# FASCICULE DE BREVET EUROPEEN

(11) **EP 1 387 305 B1**
(45) Date de publication et mention de la délivrance du brevet: **09.05.2018**
(21) Numéro de dépôt: 03291874.0
(22) Date de dépôt: 29.07.2003
(51) Int. Cl.: G06F 17/50

(54) **Procédé et systeme d'établissement automatique d'un modèle global de simulation d'une architecture**
Verfahren und System zur automatischen Bereitstellung eines globalen Modells für eine Architektursimulation
Method and system for automatically providing a global model of an architectural simulation

(30) Priorité: 30.07.2002 FR 0209690
(43) Date de publication de la demande: 04.02.2004
(73) Titulaire: Bull SAS, 78340 Les Clayes-sous-Bois (FR)
(72) Inventeur: Wozniak, Andrzej, 91120 Palaiseau (FR)
(74) Mandataire: Cabinet Camus Lebkiri

(56) Documents cités:
- WO-A-01/90961
- US-A- 5 752 002
- US-A1- 2001 021 903
- US-A1- 2002 073 375
- US-B1- 6 263 303

## Description

L'invention concerne un procédé et un système d'établissement d'un modèle global de simulation d'une architecture. Plus particulièrement, l'invention concerne un procédé de configuration et un système dit "Configurateur" pour mettre en oeuvre le procédé.

Avec l'accroissement de la complexité des systèmes hardware, il faut pouvoir traiter, pour la vérification de systèmes ou circuits intégrés en projet, des configurations rassemblant de plus en plus de modèles écrits en langage de description du matériel, par exemple, de type HDL (tels que VHDL ou Verilog, les plus utilisés) et en langage de haut niveau de type HLL (tels que C ou C++), ces langages décrivant, d'une part, les éléments constitutifs du matériel (hardware) et, d'autre part, les modèles constitutifs de l'environnement de simulation.

Nous allons référer comme "Configuration" un ensemble de modèles logiciels d'éléments dits "Composants" constituant un modèle global de simulation.

L'invention est utile dans la vérification de la conception des ASICs par simulation de leur fonctionnement, par exemple, dans un environnement identique à ou très proche de leur utilisation finale, le procédé de configuration permettant le choix de composants et de leurs modèles logiciels parmi une pluralité de modèles disponibles pour la constitution de configurations de simulation.

Dans l'art antérieur les configurations sont rigides et traditionnellement préparées "à la main" à l'aide d'éditeurs de texte ou d'éditeurs graphiques, d'après une liste prédéfinie de configurations envisageables. Chaque modification dans le modèle en langage HDL nécessite des corrections manuelles à répercuter dans l'ensemble des configurations. Cela arrive plusieurs fois au cours du développement d'un ASIC et constitue une source d'erreurs et de difficultés de modification entraînant des retards de réalisation. Les modifications de configuration sont souvent sources d'erreurs difficiles à trouver, la taille de certaines configurations pouvant atteindre des dizaines de milliers de lignes difficilement manipulables manuellement.

Le temps d'écriture et de mise au point d'une configuration peut être très long, rendant difficile la génération et l'introduction de configurations nouvelles dans l'environnement De ce fait, dans le cas d'un environnement contenant beaucoup d'éléments pour lequel il est difficile de prévoir à l'avance toutes les configurations utiles, on renonce souvent à l'utilisation de certaines variantes de configurations facilitant le déverminage (configurations ciblées simplifiées, par exemple).

Ces difficultés sont accentuées dans les environnements de co-simulation, de plus en plus utilisés, où les modèles proviennent de différentes sources et sont écrits en langages de programmation de haut niveau (HLL) tels que C, C++, ou en langages de descriptions du matériel (HDL), tels que VERILOG ou VHDL. Pour le même composant de la configuration, il existe souvent plusieurs modèles (ex : fonctionnel en langage de programmation de haut niveau, comportemental en HDL, synthétisable HDL, etc...) qu'on aimerait utiliser de manière transparente selon les besoins.

De plus, les modèles à connecter présentent souvent, au niveau des interfaces en vis-à-vis, des différences nécessitant des modules d'adaptation. C'est le cas, par exemple, de circuits avec des interfaces d'entrée-sortie sophistiqués pour lesquels, dans un premier temps, on simule le niveau logique du protocole, le niveau physique étant développé vers la fin du projet. Le choix de modules d'adaptation pour des variantes d'interfaces HDL correspondant aux différentes phases de développement du projet constitue un degré de liberté supplémentaire qui complique d'avantage encore l'écriture des configurations.

Une autre difficulté vient du fait que les modèles mixtes de type HDL (par exemple, VERILOG ou VHDL) / HLL (par exemple, C++) développés séparément, doivent être mis à jour de manière cohérente. Dans le cas d'une gestion non automatisée, c'est une source potentielle d'erreurs.

Le document US 2002/0073375 A1 décrit un procédé/système mis en oeuvre au moyen d'un système de traitement de données pour vérifier fonctionnellement le design d'un circuit intégré.

La présente invention vise à limiter un ou plusieurs de ces inconvénients. Un aspect de l'invention est un procédé tel que défini dans la revendication indépendante 1. Un autre aspect est une dispositif comme défini dans la revendication indépendante 22, ledit dispositif mettant en oeuvre le procédé. D'autres modes de réalisation de l'invention sont spécifiés dans les revendications dépendantes attenantes. L'invention sera mieux comprise à l'aide de la description suivante d'un mode préféré de mise en oeuvre du procédé de l'invention, en référence aux dessins annexés, sur lesquels :
- la figure 1 représente, sous forme très schématique, un exemple d'architecture du modèle global de simulation pour un circuit intégré (ASIC) en développement appelé BRIDGE (12) ;
- les figures 2a à 2d sont des diagrammes illustrant les différentes composantes du système Configurateur et les étapes de mise en oeuvre de ces composantes dans le procédé de l'invention ;
- les figures 3a à 3c représentent différents stades de modélisation d'un circuit à l'aide d'un modèle mixte de type HDL (VERILOG ou VHDL) et de type HLL (C++) ;
- la figure 4 représente la structure générique d'un Modèle élémentaire ;
- la figure 5 représente la structure générique d'un Modèle Composé ;
- la figure 6 décrit la correspondance entre les tables de la description du système configurateur sur les figures 2a à 2d et les tables de la mise en oeuvre du procédé de l'invention ;
- les figures 7a à 7k représentent schématiquement les différents modèles des composants avec leurs variantes d'interfaces et de niveau de description nécessaires pour les configurations relatives à l'architecture de l'exemple de la figure 1 ;
- les figures 8a à 8e représentent les configurations successives de l'architecture aboutissant à une constitution du modèle donnée dont le modèle final correspond à celui de la figure 8e et pour lequel tous les modèles de type HDL du circuit en projet sont disponibles, ce modèle final correspondant à la configuration.
- la figure 8f représente la répartition de la configuration de simulation du modèle de la figure 8a, par exemple sur deux machines.

L'invention concerne un système dit "Configurateur" et le procédé de configuration mis en oeuvre par le système.

Un modèle global de simulation est typiquement composé d'un ou plusieurs modèles de circuits intégrés testés (DUT) entourés de modèles qui créent un environnement de test et vérification. Ces modèles créent des stimuli complexes et reçoivent des réponses complexes du modèle testé. Ces composants peuvent être des transactors (XACTORS) - des modèles possédant généralement une interface programmatique (API) permettant un pilotage par des tests externes au modèle, ces tests étant écrits généralement en langage de haut niveau (HLL).

L'environnement de vérification peut contenir aussi des composants dits Bloc de Monitoring (MONITOR) et des composants dits Bloc de Vérification (VERIFIER). Ces composants n'interviennent pas directement dans l'échange de signaux entre les autres constituants du modèle global de simulation mais servent à les observer et à interpréter. Les Blocs de Monitoring (MONITOR) servent de support d'analyse pour les tests, ils possèdent des interfaces programmatiques (API) pour signaler des événements observés sur les signaux de modèle global. Les Blocs de Vérification (VERIFIER) sont des composants qui possèdent une spécification de référence de fonctionnement de modèle testé et, en observant les signaux du modèle global de simulation, sont capables de vérifier le bon fonctionnement du modèle.

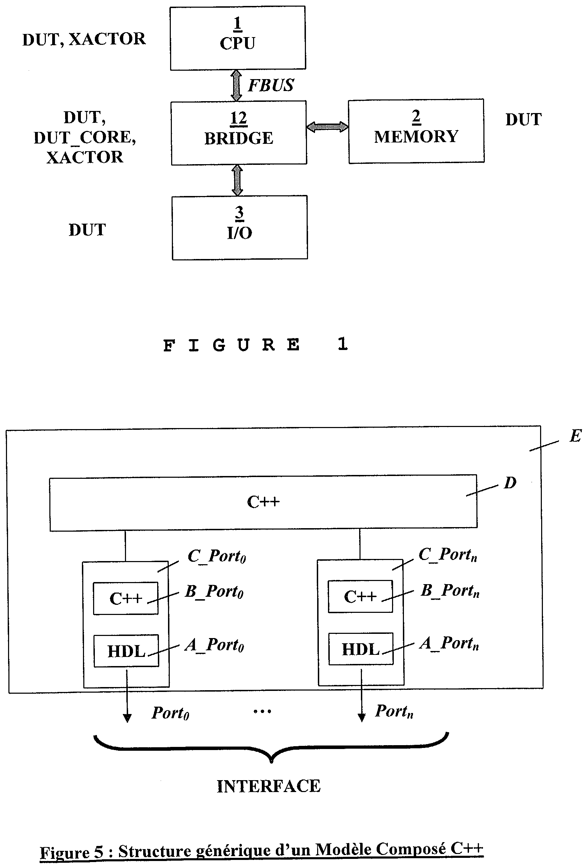

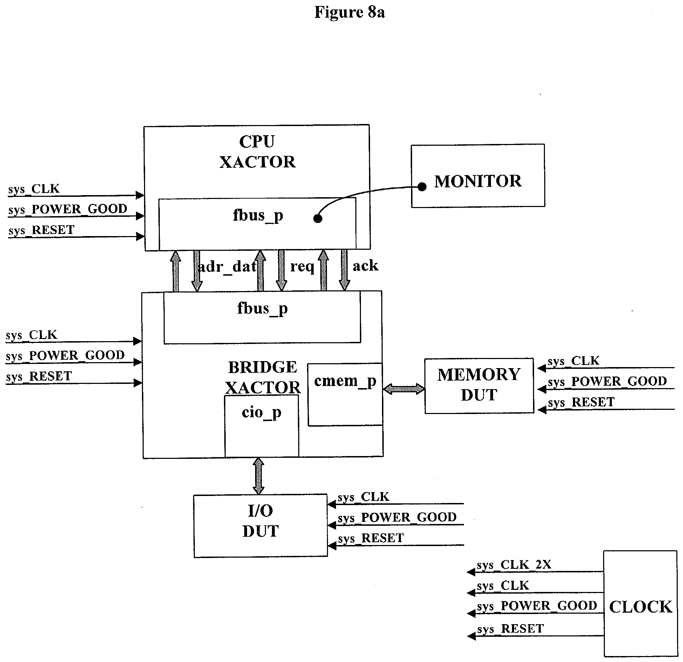

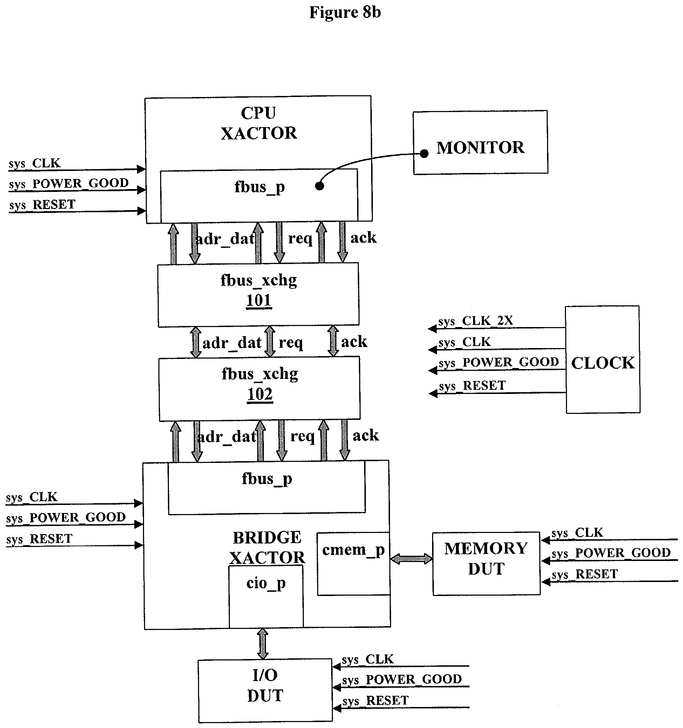

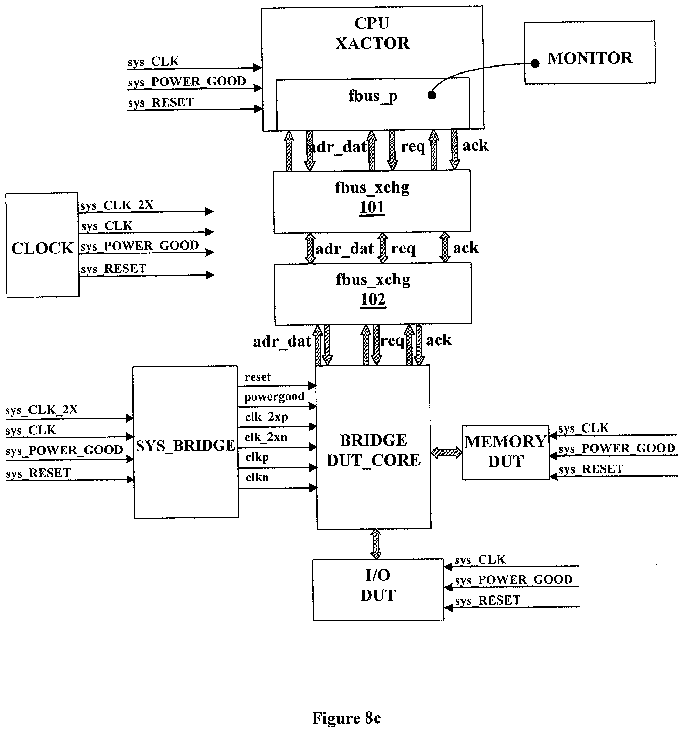

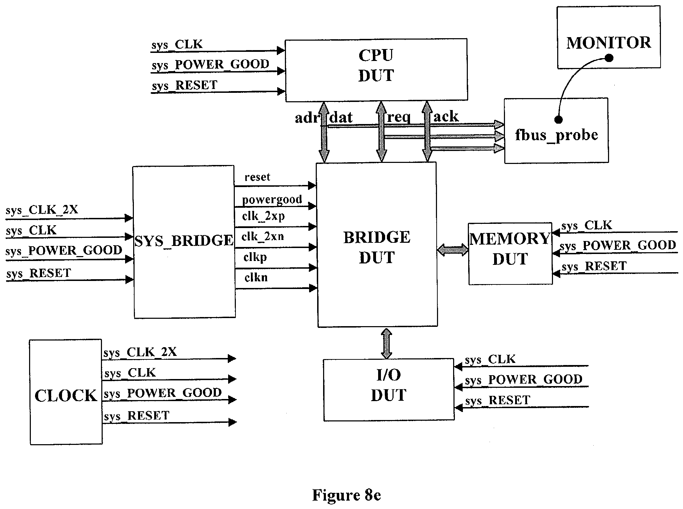

La figure 1 représente un exemple d'architecture d'un système de circuit intégré en développement dont on veut, dans une première étape, mettre au point le modèle global de simulation correspondant à la figure 8c, choisie pour illustrer le nombre le plus important de mécanismes mis en oeuvre par le configurateur. Il doit être clair que les étapes des figures 8a, 8b pourraient être d'abord exécutées selon la disponibilité des modèles et les objectifs de vérification. Le modèle final souhaité est celui correspondant à la figure 8e. L'architecture est constituée d'un processeur (CPU) communicant par une passerelle (BRIDGE) avec une mémoire système (MEMORY) et des entrées sorties (I/O). Le modèle auquel aboutit le système "Configurateur" de l'invention est constitué d'un composant processeur CPU de type XACTOR relié par une interface de type "fbus_p" à un bloc intermédiaire (fbus_xchg) 101 ayant une interface de type différent. Un autre bloc intermédiaire (fbus_xchg) 102 figures 8b et 8c relie le premier bloc intermédiaire 101 à un composant de type passerelle (BRIDGE) de type DUT_CORE qui communique, d'une part avec un modèle majoritairement en langage de type HDL d'une mémoire (MEMORY) de type DUT, d'autre part avec un modèle majoritairement en langage de type HDL d'une entrée/sortie (I/O) de type DUT et enfin avec un bloc système (SYS_BRIDGE).

Le système "Configurateur" de l'invention gère la connexion d'éléments logiciels de simulation appelés composants pour les besoins de la simulation des circuits hardware.

Il existe au moins 5 classes de composants :
- Les "Composants actifs" (voir ci-après) ;
- Les "Blocs de Monitoring et de Vérification" (voir ci-après) ;
- Les "Blocs intermédiaires" (voir ci-après) ;
- Les "Blocs Système" (voir ci-après) ;
- Les "Blocs Globaux" (voir ci-après et 1 de A2).

Chaque type de composant peut posséder plusieurs variantes de réalisation d'un même élément, différenciées par le niveau de description (voir ci-après) ou par les signaux sur les interfaces (voir ci-après). Chaque type de Composant peut être décrit à plusieurs niveaux de détails (fonctionnel, comportemental, portes, etc...) en langage de type HDL, tel que VERILOG ou VHDL, ou en langage de haut niveau (HLL), tel que C ou C++ complété d'une interface de type HDL.

Plusieurs niveaux de descriptions peuvent coexister pour décrire des fonctionnalités similaires et avoir des interfaces de type HDL similaires mais pas forcément identiques. Certaines descriptions peuvent avoir plus de fonctionnalités, et les interfaces de type HDL peuvent contenir des jeux de signaux complètement différents.

Les composants sont connectés selon un schéma prédéterminé considéré fixe pour chaque exécution du système Configurateur. Ces connexions sont définies par l'architecture du modèle global de simulation et spécifiées par le fichier de description d'architecture (FDARCH) (voir annexes A1-A5).

Chaque instance d'un composant dans ce schéma obtient un nom ou label qui identifie de façon non équivoque la position du composant et son type.

Le fichier de définition de la configuration (FCONF) fournit une description synthétique de la variante de Configuration à générer par le système Configurateur. Seuls les composants principaux (Composants Actifs, Blocs de Monitoring et Blocs de Vérification) y sont mentionnés avec les types de modèles souhaités. Les autres composants (Blocs Globaux, Blocs Système et Blocs Intermédiaires) seront instanciés automatiquement par le système configurateur.

Parmi les différents types de composants, les "Composants Actifs" constituent le sous-ensemble des objets explicitement désignés dans le fichier de configuration (FCONF) et qui échangent des stimuli en émission et réception avec leur environnement.

Parmi les différents types de composants, les "Blocs de Monitoring et Vérification" constituent le sous-ensemble des objets, explicitement désignés dans le fichier de configuration (FCONF), qui ne font que recevoir des informations de leur environnement. Ils sont utilisés à des fins d'observation et de Vérification (MONITOR, VERIFIER). La granularité de traitement de ces modèles est l'événement qui rend compte des changements de valeurs des signaux de contrôle et des échanges arbitraires de données.

Tous les autres Composants constituent des composants dits implicites, qui sont gérés et instanciés de façon automatique par le système configurateur, en fonction des paramètres du fichier de configuration (FCONF) (type de composants explicites, type d'interface, ...).

Les composants peuvent être connectés entre eux directement ou par l'intermédiaire de composants d'adaptation externe dits "Blocs Intermédiaires" définis et déclarés spécialement à cet effet. Ils sont souvent utilisés, comme nous le verrons par la suite, lors des phases successives de développement pour compléter les parties manquantes du design.

Le système Configurateur peut insérer ainsi un ou plusieurs blocs intermédiaires pour connecter deux composants actifs.

Les composants dits "Blocs Systèmes" sont associés aux autres composants pour leur fournir les signaux d'environnement qui leur sont spécifiques. Ces composants encapsulent, au niveau de chaque interface, l'ensemble des signaux système ne participant pas à la connexion entre les autres composants. Les "Blocs Systèmes" sont eux-mêmes connectés aux "Blocs Globaux" et gèrent l'ensemble des signaux d'environnement : les signaux d'horloge et de contrôle général (clock, reset, powergood, diagnostic), qui peuvent être éventuellement transformés pour les adapter au besoins du bloc actif correspondant (changement de polarité, retard etc.), ainsi que les signaux spécifiques, différents pour chaque instance particulière du composant actif concerné, par exemple les signaux codant le numéro de module ou le mode de fonctionnement du composant, etc... Ces derniers sont gérés par des paramètres fournis par le système Configurateur aux instances de modèles des composants générés. Si, pour un Composant donné, le Bloc Système n'est pas nécessaire (ce qui est indiqué par les tables de description de la configuration), il sera relié directement aux Blocs Globaux (cf. 1 de A2).

Le fichier de configuration (FCONF) peut contenir des informations supplémentaires spécifiant des blocs intermédiaires à utiliser en association avec les instances des composants actifs. Ainsi, l'utilisateur peut influencer le choix du composant intermédiaire, ou lever l'ambiguïté, dans le cas de plusieurs choix possibles. Les connexions ainsi obtenues sont comparées à la table de règles de cohérence de connexions (TRCOH) pour détecter des incompatibilités entre extrémités de connexions entre les composants et, en pareil cas, choisir et ajouter, dans la table de connexion des instances (TCINST), encore un composant adaptateur (Bloc Intermédiaire) inséré dans la connexion considérée.

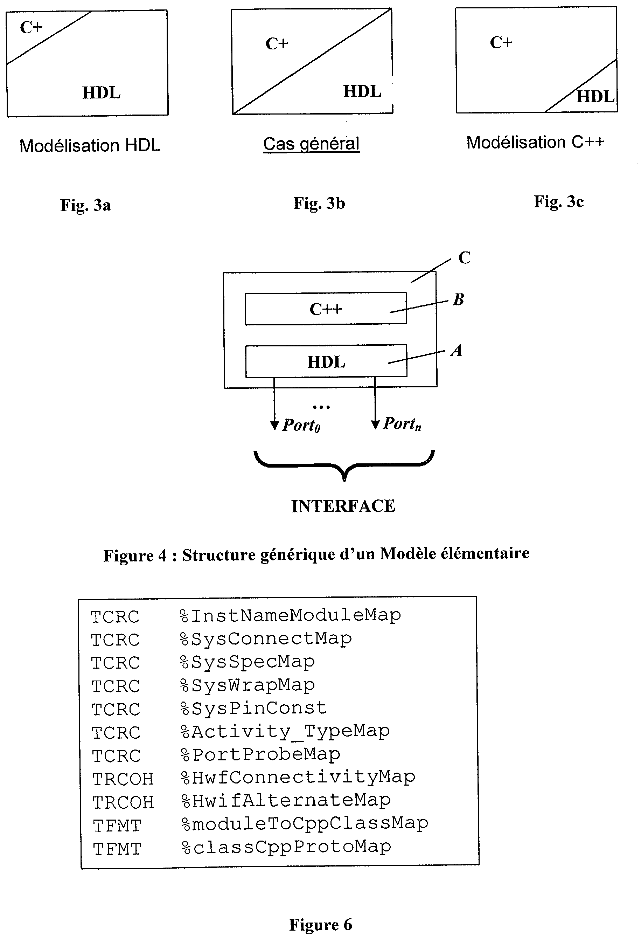

Le système Configurateur s'appuie sur une représentation générique, telle que décrite sur les figures 3a à 3c, commune à l'ensemble des composants déclarés dans le fichier de description d'architecture (FDARCH) du modèle global de simulation, et comprenant deux parties, de type HDL (par exemple VERILOG ou VHDL) et de type HLL (par exemple C++).

Dans le cas d'un composant décrit complètement en langage de type HDL (figure 3a), la partie de type HLL est réduite à une instance qui permet de signaler sa présence dans la Configuration au cours de la simulation et qui fournit les chemins d'accès aux ressources de type HDL du composant.

Pour les composants décrits en langage de type HLL (figure 3c), c'est la partie de type HDL qui est réduite au strict minimum, et qui est limitée à la description des signaux et registres d'interface.

Tous les niveaux intermédiaires entre ces deux extrémités sont possibles et naturellement exploités dans le contexte de processus de développement des circuits ASIC.

Typiquement, au cours d'un développement, on commence par un modèle de type HLL avec une interface de type HDL minimale et, ensuite, on passe à des modèles de type HDL de plus en plus complets écrits par les concepteurs et on termine par les modèles du niveau portes logiques synthétisés automatiquement à partir de modèles de type HDL.

Les modèles mixtes sont souvent utilisés parce qu'ils permettent une simulation précise et efficace en dédiant le langage de haut niveau (HLL) aux modélisations complexes pour lesquelles le langage de type HLL offre une description compacte et rapide à l'exécution. Néanmoins, même pour les modèles écrits majoritairement en langage de type HLL, la partie de type HDL peut être non triviale pour des raisons de pertes de performances dues aux changements de contexte de simulation entre, respectivement, les parties de type HDL et de type HLL. Un exemple typique est une interface dont les signaux changent, même sans activité réelle de transfert de données. Dans ce cas, il est préférable de traiter les signaux dans la partie de type HDL du modèle, et de passer à la partie de type HLL quand les données sont présentes sur l'interface.

L'interface d'un composant est l'ensemble de tous les signaux présents à sa périphérie. Pour les composants décrits uniquement en langage de type HDL, cela correspond à l'interface externe de la définition de ce composant en langage de type HDL (par ex. VERILOG ou VHDL). Pour les composants définis de manière mixte en langage de types HLL et HDL, l'interface d'un composant est la somme des signaux de tous les modules de type HDL utilisés à la périphérie de ce composant.

La figure 4 décrit la structure générique des modèles élémentaires constituant la majorité des composants. Cette structure s'applique typiquement, mais pas uniquement, au cas du circuit ASIC en développement, des adaptateurs d'interface, blocs intermédiaires, blocs système.

Elle comprend un Bloc englobant noté C contenant la description de type HDL notée A et le Bloc HLL noté B fournissant les chemins d'accès aux ressources de type HDL et, le cas échéant, une description du bloc en langage de type HLL. L'ensemble des signaux du bloc de type HDL constitue l'Interface du bloc C. Pour les besoins de connexion entre les blocs nous utilisons la notion de Ports (voir plus loin) qui sont des sélections logiques arbitraires des signaux d'une Interface. Il est possible qu'un signal appartienne à plusieurs Ports à la fois.

Le système Configurateur est capable de traiter des modèles dits 'composés' comprenant une partie en langage de type HLL et incluant d'autres modèles des composants dits 'adaptateurs d'interface'. Les adaptateurs d'interface sont des modèles mixtes de types HDL / HLL possédant une interface programmatique (API) en langage de type HLL par laquelle ils peuvent communiquer avec le modèle composé. Les modèles composés sont particulièrement utiles pour les composants d'environnement de simulation (par exemple MONITOR, VERIFIER, XACTORS) où le modèle doit s'adapter à des signaux présents sur les différentes variantes des modèles utilisés dans une configuration.

La figure 5 décrit la structure générique de modèles composés, utilisés surtout pour modéliser les constituants de l'environnement de simulation. Vu de sa présentation extérieure, le modèle composé est identique au modèle élémentaire. A l'intérieur, la spécification HLL du modèle (notée D) communique avec l'interface extérieure de type HDL à travers les adaptateurs d'interface (notés C_Port)ᵢ modélisés au moyen de structures élémentaires en langage de type HLL (notées B_PORT) et en langage de type HDL, (notées A_PORT).

Le système Configurateur est agencé pour sélectionner automatiquement les adaptateurs d'interface pour un modèle composé. Le système Configurateur examine la liste d'adaptateurs d'interface utilisables pour un modèle composé donné décrit par les propriétés du modèle, et choisit le modèle d'adaptateur d'interface dont les connexions physiques avec le reste du modèle global sont en conformité avec la table des règles de cohérence de connexions (TRCOH). Cette approche permet une rapide adaptation à de nouveaux types d'interfaces en ajoutant de nouveaux adaptateurs.

Il est important de souligner qu'un même composant peut aussi bien être modélisé par une structure élémentaire, ou composée, suivant son niveau de description.

Un composant adaptateur d'interface peut être partagé entre plusieurs modèles composés connectés sur le même port. Un seul d'entre ces modèles est autorisé à émettre des signaux sur le port, les autres modèles étant purement observateurs. Une utilisation typique concerne les blocs de Monitoring et Vérification qui n'envoient pas de signaux en sortie. Le partage des adaptateurs d'interface accélère la simulation par la simplification et la factorisation des parties du modèle.

On appellera par la suite Sondes, les adaptateurs d'interface servant à observer les signaux pour le compte des Blocs de Monitoring ou de Vérification qui sont des Modèles Composés.

Le système Configurateur est conçu pour optimiser l'utilisation des Sondes en minimisant leur nombre. Comme la description des Composants établit la notion d'équivalence entre certains Composants, le système Configurateur essaye d'abord de partager le port d'un "Composant actif". Si cela s'avère impossible, il instancie un composant Sonde adéquat connectable sur l'interface de type HDL à partir d'une liste fournie dans la description du Composant Monitoring ou Vérification.

La partie ci-après décrit les définitions relatives aux connexions entre Composants. Les notions d'interface et de port servent de support à la description des connexions entre les composants.

Nous rappelons que le port est une sélection arbitraire des signaux de l'interface de type HDL d'un composant, réalisée à l'aide des expressions régulières portant sur les noms de ces signaux. Un signal donné peut appartenir à un ou plusieurs ports. La définition de chaque port est constituée de paires de type expression régulière et expression de substitution correspondante. Ces expressions sont appliquées successivement au nom de chaque signal de l'interface et, en cas d'adéquation 'match', l'expression de substitution est appliquée et le nom ainsi obtenu passe au traitement de la substitution suivante. Si la substitution finale donne un résultat final identique pour deux signaux, ces derniers seront connectés ensemble. Le configurateur génère un nom unique pour la connexion et place les informations adéquates dans la table de câblage (TCAB). La méthode décrite permet d'exprimer des règles complexes de connexion entre deux composants. Par exemple on peut connecter des signaux de noms différents, ou créer des règles de connexion des signaux d'entrée avec les signaux de sortie.

La création de cette méthode de définition par les interfaces et les ports permet un découplage entre les déclarations de modules de type HDL et les spécifications de connexions pour le système Configurateur. Ce dernier combine ces deux sources d'information pour générer les connexions. Dans la majorité des cas, les modifications de déclarations dans les parties de type HDL, très fréquentes pendant le développement, n'entraînent pas de modifications dans les expressions régulières décrivant les câblages.

Dans l'exemple de mise en oeuvre de l'invention traité ci-après, seules les connexions point à point sont traitées. Les connexions de type "bus" sont facilement modélisables en utilisant un composant à plusieurs sorties englobant le bus.

Nous allons décrire ci-après le procédé de connexion automatique entre les "composants" par le système Configurateur pour constituer le modèle global de simulation. Ce procédé comprend les étapes suivantes :
- Lecture du fichier de description d'architecture (FDARCH) du modèle global et mémorisation, dans une table de composants et de règles de connexion, dans une table de règles de cohérence de connexions et dans une table de formatage de fichiers source, des informations relatives à l'ensemble des configurations possibles, chaque composant obtenant un nom identifiant, de façon non équivoque, sa position dans l'architecture, ainsi qu'un type parmi plusieurs types (Composants actifs, Blocs de Monitoring et de Vérification, Blocs intermédiaires, Blocs systèmes et Blocs Globaux).
- Instanciation des composants, spécifiés dans le fichier de définition de configuration par l'utilisateur-concepteur au moyen d'une liste de composants présents désignés par leurs nom et type et comportant des paramètres ou faisant appel à des procédures, le fichier de définition de la configuration comprenant un fichier de sélection des composants et de leur type et des indications supplémentaires optionnelles concernant le type d'interface et le serveur concerné par la configuration à générer par le Configurateur, et mémorisation des informations correspondantes dans une table de connexion des instances.
- Connexion topologique des instances selon le schéma défini par la table de composants et de règles de connexions (TCRC).
- Lecture et mémorisation des sources de type HDL des modèles instanciés pour en extraire les noms et types des signaux d'interfaces.
- Câblage des signaux d'interface au niveau de chaque instance des composants par application d'expressions régulières, stockées dans la table de composants et de règles de connexions (TCRC), et portant sur le nom des signaux constituant la table de câblage (TCAB).
- Utilisation de la table de connexion des instances (TCINST), de la table de câblage (TCAB) et de la table de formatage (TFMT) pour générer automatiquement les fichiers source de type HDL (MGHDL) et de type HLL (MGHLL) du modèle global de simulation correspondant à la configuration spécifiée par le fichier de configuration (FCONF).

Le déroulement de la phase topologique est le suivant :
- Les Composants explicites spécifiés dans le fichier de configuration (FCONF) sont instanciés en premier par le système Configurateur et placés dans la table de connexion des instances (TCINST). Cette table contient le descriptif de chaque instance (label, type), accompagné de la liste des composants avec lesquels il est connecté.
- Ensuite, les Blocs Intermédiaires, spécifiés explicitement sur les ports des "Composants actifs" dans le fichier de configuration, sont instanciés et ajoutés dans la table de connexion des instances (TCINST).
- Les connexions entre les composants actifs instanciés sont comparées avec les règles contenues dans la table de cohérence de connexions (TRCOH) pour détecter des incompatibilités entre les extrémités des connexions entre les composants et, dans ce dernier cas, pour choisir et ajouter, dans la table de connexion des instances (TCINST), un composant adaptateur (Bloc Intermédiaire) à insérer dans la connexion considérée.
- Ensuite sont instanciés les composants de type Bloc de Monitoring et Bloc de Vérification. Le système Configurateur analyse les connexions des composants à modèle composé et cherche des adaptateurs d'interface partageables au niveau des ports commun (voir modèles C_Portᵢ sur la Figure 3). S'il n'existe pas de composant approprié pour partager la connexion en observation des signaux requis, un composant adaptateur d'interface aux propriétés spécifiées par la description sera instancié par le configurateur. La table de connexion des instances (TCINST) est remise à jour.
- Enfin, les composants 'bloc système' sont instanciés et placés dans la table de connexion des instances (TCINST), pour les composants qui en ont besoin.

En phase de Câblage, le système Configurateur connecte les signaux d'interface au niveau de chaque port par application d'expressions régulières portant sur les noms des signaux comme décrit dans la définition du port. Ces expressions sont appliquées aux noms des signaux extraits à partir des descriptions de type HDL des composants, de telle sorte que les changements des interfaces de type HDL d'une version de modèle à l'autre n'influent pas directement sur les spécifications des connexions entre les blocs. Cette phase génère comme résultat la table de câblage (TCAB) associant les signaux connectés ensemble, au nom unique du fil les connectant. Un certain nombre de vérifications sont alors possibles, portant par exemple sur les connexions sans source, ou la connexion de plusieurs sorties ou autres.

Les différentes étapes de la phase de câblage sont les suivantes :
- Les Composants Globaux et Blocs Système sont câblés en premier à tous les composants.
- Ensuite sont câblés les signaux entre les autres composants.
- A la fin du câblage, une passe supplémentaire permet de connecter les signaux d'un composant non connectés dans les phases précédentes de câblage à des signaux du bloc système correspondants, spécialement prévus pour forcer des valeurs connues et stables inhibant les ports non utilisés. Les signaux concernés des blocs système portent un marquage spécial (par exemple un préfixe spécial dans le nom) pour ne pas être connectés au cours des phases de câblage précédentes.

En phase de génération des sources, le système Configurateur génère les fichiers source de type HDL et de type HLL en s'appuyant sur le contenu de la table de connexion des instances (TCINST), de la table de câblage (TCAB) et de la table de formatage (TFMT) pour générer automatiquement les fichiers source de type HDL (MGHDL) et de type HLL (MGHLL) du modèle global de simulation correspondant à la configuration spécifiée par le fichier de configuration (FCONF).

Le fichier source de type HDL contient une description de la partie de type HDL (par exemple en VERILOG) du modèle global de simulation correspondant au fichier de configuration (FCONF). En particulier, il contient l'instanciation de tous les modèles de type HDL des composants explicités dans le fichier de configuration, les blocs intermédiaires, Blocs Système et les Bloc Globaux ainsi que tous les fils reliant ces instances.

Le fichier source de type HLL contient le programme correspondant à l'instanciation de tous les composants possédant une partie de leur modèle en langage de type HLL. Dans le cas de langages HLL orientés objet, le code contient les constructeurs d'objets de classes HLL avec les paramètres correspondants spécifiés dans la description de chaque composant. Un tableau de formatage (TFMT) spécifique à chaque projet permet la génération du code de type HLL approprié.

Nous allons décrire le fichier de description d'architecture (FDARCH) pour une implémentation spécifique du système configurateur (PROGCONF) en langage PERL, choisi à cause de la manipulation directe des expressions régulières et des tables associatives à plusieurs niveaux.

L'architecture, représentée sur la figure 1, est constituée d'un processeur (CPU) communicant par une passerelle (BRIDGE) avec une mémoire système (MEMORY) et des entrées sorties (I/O).

Le fichier FDARCH représenté a été découpé pour faciliter son écriture et sa manipulation en plusieurs parties présentées dans les annexes A1 à A5. Ce fichier définit l'architecture du modèle global de simulation correspondant au schéma générique représenté sur la figure 1. Le langage de type HDL généré est VERILOG et le langage de haut niveau (HLL) généré est le C++.

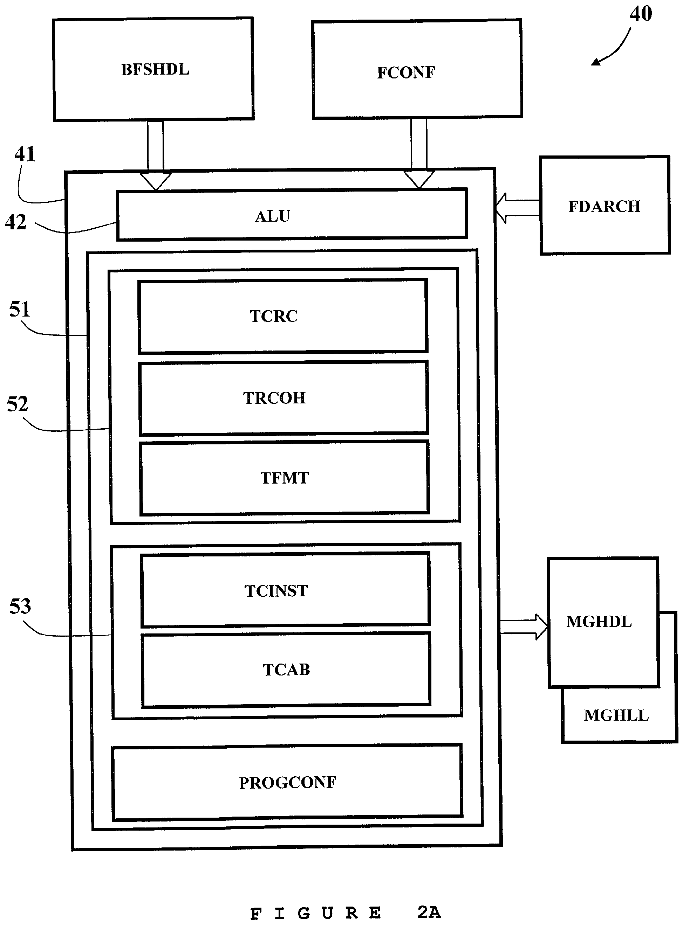

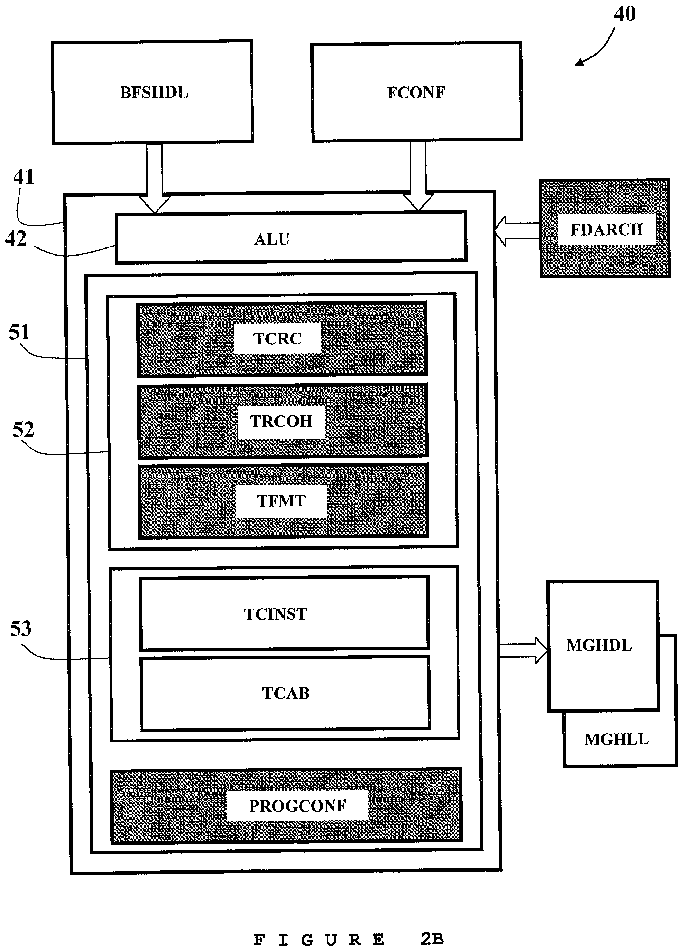

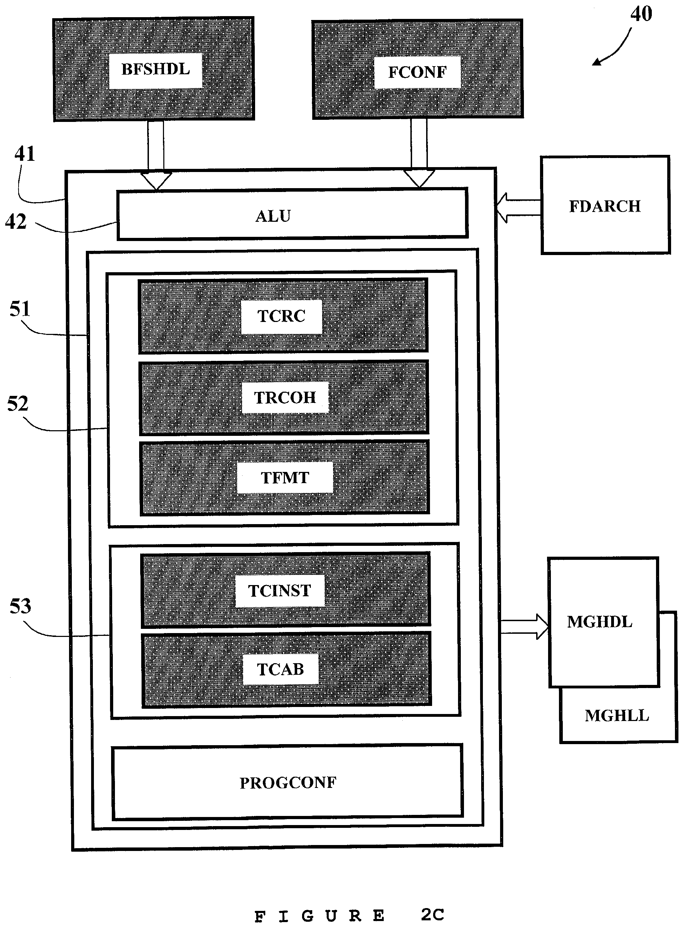

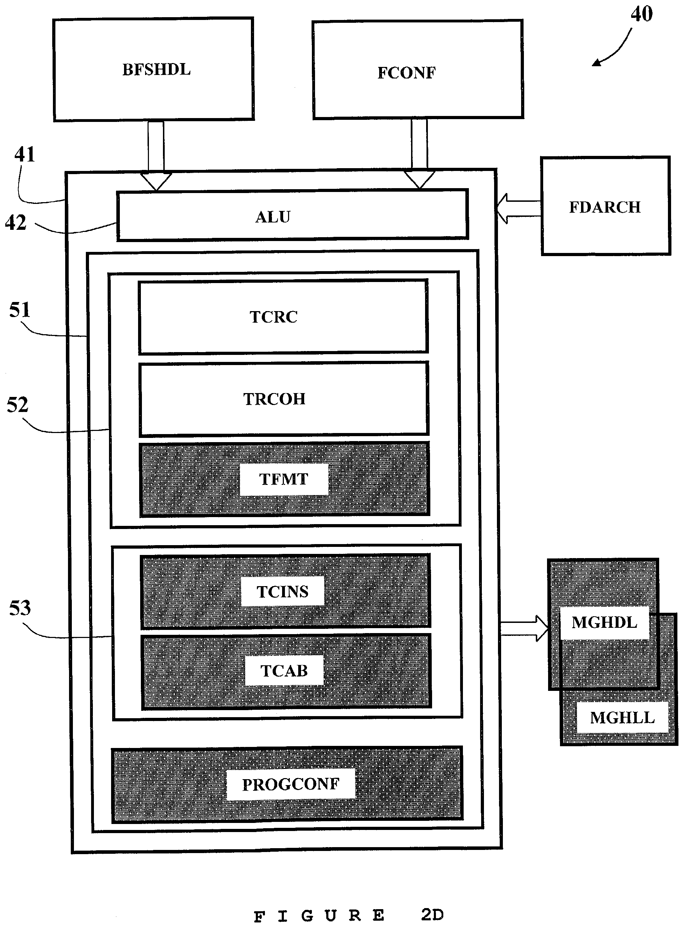

Les propriétés des Composants (type, Interfaces de type HDL, ports, constructeurs d'objets de la classe C++, etc...) sont décrites dans plusieurs tables écrites en langage PERL. La correspondance entre ces tables et le diagramme illustrant le système Configurateur de la figure 2 est représentée sur la figure 6. Dans la suite de la description, toutes les notations commençant par "%..." correspondent à des tables de hachage.

Ces tables peuvent contenir la description, soit sous forme de suites de paramètres, soit sous forme de références à des procédures qui génèrent les valeurs requises.

Les procédures font partie de la description et sont changées pour chaque projet. L'exemple typique de leur utilisation est la génération d'interconnexion entre les composants. Souvent, le tableau correspondant à toutes les interconnexions possibles serait trop grand et difficile à générer et maintenir. En revanche une procédure peut être très compacte.

La description des règles d'interconnexion des composants (TCRC) contient des paramètres globaux communs à tous les types de composants. Elle peut se présenter sous forme d'au moins une table. Dans le mode de réalisation de la figure 6, elle se présente sous forme de sept tables associatives (hachages), dont trois ont pour entrées (%InstNameModuleMap, %SysConnectMap, %SysSpecMap) les noms désignant l'ensemble des modèles possibles pour un même composant :
- La table "%InstNameModuleMap" (cf. 2 de A1), qui figure dans le fichier patent_config_defs.pm, pour décrire les Composants explicites. Cette table représente les règles de génération de connexion entre les signaux. Elle a pour entrées Connect et SelfConnect.
- La table "%SysConnectMap" qui figure dans le fichier patent_Sysconfig_defs.pm pour les Blocs Système.
- La table "%SysSpecMap" (cf. 4 de A2) qui figure dans le fichier patent_Sysconfig_defs.pm pour les Blocs Intermédiaires.
Les deux tables de hachage %SysWrapMap et %SysPinConst (cf. 6 de A2) contiennent les règles de connexion niveau système. La table de hachage %Activity_TypeMap associe le nom d'un composant avec son type. La table de hachage %PortProbeMap a pour entrées les noms des modules de type HDL utilisée dans la description des composants.

Le système Configurateur est piloté par au moins une table de règles de cohérence de connexions (TRCOH) qui représente les règles d'interconnexion entre les composants et d'insertion des composants intermédiaires. Dans le mode de réalisation de la figure 6, les règles de cohérence de connexions sont réparties sous forme des deux tables suivantes :
- %HwfConnectivityMap (cf. 2 de A2)
- %HwifAlternateMap

Le système Configurateur est piloté par au moins une table de formatage de fichiers source (TFMT) qui représente les règles de génération des instances des objets de type HLL. Dans le mode de réalisation de la figure 6, les règles de génération des instances des objets de type HLL sont réparties sous forme des deux tables suivantes :
- %moduleToCppClassMap (cf. 1 de A5)
- %classCppProtoMap (cf. 2 de A5)
Le rôle de chacune de ces tables de hachage est détaillé ci-après.

Parmi les entrées définies pour les tables %InstNameModuleMap, %SysConnectMap, %SysSpecMap, certaines sont obligatoires :
- L'entrée "MatchExpr", dont la valeur est l'expression régulière qui permet d'accepter un nom (label) du composant dans le fichier de configuration, est utilisée pour définir les variantes de positions autorisées pour le composant.
- L'entrée "ExtrExpr", dont la valeur est l'expression régulière qui assure l'extraction des paramètres numériques à partir du nom (label), est utilisée pour l'instanciation des Blocs Intermédiaires ou des Blocs Système ou pour générer le label du composant implicite.

D'autres paramètres sont facultatifs et peuvent être ajoutés à la description des tables mais ces paramètres ne peuvent être utilisés que par le code fourni avec la description - parmi eux :
- NumAdd est un paramètre auxiliaire servant de modificateur pour les paramètres extraits par ExtrExpr, exploité par la procédure GenDest (voir ci-après).
- BaseldExpr est une expression régulière qui permet de retrouver le composant actif correspondant à un composant intermédiaire ou système en cas d'ambiguïté.

Les entrées suivantes du hachage définissent le Type du composant tel que, par exemple, DUT (modèle de type HDL), XACTOR (transactor), ou autres.

A chaque Type de Composant, correspond un hachage composé à son tour des entrées suivantes :
- L'entrée "ReqModule" - contient le nom du module de type HDL (VERILOG) du composant et le nom du fichier source correspondant.
- L'entrée "Connect" - est la définition de la méthode de sélection des signaux faisant partie d'un Port. Cette description est composée d'une suite d'entrés indexés par le nom du Port. À chaque nom de Port on associe un tableau d'expressions régulières et un pointeur sur une procédure de connexion des signaux qui gère l'application de ces expressions aux noms des signaux de l'interface du composant.
Le Configurateur dispose de plusieurs procédures préprogrammées mais d'autres peuvent être ajoutées et référencées. Les procédures préprogrammées acceptent des modificateurs :
→ E (exclusif - le signal ne sera utilise qu'une seule fois)
→ T(dérivation - le signal peut être utilisé par plusieurs destinations).
→ Une valeur spéciale 'filter_out_wire_name', attribué à un signal ou un groupe de signaux permet d'éliminer toute connexion sur les signaux correspondants.
   - L'entrée "SelfConnect" - similaire à l'entrée "Connect" contient les définitions des connexions des signaux de Ports qui peuvent être connectés entre deux instances d'un même composant - cette définition facilite la connexion de signaux unidirectionnels sortie → entrée dans le cas particulier de connexion tête-bêche.
   - L'entrée "Port" - fournit la définition de l'ensemble des ports. C'est un hachage qui associe le nom de chaque port à un tableau comportant les éléments suivants :
      - Le nom logique du composant de type HDL.
      - Le nom du module de type HDL ou un choix de modules.
      - Le numéro du port (utile pour la générations du code VERILOG et C++).
   - L'entrée "GenDest" (cf. 1 de A3) - est un pointeur sur la procédure qui, pour un composant désigné par un label et type, génère, pour chaque port, le label du composant auquel il se connecte. La procédure référencée doit être impérativement spécifiée par l'utilisateur - cette procédure est également utilisée pour contrôler la cohérence de la configuration demandée
   - L'entrée "SysConn" - est un hachage qui associe à chaque module de type HDL contenu dans le modèle un pointeur sur la procédure de sélection et nommage des Blocs Système. La procédure référencée doit être impérativement spécifiée par l'utilisateur.
   - L'entrée "GenHDLInstParam" - est un pointeur sur la procédure qui génère les paramètres supplémentaires requis par le simulateur de type HDL pour le code généré qui instancie la partie de type HDL du composant.
   - L'entrée "CfgCpp" - définit les paramètres du constructeur de l'objet pour le code C++ d'identification de la Configuration, généré automatiquement, servant de filtrage pour la sélection des Composants par le système Configurateur :
      - Le premier paramètre est le nom de la classe de l'objet C++ - c'est un nom prédéfini associé à celui du modèle de type HDL - il est suivi par les tableaux correspondants à des groupes de paramètres associés typiquement à chaque port du composant. Le mot-clé "Own" indique un composant à modèle élémentaire.
      - Ensuite viennent le nom du composant de type HDL référencé dans la partie Port et l'identifiant de type du composant tels, par exemple, DUT, modèle du circuit en projet; XACTOR, transacteur.
      - Pour les blocs à modèle composé, la partie paramètres est plus riche :
         → Elle contient le mot clé "Src" pour les composants actifs ou "Mon" pour les composants de Vérification et Monitoring
         → Viennent ensuite les paramètres du composant adaptateur d'interface, comprenant :
            - le nom du composant de type HDL.
            - l'identifiant du type du composant et sa classe suivie du nom du port correspondant.
            Ces derniers paramètres sont spécifiés pour chaque port du bloc composé.

Dans le code C++ généré pour un modèle composé, les paramètres transmis au constructeur d'une classe correspondent aux pointeurs sur les instances des adaptateurs d'interface.

Tous ces paramètres servent à guider le générateur du code C++ qui les combine avec les règles contenues dans le tableau de hachage "%classCppProtoMap"
- L'entrée "ProbeConnect" - associe à chaque port d'un composant Moniteur ou Vérifieur la classe C++ acceptable comme adaptateur d'interface. Ainsi le Configurateur est capable d'optimiser le code en utilisant le même adaptateur d'interface pour plusieurs composants (modèle composé).
- L'entrée "SysWrap" - est un hachage qui pour chaque partie de type HDL d'un composant définit l'expression régulière à utiliser pour mettre à un état connu les signaux restés non connectés après le câblage entre les composants.

L'algorithme de connexion de deux composants est le suivant :
- Le système Configurateur essaye d'abord la connexion directe.
- Si celle-ci s'avère impossible d'après la première table de hachage %HwfConnectivityMap, les modules spécifiés dans %HwifAlternateMap sont pris en compte pour être placés dans le composant. Les modules à choix sont indiqués par le caractère ">" au début de leur nom dans la spécification d'un composant.
- A la fin, si aucun module ne convient, le système Configurateur revient au hachage %HwfConnectivityMap pour choisir les blocs intermédiaires à placer entre les composants.
- Si aucun bloc adéquat n'est trouvé une erreur est signalée.

L'utilisateur peut influencer les choix du système Configurateur en spécifiant explicitement dans le fichier de configuration les blocs intermédiaires à connecter à un composant.

Le tableau "%HwfConnectivityMap" permet à la fois la Vérification de connectivité et la spécification de Blocs intermédiaires à insérer pour connecter deux Composants dont les ports ne sont pas directement connectables.

Pour que deux blocs puissent être connectés entre eux, il faut que %HwfConnectivityMap contienne des entrées qui décrivent les propriétés de cette connexion :
- A chaque composant, on associe le composant auquel il peut être connecté.
- Une connexion directe est indiquée par la valeur "Direct".
- Pour les connexions nécessitant un Bloc intermédiaire, le nom de ce bloc est indiqué.
- Pour certains blocs, la connectivité peut être spécifiée différemment pour chaque port du bloc. Cela sert à lever l'ambiguïté sur les connexions d'un bloc. Une utilisation typique concerne l'insertion de deux blocs intermédiaires connectés tête-bêche entre deux composants explicites.

On souligne que la connectivité est exprimée ici de manière globale, sans spécifier les noms de signaux à connecter.

Les Composants décrits en langage de type HLL peuvent posséder plusieurs implémentations possibles des modules de type HDL A_Portᵢ au niveau de chaque port i (voir Figure 3). La table de hachage "%HwifAlternateMap" spécifie le choix possible pour chaque module de type HDL d'un composant. Le système configurateur utilise cette information pour ne placer les blocs intermédiaires qu'en cas de stricte nécessité.

Le hachage %SysWrapMap définit, pour chaque implémentation d'un composant, son Bloc Système. Les entrées sont des noms de modules de type HDL associés avec le nom du bloc système et son implémentation de type HDL. Ces informations sont utilisées par le système Configurateur pour instancier le bloc système adéquat à partir de spécifications contenues dans le hachage %SysConnectMap (cf. 3 de A2).

Le hachage %SysPinConst associe à chaque Bloc Système, les connexions de certains signaux de son interface aux noms des signaux (wires) correspondants au niveau système. Ces connexions sont indépendantes des configurations et ne sont pas régies par les expressions régulières applicables lors du câblage des autres signaux.

Typiquement, les signaux concernés sont des signaux d'horloge, de remise à zéro (reset), etc... Les noms référencés sont déclarés dans un code de type HDL, spécifique pour chaque modèle en projet (design), et fournis par l'utilisateur (sous forme d'une variable ou d'un fichier) avec les descriptions des composants et des règles de connexion spécifiques.

Ce code spécifique de type HDL est inclus systématiquement au début du code de type HDL généré par le système Configurateur.

La procédure "&gen_sys_VlogInstParameter" est une procédure qui génère les paramètres d'instantiation pour le générateur du code de type HDL à partir du label et du type de chaque Composant.

Le hachage %Activity_TypeMap (cf. 1 de A1) associe le nom d'un composant avec son type spécifié par un mot clé:
- 'actor' pour les composants actifs.
- 'spectator' pour les blocs de Monitoring.
- 'checker' pour les blocs de Vérification.
- 'helper' pour les blocs Système ou les blocs Intermédiaire en cas de connexion indirecte.

La table "%PortProbeMap" est un hachage dont les entrées sont les noms des modules de type HDL utilisés dans la description des composants. Les valeurs sont à leur tour des hachages qui associent, à chaque nom de port, un tableau contenant le nom de bloc pouvant servir de Sonde pour observer les signaux de ce port et le nom de la classe C++ correspondante. Ce hachage informe le système Configurateur sur le type de Composant capable d'observer les signaux d'un port donné et le type d'API C++ pouvant être utilisée pour analyser le flux de contrôle et de données observé sur ce port.

La procédure &GenDest accepte en entrée le label du composant source, son type et son port. Le résultat retourné est un hachage qui associe le label du composant cible connecté avec son port.

Pour contrôler la cohérence de la configuration générée quel que soit l'ordre de prise en compte des Composants, le système Configurateur appelle la procédure &GenDest avec les paramètres obtenus pour le composant cible utilisé comme source et vérifie que le résultat correspond bien au composant et port source initial.

Le système Configurateur appelle la procédure &GenDest pour chaque composant contenu dans le fichier de configuration en parcourant tous ces ports.

Le hachage retourné par &GenDest peut contenir plusieurs composants avec leurs ports respectifs. C'est le cas notamment des connexions de type " bus " - &GenDest retourne tous les composants connectés par les bus sauf celui qui est donné en argument. Le système Configurateur insère automatiquement le composant « bus » nécessaire.

Le hachage %moduleToCppClassMap est un accélérateur de recherche permettant de retrouver la classe C++ à partir du nom de module de type HDL - il ne s'applique qu'aux Modèles élémentaires (voir 1.14).

Le hachage %classCppProtoMap décrit la génération des constructeurs d'objets de classes C++. Chaque entrée correspond au nom d'une classe C++. Chaque description est un hachage composé de quatre entrées :
- L'entrée "Prea" correspond à la génération de la première partie du constructeur (classe nom de l'instance, premiers paramètres).
- L'entrée "Iter" correspond à la partie itérative des paramètres du constructeur. Cette règle est appliquée pour chaque élément contenu dans l'entrée CfgCpp de la description du composant.
- L'entrée "Post" correspond à la partie finale du constructeur (derniers paramètres parenthèse fermante).
- L'entrée "Idle" est une règle de substitution pour la règle "Iter" pour les connexions non existantes (configurations partielles). Typiquement, un pointeur nul ou une chaîne nulle est généré(e).

Chaque entrée est une chaîne de caractères contenant des sélecteurs spéciaux prédéterminés, substitués par les valeurs calculées par le système Configurateur. Ces sélecteurs ont la forme générale #<Src|Dst|Act><Item># où 'Src', 'Dst' et 'Act' indiquent l'instance à prendre en compte , cette dernière étant transmise comme paramètre à un constructeur d'un objet HLL :
- 'Src' indique l'instance courante.
- 'Dst' l'instance connectée à l'autre extrémité du port.
- 'Act' indique l'instance composée correspondant au Composant Actif contenant le port d'observation.

<Item> est un mot-clé indiquant la sélection :
- 'Inst' pour le nom d'instance cpp.
- 'lid' pour le label de composant correspondant à Inst.
- 'Ict' pour le type de composant (DUT, VERIFIER, XACTOR, Monitor...).
- 'Port' pour le nom du port.

Les deux variables "$cpp_preamble" (cf. 3 de A5), "$cpp_postambl" (cf. 4 de A5) contiennent respectivement le début et la fin du texte de programme C++ généré par le système Configurateur. Le texte généré à partir du tableau %classCppProtoMap est inséré au milieu.

Les deux variables "$top_verilog_preamble" et "$top_verilog_postamble" contiennent respectivement le début et la fin du texte de l'instance 'top' de la description de type HDL (VERILOG) de la configuration. Typiquement, ce sont les instanciations des blocs d'horloge et autres blocs niveau système.

La description qui suit est un exemple simple de génération de Configuration par la mise en oeuvre du système Configurateur qui est illustrée dans le cas simplifié ci-après de l'architecture d'un Système constitué d'un pont (BRIDGE) reliant une unité centrale (CPU), une Mémoire et une carte entrée/sortie (I/O). L'Architecture du Système est représentée sur la figure 1.

Dans cet exemple, le CPU et le BRIDGE peuvent être modélisés, soit par un modèle VERILOG du projet "Design" (DUT, DUT_Core), soit par un modèle composé C++ (XACTOR).

L'interface entre le CPU et le BRIDGE est nommée FBUS. Plusieurs variantes de cette interface sont considérées correspondant à des étapes successives de développement.

Le bloc global Clock assure la distribution des signaux d'horloge et signaux système globalement pour l'ensemble des Composants

Le système Configurateur s'appuie sur la description des Interfaces de type HDL des Composants. Des interfaces simples, écrites en langage VERILOG, sont proposées ci-dessous à titre d'illustration pour chacun des Composants. Le système Configurateur n'analyse que cette partie des fichiers source contenus dans la bibliothèque des fichiers sources de type HDL (BFSHDL). Ils s'inscrivent dans une méthodologie de prise en compte progressive de variantes de modèles au fur et à mesure de leur disponibilité.

La description de type HDL des Interfaces qui suit est réduite à ce qui est nécessaire à l'illustration des possibilités et du fonctionnement du configurateur. Dans une situation réelle sont inclues les descriptions des comportements comme dans le cas du modèle de l'horloge (module CLOCK).

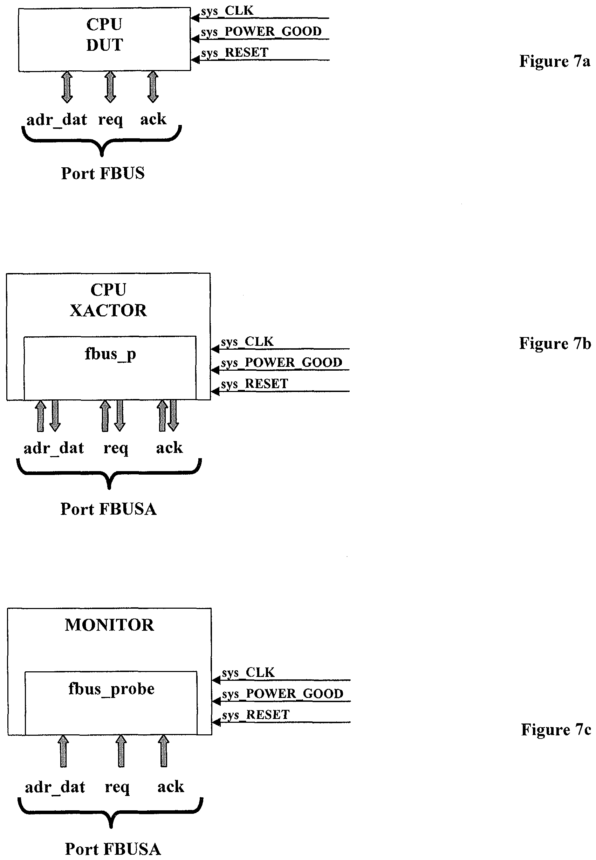

La description est la suivante :
- CPU :
   a) Le modèle DUT de composant CPU (figure 7a) présente un port FBUS de connexion avec le BRIDGE ainsi qu'un ensemble de signaux Système définis ci-après.

      ```
     module cpu (
         XXadr_dat,
         XXreq,
         XXack,
         //
         clk,
         reset,
         powergood
         );
     inout [63:0] XXadr_dat;
     inout [3:0] XXreq;
     inout [3:0] XXack;
     input clk;
     input reset;
     input powergood;
     endmodule
```
   b) Le modèle XACTOR (figure 7b) consiste en un modèle abstrait C++ dont l'instance de type HDL est constituée de celle du Port nommé fbus_p. Dans cet exemple, il est supposé que le Port FBUS présente une variante nommée FBUSA dans laquelle les signaux bidirectionnels adr_dat ont été éclatés en paires de signaux unidirectionnels in (inXXadr_dat) et out (outXXadr_dat).

      ```
     module fbus_p (
         inXXadr_dat,
         outXXadr_dat,
         inXXreq,
         outXXreq,
         inXXack,
         outXXack,
         //
         clk,
         reset,
         powergood
     );
     input [63:0] inXXadr_dat;
     output [63:0] outXXadr_dat;
     input [3:0] inXXreq;
     output [3:0] outXXreq;
     input [3:0] inXXack;
     output [3:0] outXXack;
     input clk;
     input reset;
     input powergood;
     endmodule
```
   c) Le modèle MONITOR du composant CPU est un modèle composé permettant le Monitoring de l'interface FBUS. Dans le cas où il n'existe pas d'adaptateur de port fbus_p dans la configuration, une sonde contenant l'instance fbus_probe sera générée (figure 7c).

      ```
     module fbus_probe (
         XXadr_dat,
         XXreq,
         XXack,
         //
         clk,
         reset,
         powergood
         );
     input [63:0] XXadr_dat;
     input [3:0] XXreq;
     input [3:0] XXack;
     input clk;
     input reset;
     input powergood;
     endmodule
```
- Bloc intermédiaires d'adaptation FBUS :
   Ces blocs réalisent l'adaptation d'interface au niveau FBUS dans le cas où la correspondance point à point des signaux est impossible. Le port FBUSA est la variante de FBUS dans laquelle les signaux bidirectionnels ont été éclatés en paires de signaux unidirectionnels d'entrée (in) et de sortie (out).

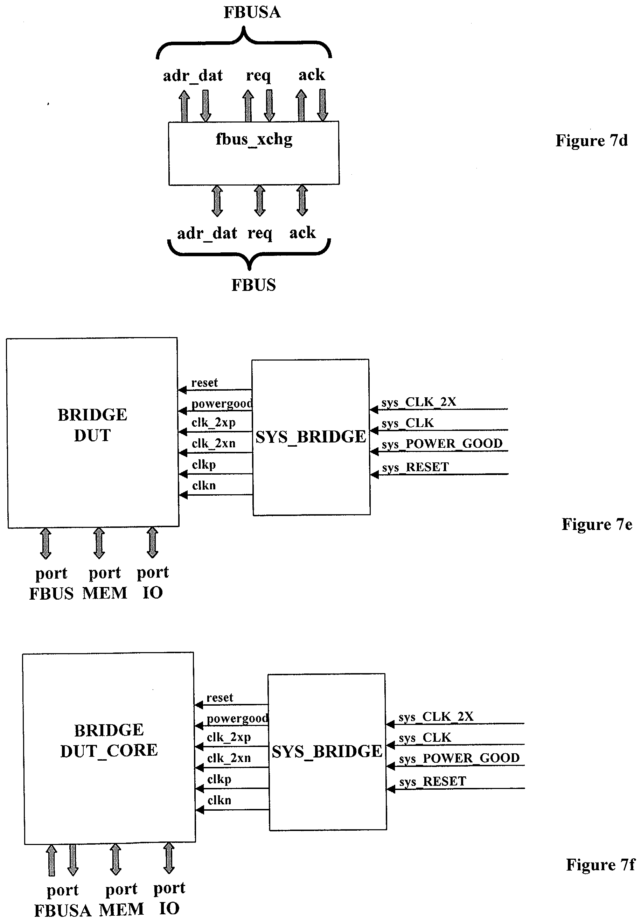

   Le modèle fbus_xchg (figure 7d) réalise l'adaptation entre l'interface FBUS du port fbus_p et celui d'un port FBUSA - la largeur de l'interface peut être paramétrée de façon à rendre compte d'évolutions technologiques possibles.

   ```
     module fbus_xchg (
         XXadr_dat,
         XXreq,
         XXack,
         //
         inXXadr_dat,
         outXXadr_dat,
         inXXreq,
         outXXreq,
         inXXack,
         outXXack
     );
     inout [63:0] XXadr_dat;
     inout [3:0] XXreq;
     inout [3:0] XXack;
         //
     input [63:0] inXXadr_dat;
     output [63:0] outXXadr_dat;
     input [3:0] inXXreq;
     output [3:0] outXXreq;
     input [3:0] inXXack;
     output [3:0] outXXack;
     // model body
     endmodule
```
- BRIDGE :
   a) Le modèle DUT du composant BRIDGE (figure 7e) présente les trois ports respectifs vers les modèles CPU, MEM et IO ainsi que les signaux Système délivrés par le bloc système dédié SYS_BRIDGE et par le bloc global CLOCK.

      ```
     module bridge (
         XXadr_dat,
         XXreq,
         XXack,
         YYadr,
         YYdata,
         ZZdata,
         ZZreq,
         ZZack,
         YYctrl,
         clk_2xp,
         clk_2xn,
         clkp,
         clkn,
         reset,
         powergood
         );
     inout [63:0] XXadr_dat;
     inout [3:0] XXack;
     inout [3:0] XXreq;
     output [31:0] YYadr;
     inout [63:0] YYdata;
     output [2:0] YYctrl;
     inout [15:0] ZZdata;
     input [1:0] ZZack;
     output [1:0] ZZreq;
     input clk_2xp;
     input clk_2xn;
     input clkp;
     input clkn;
     input reset;
     input powergood;
     endmodule
```
   b) Le modèle BRIDGE_CORE (figure 7f) est la variante DUT_CORE du composant BRIDGE présentant une interface FBUSA. Ce modèle traduit la situation où le modèle du contrôleur d'interface FBUS n'est pas disponible.

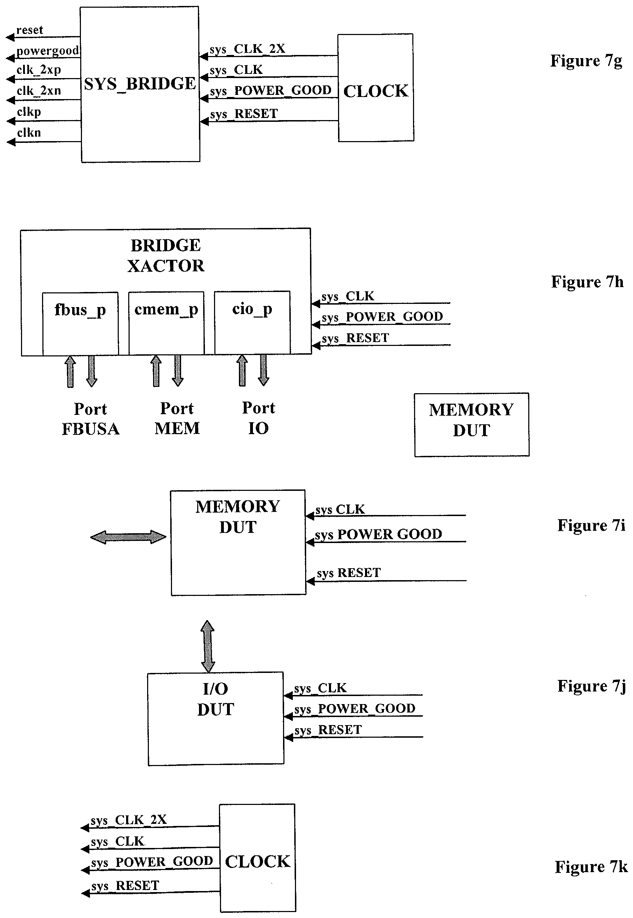

      ```
     module bridge_core (
         inXXadr_dat,
         outXXadr_dat,
         inXXreq,
         outXXreq,
         inXXack,
         outXXack,
         //
         YYadr,
         YYdata,
         YYctrl,
         //
         ZZdata,
         ZZreq,
         ZZack,
         //
         clk_2xp,
         clk_2xn,
         clkp,
         clkn,
         reset,
         powergood
         );
     input [63:0] inXXadr_dat;
     output [63:0] outXXadr_dat;
     input [3:0] inXXreq;
     output [3:0] outXXreq;
     input [3:0] inXXack;
     output [3:0] outXXack;
     output [31:0] YYadr;
     inout [63:0] YYdata;
     output [2:0] YYctrl;
     inout [15:0] ZZdata;
     input [1:0] ZZack;
     output [1:0] ZZreq;
     input clk_2xp;
     input clk_2xn;
     input clkp;
     input clkn;
     input reset;
     input powergood;
     endmodule
```
   c) Le modèle sys_bridge (figure 7g) est le block système dédié aux signaux Système du modèle Bridge - il est directement alimenté par le bloc CLOCK.

      ```
     module sys_bridge(
             clk_2xp,
             clk_2xn,
             clkp,
             clkn,
             reset,
             powergood,
             //
             sys_CLK_2X,
             sys_CLK,
             sys_RESET,
             sys_POWER_GOOD
             );
     output clk_2xp;
     output clk_2xn;
     output clkp;
     output clkn;
     input sys_CLK_2X;
     input sys_CLK;
     input sys_RESET;
     input sys_POWER_GOOD;
     output reset;
     output powergood;
     clk_2xp = sys_CLK_2X;
     clk_2xn = ∼sys_CLK_2X;
     clkp = sys_CLK;
     clkn = ∼sys_CLK;
     reset = sys_RESET;
     powergood = sys_POWER_GOOD;
     endmodule
```
   d) Le modèle XACTOR (figure 7h) est un modèle abstrait C++ dont l'instance de type HDL est constituée de celle des différents ports respectivement fbus_p, cmem_p et cio_p vers CPU, MEM et IO.

      ```
module cmem_p (
         YYadr,
         YYdata,
         YYctrl,
         clk,
         reset,
         powergood
         );
     output [31:0] YYadr;
     inout [63:0] YYdata;
     output [2:0] YYctrl;
     input clk;
     input reset;
     input powergood;
     endmodule
     module cio_p (
         ZZdata,
         ZZreq,
         ZZack,
         //
         clk,
         reset,
         powergood
         );
     inout [15:0] ZZdata;
     input [1:0] ZZack;
     output [1:0] ZZreq;
     input clk;
     input reset;
     input powergood;
     endmodule
```
- MEMORY:
   Le modèle DUT du composant MEMORY (figure 7i) présente les ports respectifs vers les modèles BRIDGE et CLOCK.

   ```
 modèle DUT :
     module cmem (
         YYadr,
         YYdata,
         YYctrl,
         clk,
         reset,
         powergood
         );
     input [31:0] YYadr;
     inout [63:0] YYdata;
     input [2:0] YYctrl;
     input clk;
     input reset;
     input powergood;
     endmodule
```
- I/O :
   Le modèle DUT du composant I/O (figure 7j) présente les ports respectifs vers les modèles BRIDGE et CLOCK.

   ```
 modèle DUT :
     module cio (
         ZZdata,
         ZZreq,
         ZZack,
         clk,
         reset,
         powergood
         );
     inout [15:0] ZZdata;
     output [1:0] ZZack;
     input [1:0] ZZreq;
     input clk;
     input reset;
     input powergood;
     endmodule
```
- Block Système global :
   Ce modèle (figure 7k) assure la fourniture des signaux Système alimentant les blocs système dédiés à chaque composant.

   ```
     module Clock (
                  sys_POWER_GOOD,
                  sys_RESET,
                  sys_CLK,
                  sys_CLK_2X
                  );
     output sys_POWER_GOOD;
     output sys_RESET;
     output sys_CLK;
     output sys_CLK_2X;
     parameter HALF_PERIOD = 75; // 7.5ns, 66MHz
     parameter RESET_DELAY = 10000000000 ; // 1.0ms
     parameter POWER_GOOD_DELAY = 5000000000 ; // 0.5ms
     initial begin;
     sys_POWER_GOOD = 0;
     sys_ RESET = 0;
     sys_CLK = 0;
     sys_CLK_2X = 0;
     #POWER_GOOD_DELAY sys_POWER_GOOD = 1;
     #RESET_DELAY sys_RESET = 1;
     end
     always begin
     #HALF_PERIOD sys_CLK = ∼sys_CLK;
     end
     always @(posedge sys_CLK_2X) begin
      sys_CLK = ∼sys_CLK;
     end
     endmodule
```

### Définition des configurations :

Les variantes de configuration marquent les différentes étapes de vérification suivant la disponibilité des modèles - le système Configurateur élabore les configurations de façon non ambiguë à partir des informations topologiques contenues dans le fichier de configuration.

La première configuration est définie par le fichier de configuration 1 ci-après et représentée figure 8a : les modèles DUT du CPU et du BRIDGE ne sont pas disponibles.

**Fichier de configuration 1 :**

| | |
|---|---|
| CPU_0 | XACTOR |
| CPU_0 | MONITOR |
| BRIDGE_0 | XACTOR |
| CMEM_0 | DUT |
| CIO_0 | DUT |

| | |
|---|---|
| Le XACTOR CPU partage le port fbus_p avec le MONITOR. | |

La deuxième configuration est définie par le fichier de configuration 2 ci-après et représentée figure 8b.

Le BRIDGE XACTOR est connecté au CPU XACTOR par une interface de type FBUSA spécifiée dans le fichier de configuration par l'attribut FBUSA=FBUS_xchg - le système Configurateur insère automatiquement le deuxième adaptateur fbus_xchg 102.

**Fichier de configuration 2 :**

| | | |
|---|---|---|
| CPU_0 | XACTOR | FBUSA=FBUS_xchg |
| CPU_0 | MONITOR | |
| BRIDGE_0 | XACTOR | |
| CMEM_0 | DUT | |
| CIO_0 | DUT | |

| | | |
|---|---|---|
| Le XACTOR CPU partage le port fbus_p avec le Monitor. | | |

La troisième configuration est définie par le fichier de configuration 3 ci-après et représentée figure 8c : le BRIDGE DUT_CORE est connecté au CPU XACTOR par une interface de type FBUSA spécifiée dans le fichier de configuration par l'attribut FBUSA=FBUS_xchg - le système Configurateur insère automatiquement le deuxième adaptateur fbus_xchg 102.

**Fichier de configuration 3 :**

| | | |
|---|---|---|
| CPU_0 | XACTOR | FBUSA=FBUS_xchg |
| CPU_0 | MONITOR | |
| BRIDGE_0 | DUT_CORE | |
| CMEM_0 | DUT | |
| CIO_0 | DUT | |

| | | |
|---|---|---|
| Le XACTOR CPU partage le port fbus_p avec le MONITOR. | | |

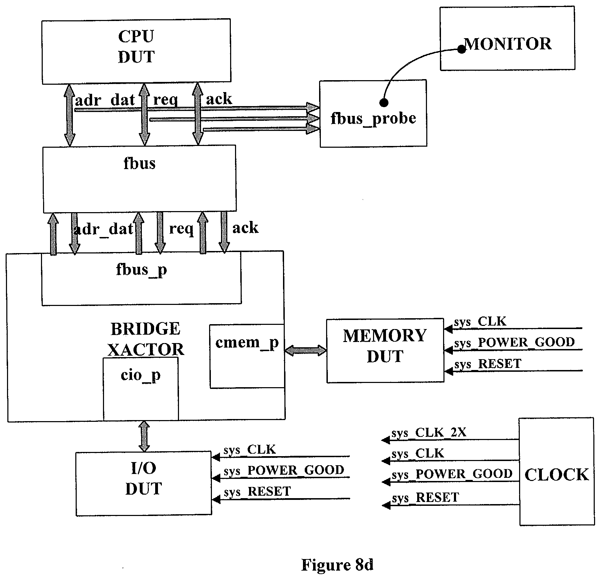

La quatrième configuration est définie par le fichier de configuration 4 ci-après et représentée figure 8d : le modèle CPU DUT est connecté avec le modèle BRIDGE XACTOR - le système Configurateur insère automatiquement un adaptateur d'interface fbus pour réaliser la connexion entre le CPU DUT et le BRIDGE XACTOR sans mention explicite de ce bloc dans le fichier de configuration.

**Fichier de configuration 4 :**

| | |
|---|---|
| CPU_0 | DUT |
| CPU_0 | MONITOR |
| BRIDGE_0 | XACTOR |
| CMEM_0 | DUT |
| CIO_0 | DUT |

Le Configurateur instancie automatiquement la Sonde fbus_probe pour permettre l'observation de l'interface FBUS par le Monitor.

La cinquième configuration est définie par le fichier de configuration 5 ci-après et représentée figure 8e : tous les modèles DUT sont disponibles.

**Fichier de configuration 5 :**

| | |
|---|---|
| CPU_0 | DUT |
| CPU_0 | MONITOR |
| BRIDGE_0 | DUT |
| CMEM_0 | DUT |
| CIO_0 | DUT |

Le système Configurateur instancie automatiquement la Sonde fbus_probe pour permettre l'observation de l'interface FBUS par le Monitor.

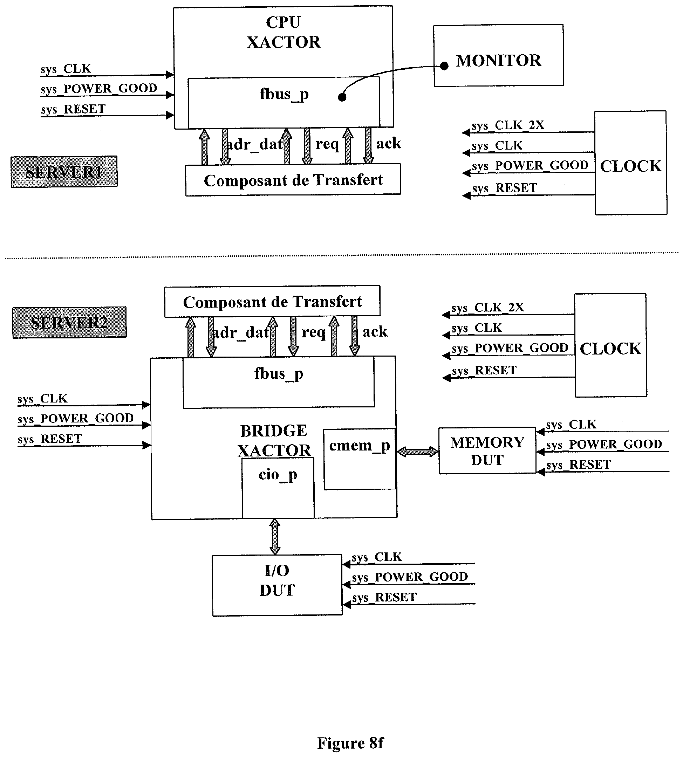

La sixième configuration est définie par le fichier de configuration 6 ci-après et représentée par la figure 8f : c'est une Configuration Multi-serveur - la Config1 est répartie entre les 2 serveurs SERVER1 et SERVER2, la coupure se faisant au niveau de l'interface FBUS.

**Fichier de configuration 6 :**

| | | |
|---|---|---|
| CPU_0 | XACTOR | SERVER1 |
| CPU_0 | MONITOR | SERVER1 |
| BRIDGE_0 | XACTOR | SERVER2 |
| CMEM_0 | DUT | SERVER2 |
| CIO_0 | DUT | SERVER2 |

Les règles de connectivité permettant la génération des tables de connectivités et de toute configuration pour cet exemple sont décrites en langage PERL dans les annexes A1 à A5.

L'annexe A1 décrit, dans le cas de l'exemple choisi, les règles topologiques liées aux composants actifs à utiliser par le système Configurateur.

L'annexe A2 décrit les règles topologiques liées aux Blocs systèmes et aux Blocs intermédiaires à utiliser par le système Configurateur.

L'annexe A3 décrit les procédures de connexion des Composants à utiliser par le système Configurateur.

L'annexe A4 décrit le code de génération du fichier en langage de type HDL (Verilog_top.v) de connexion des composants à utiliser par le système Configurateur.

L'annexe A5 décrit le code de génération des Classes C++.

Les annexes A6 et A7 décrivent les fichiers résultats générés par le système Configurateur respectivement en langage bas niveau de type HDL (VERILOG) et en langage haut niveau (C++) pour constituer le modèle de la configuration définie par la troisième configuration correspondant à la figure 8c. Le configurateur peut ainsi, avec l'utilisateur-développeur, réaliser son modèle selon la variante de configuration choisie.

On aurait pu, de la même façon, illustrer les autres variantes de réalisation du modèle (figures 8a, 8b et 8d à 8f) qui pourraient être traitées par le système Configurateur pour produire les fichiers résultats correspondants, constituant les modèles de simulation de l'architecture système envisagée pour le circuit intégré en développement.

La figure 2 représente les divers moyens mis en oeuvre par un système informatique 40 mettant en oeuvre le procédé de l'invention.

Le calculateur 40 comporte une unité centrale 41, comprenant des circuits de traitement de données 42 (unité de traitement arithmétique ALU et mémoires de programmes associés, globalement appelés, par la suite, ALU, par commodité), et comporte diverses mémoires, de programmes ou fichiers de données d'exploitation, associées à l'unité centrale 41.

L'unité centrale 41 comporte une mémoire 51 contenant la table de composants et de règles de connexions (TCRC), la table de règles de cohérence de connexions (TRCOH) et la table de formatage de fichiers source (TFMT). Ces tables sont créées à partir du fichier de description d'architecture (FDARCH).

La mémoire 51 contient aussi des programmes ou moteurs intelligents PROGCONF nécessaires pour constituer le système Configurateur exploitable par l'ALU 42.

Une mémoire 53 contient la table de connexion des instances (TCINST) représentant les instances des composants et leurs interconnexions mutuelles requises par la Configuration définie dans le fichier de configuration FCONF et conformes au règles contenues dans les tables TCRC et TRCOH.

La mémoire 53 contient aussi la table de câblage (TCAB) représentant les connexions physiques (fils) entre les parties de type HDL des composants instanciés à partir de la bibliothèque de fichiers sources de type HDL (BFSHDL).

Il en résulte les fichiers MGHDL et MGHLL représentant respectivement les fichiers sources du modèle global de simulation de type HDL (VERILOG ou VHDL) et de type HLL (C++) générés par le système Configurateur, modèle permettant la co-simulation d'un circuit ASIC dans son environnement de vérification.

La mise en oeuvre du procédé de l'invention va maintenant être exposée.

Le procédé d'établissement automatique, au moyen du calculateur ou système de traitement de données 40, de modèle de simulation d'une configuration de modèles de composants déterminés, mutuellement reliés par des connexions d'inter-fonctionnement, pour constituer un modèle global de simulation MGHDL / MGHLL d'un circuit ASIC dans son environnement de vérification, comporte les étapes suivantes (cf. figure 2a) :
- un opérateur, éventuellement aidé ou même remplacé par un calculateur, établit le fichier de description d'architecture (FDARCH) décrivant les règles d'interconnexion entre les différents composants, les modèles pouvant être utilisés pour modéliser chacun de ces composants et les règles de formatage pour générer les fichiers source du modèle résultant.
- un opérateur, éventuellement aidé ou même remplacé par un calculateur, établit la bibliothèque BFSHDL de fichiers source, de parties de type HDL de modèles de composants respectifs susceptibles d'être utilisés dans une configuration conformément au contenu du fichier FDARCH.
- l'opérateur établit le fichier FCONF de configuration visée, identifiant les composants et les modèles voulus (cf. figure 2b).
- Le système de traitement lit le fichier de description d'architecture (FDARCH) généré et génère et place en mémoire les tables TCRC, TRCOH et TFMT à partir de FDARCH (cf. figure 2b).
- Les diverses tables TCRC, TRCOH et TFMT étant rendues accessibles au système de traitement de données 40 (cf. figure 2c),
- le système de traitement de données 40 lit le fichier de la configuration visée FCONF pour identifier les composants et leurs modèles requis (cf. figure 2c),
- il lit la table de composants et de règles de connexion pour instancier et placer dans la table de connexion des instances TCINST les composants requis (cf. figure 2c).
- Il lit la table de règles de cohérence de connexions (TRCOH) pour vérifier la connectivité physique entre modèles et insérer, le cas échéant, des composants intermédiaires.
- Il lit dans la bibliothèque BFSHDL les fichiers source correspondants aux parties de type HDL des modèles de composants instanciés dans la table TCINST pour engendrer la table TCAB de connexions physiques (fils) entre les modèles de composants (cf. figure 2c).
- Il applique les règles de formatage de la table TFMT au contenu des tables TCINST et TCAB et il génère les fichiers source finaux MGHDL/MGHLL de modèle global de simulation correspondant à la configuration spécifiée par le fichier de configuration (FCONF) (cf. figure 2d).

Le fichier d'entrée FCONF correspond donc à une description du schéma théorique du type de la figure 1, sans toutefois les modèles, qui sont ajoutés lors de l'élaboration des tables intermédiaires TCINST, TCAB descripteurs de configuration et de connexions, afin de fournir un modèle global de simulation qui soit effectivement opérationnel et qui, en outre, ici, permette une observation de signaux particuliers.

Les diverses tables ci-dessus peuvent être préalablement stockées dans le calculateur 40 ou bien avoir été stockées dans une mémoire externe que l'on relie au calculateur 40, éventuellement par un réseau de transmission de données pour qu'elles lui soient accessibles.

L'ALU 42 dispose alors de toutes les données de base nécessaires aux tables outils TCRC, TRCOH, TFMT pour que le programme PROGCONF associé au système Configurateur, commande, à l'ALU 42, l'élaboration des fichiers finaux MGHDL/MGHLL (cf. figure 2d).

La table intermédiaire TCAB, des descripteurs de connexions physiques, générée ici à partir d'une description de type HDL, est, dans cet exemple, soumise à une vérification, afin de détecter des erreurs manifestes, telles que l'existence d'entrées ou sorties non raccordées ou encore de sorties reliées en parallèle, lorsqu'il s'agit de sorties classiques de type dit 'totem', donc autres que celles à collecteur ouvert ou à inhibition commandée (tri-state).

En cas de modification du fichier de départ FCONF, les tables intermédiaires TCINST, TCAB et les fichiers finaux MGHDL/MGHLL peuvent ainsi être redéfinis à partir des fichiers sources de modèles et de fichier FDARCH. On évite ainsi des risques d'erreur.

Dans cet exemple, l'ALU 42 génère un modèle global de co-simulation en associant, à au moins un bloc fonctionnel, plusieurs modèles de spécification fonctionnelle écrits en langages de programmation de niveaux différents, ici de type HDL et C++.

On conçoit que la présente invention peut être mise en oeuvre selon d'autres formes spécifiques, sans sortir de son domaine d'application tel que revendiqué. Par conséquent, la présente description détaillée doit être considérée comme étant une simple illustration d'un cas particulier dans le cadre de l'invention et peut donc être modifiée sans sortir du domaine défini par les revendications jointes.

### ANNEXE : Description du code Configurateur

### A1 - Règles Topologiques liées aux Composants actifs

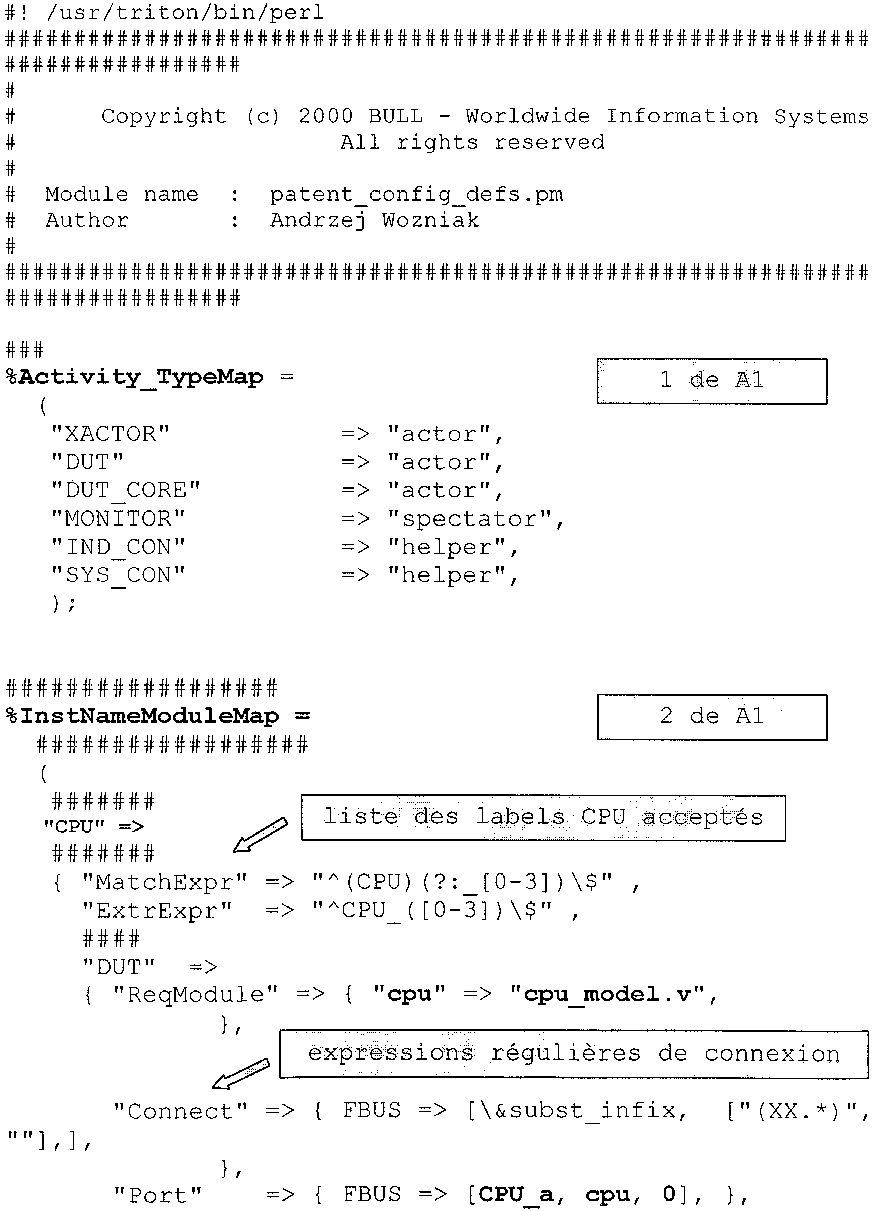

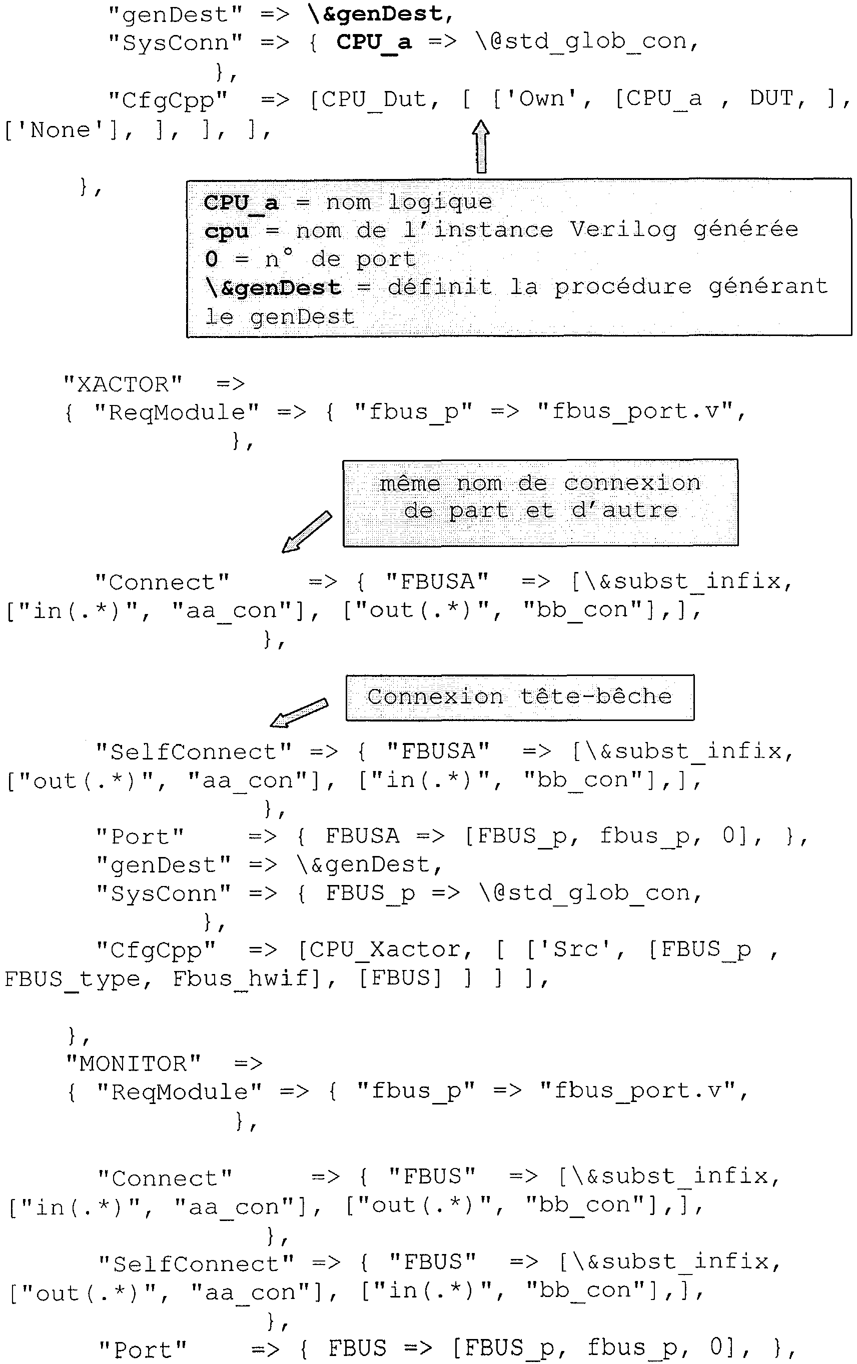

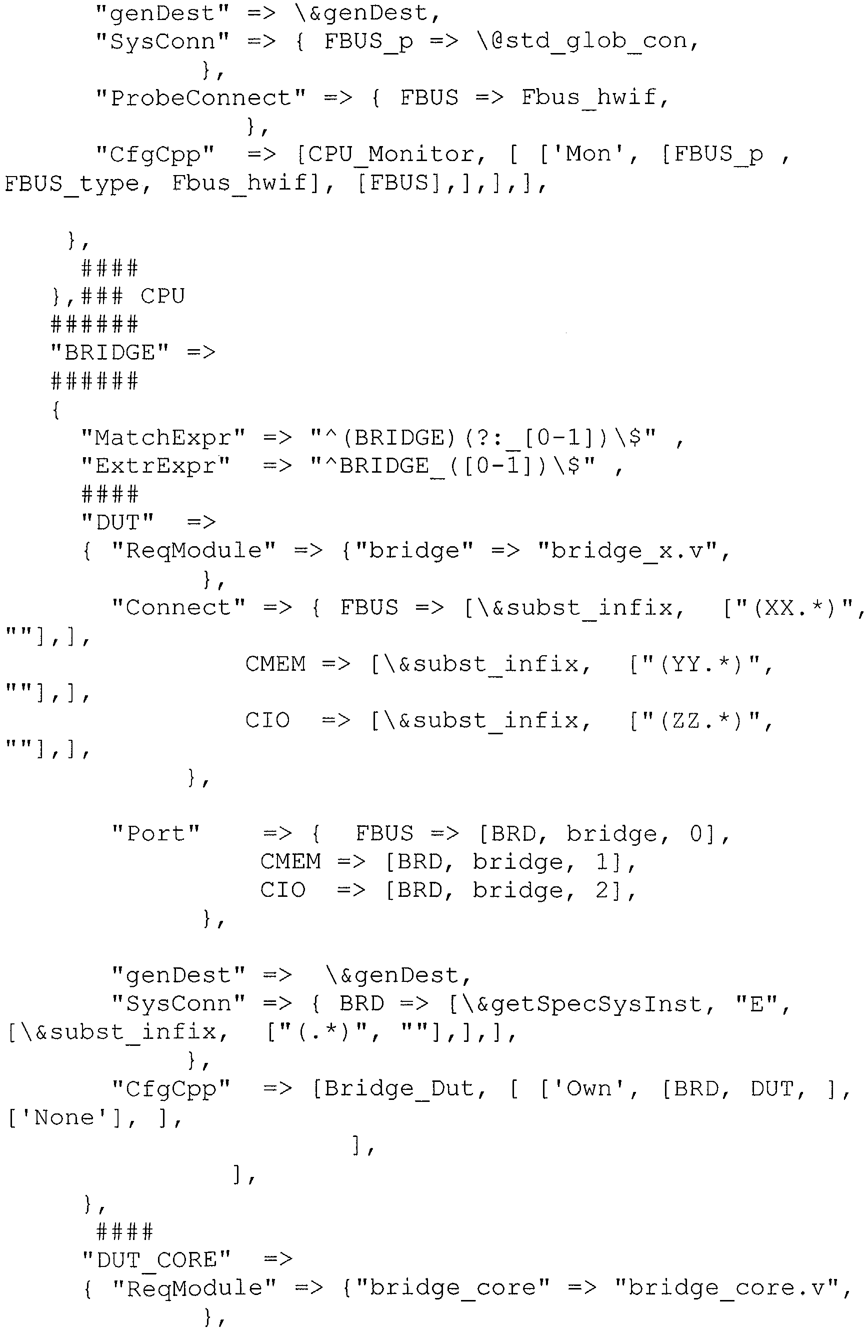

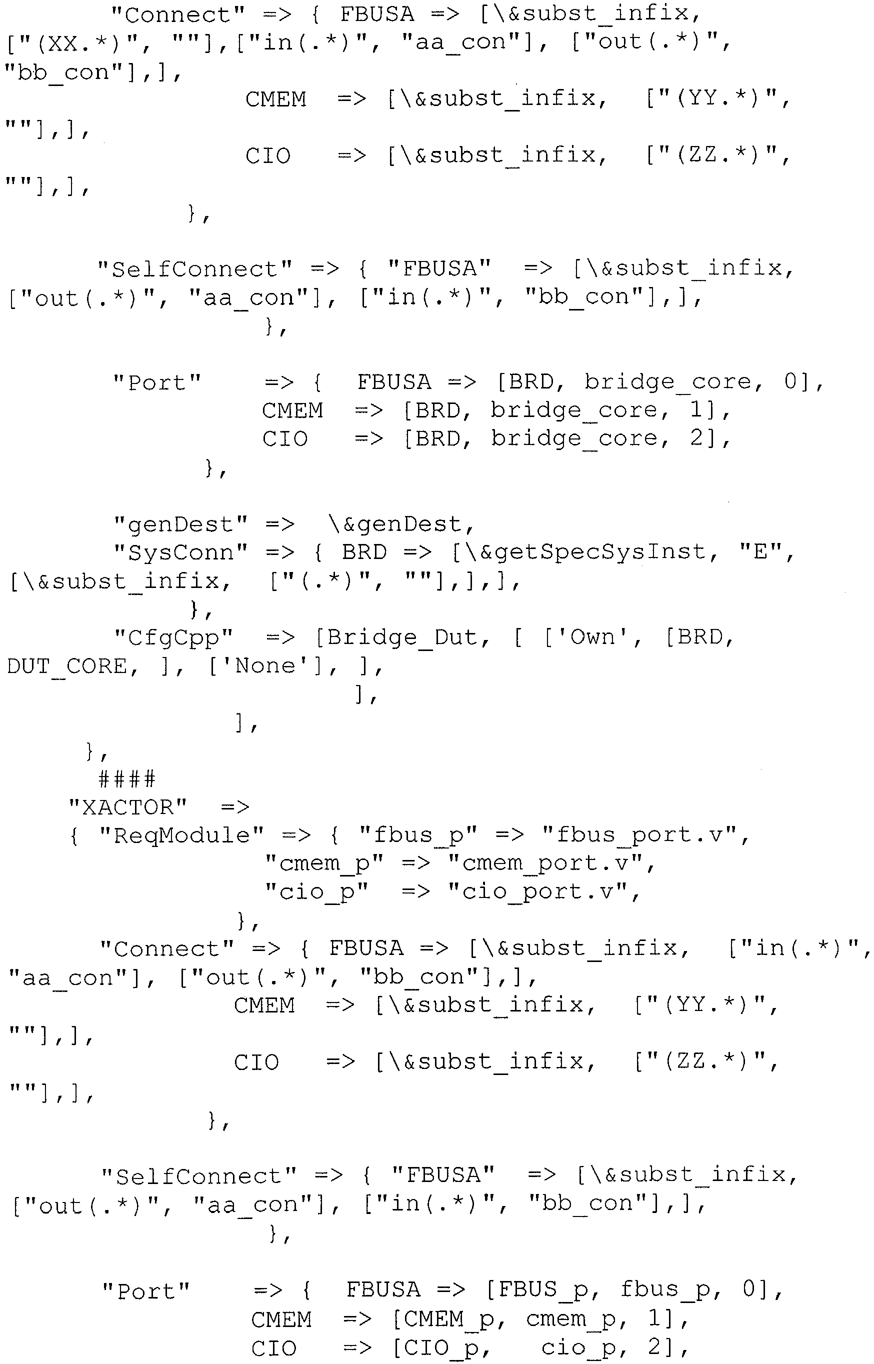

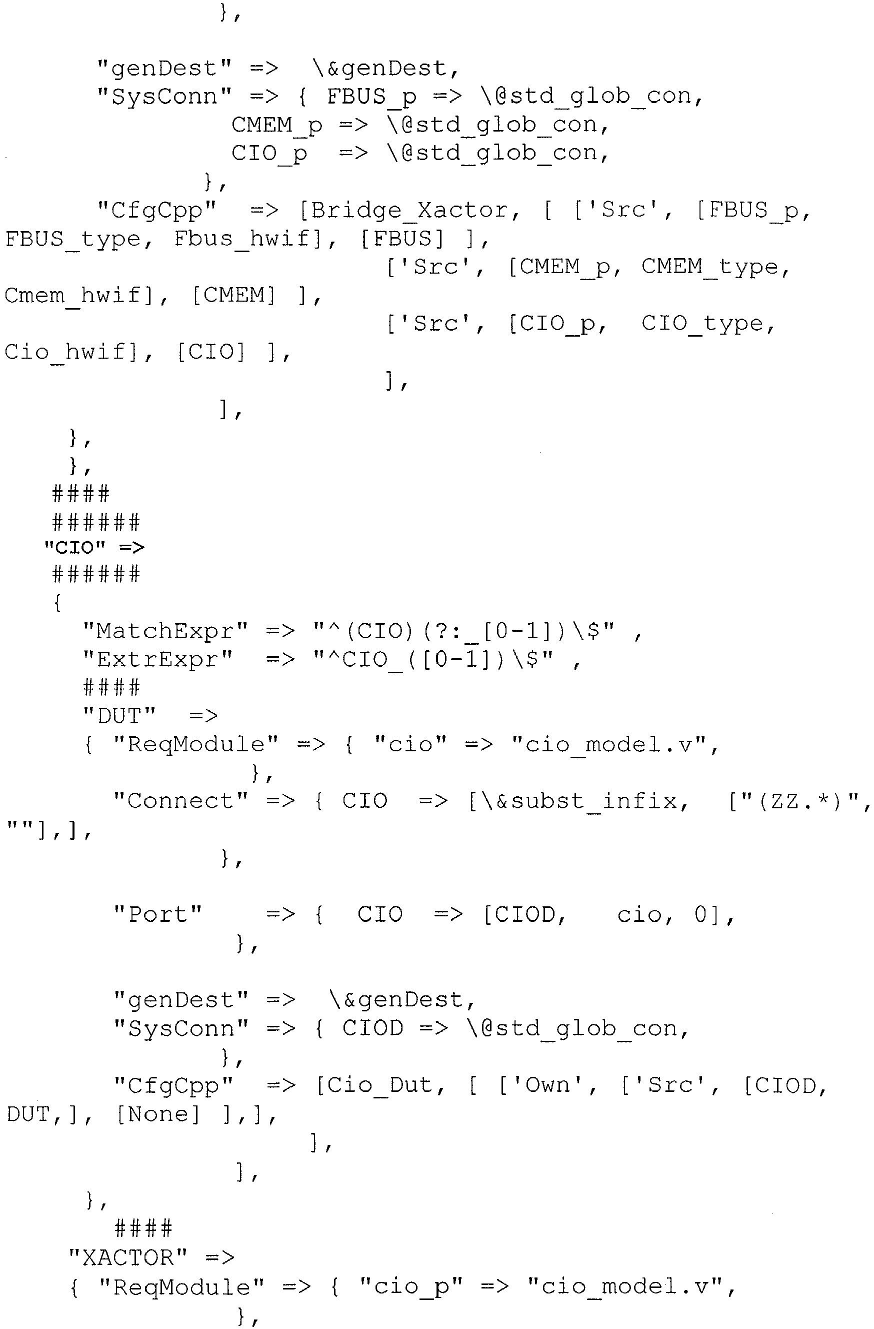

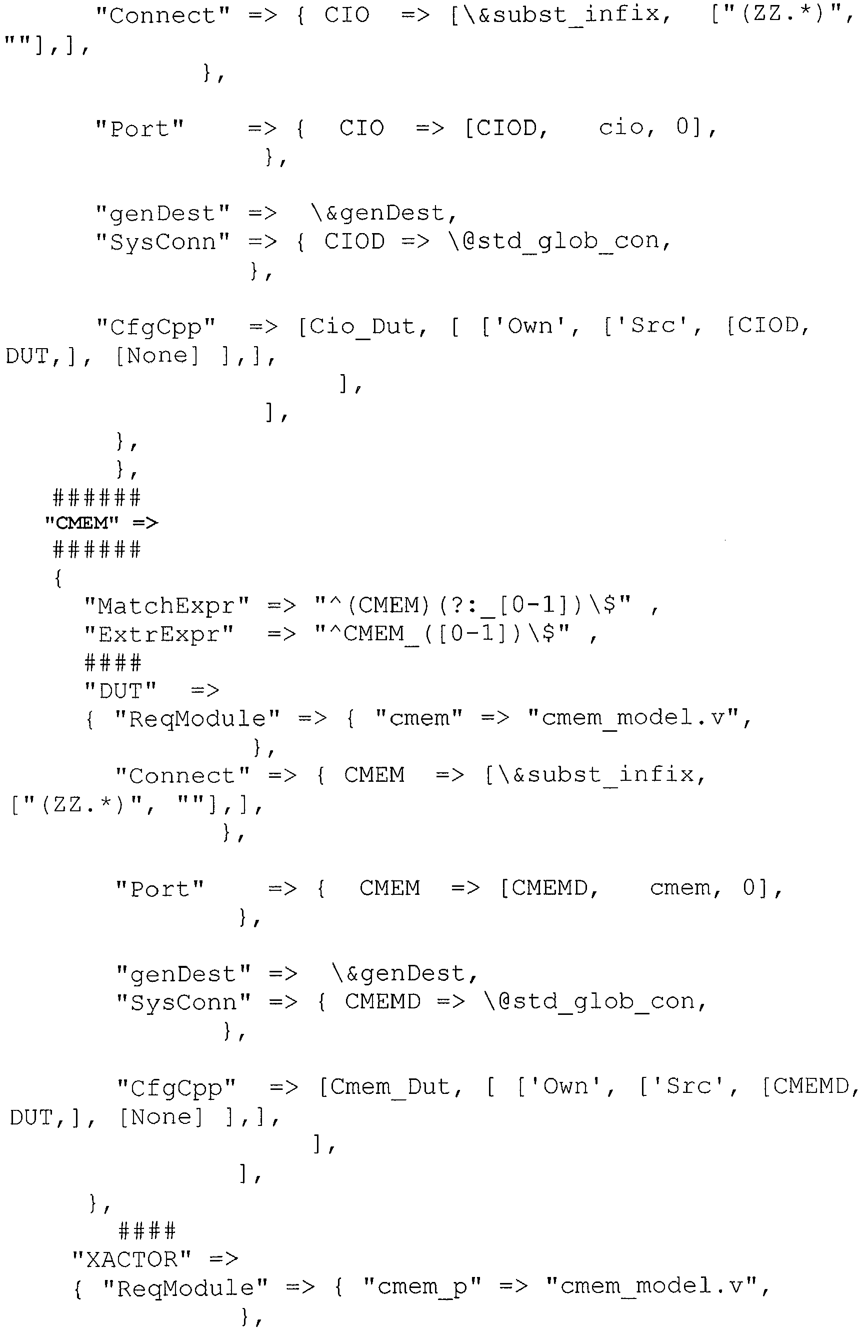

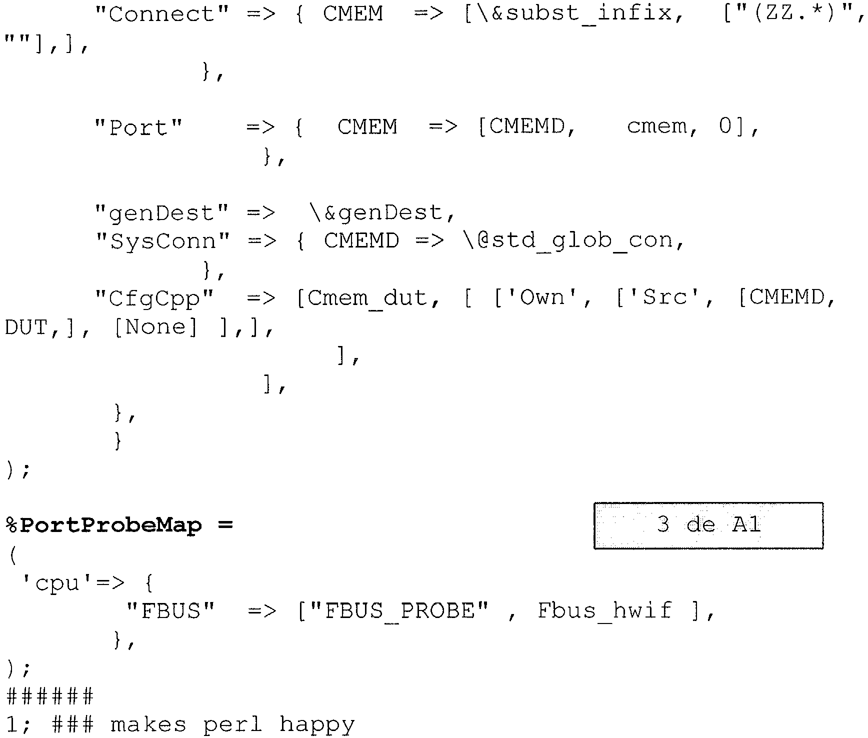

### ANNEXE

### A2 - Règles Topologiques liées aux Blocs système et blocs intermédiaires

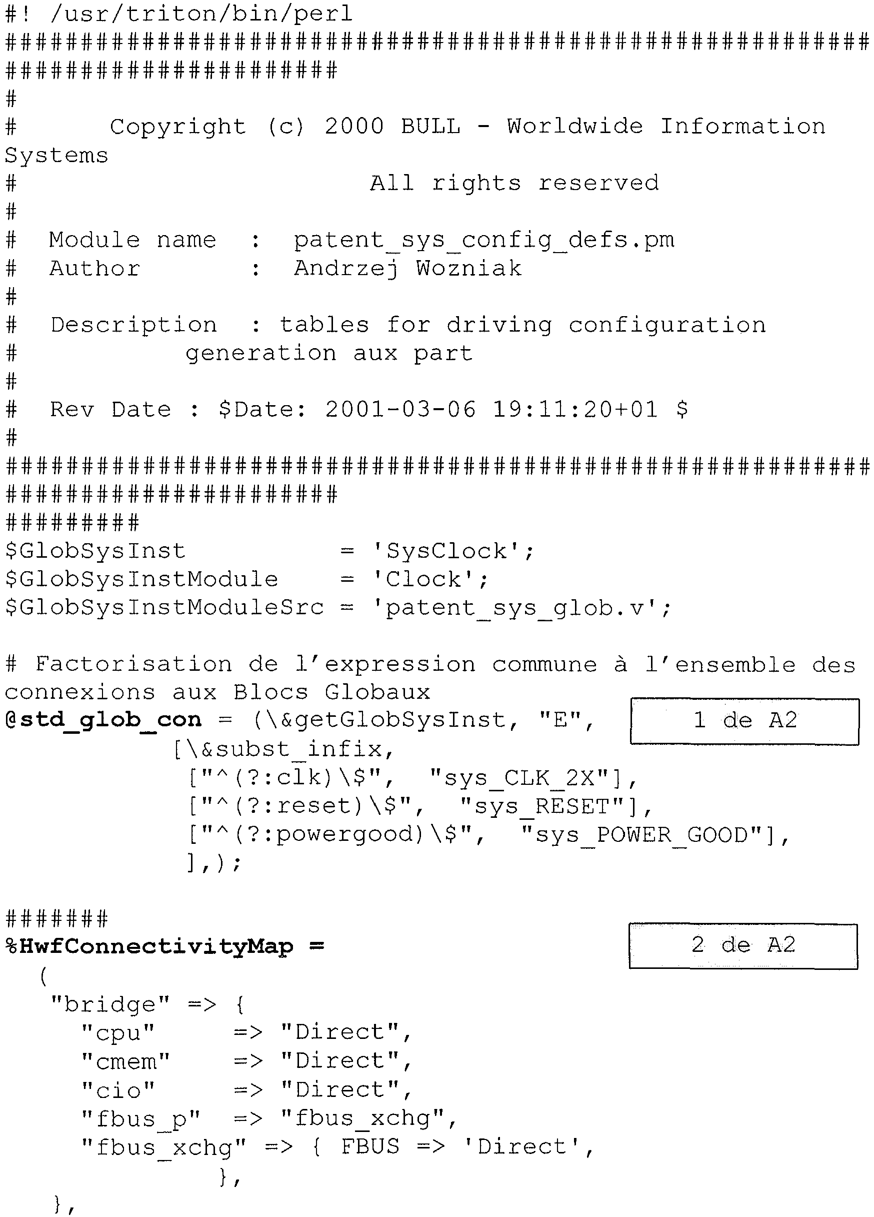

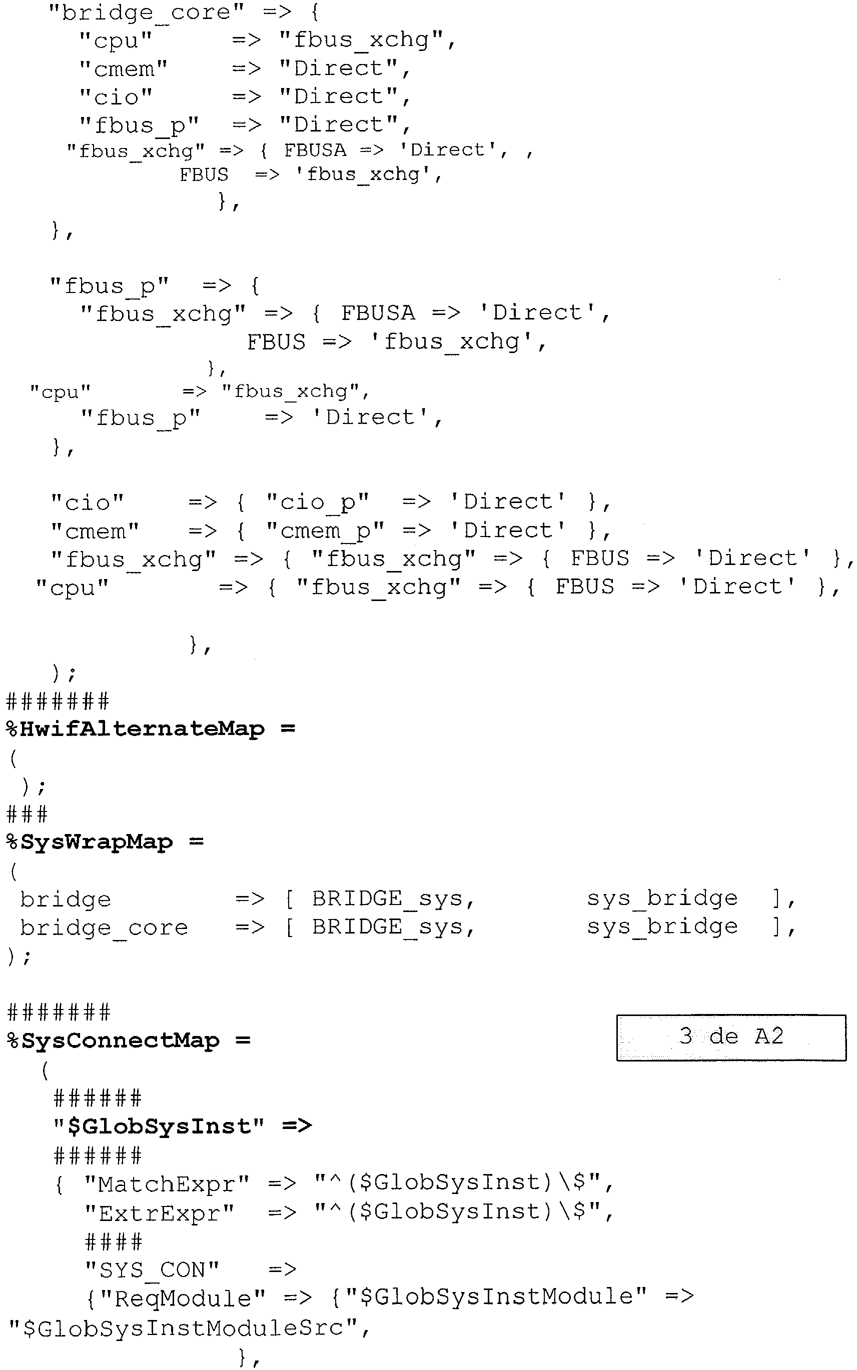

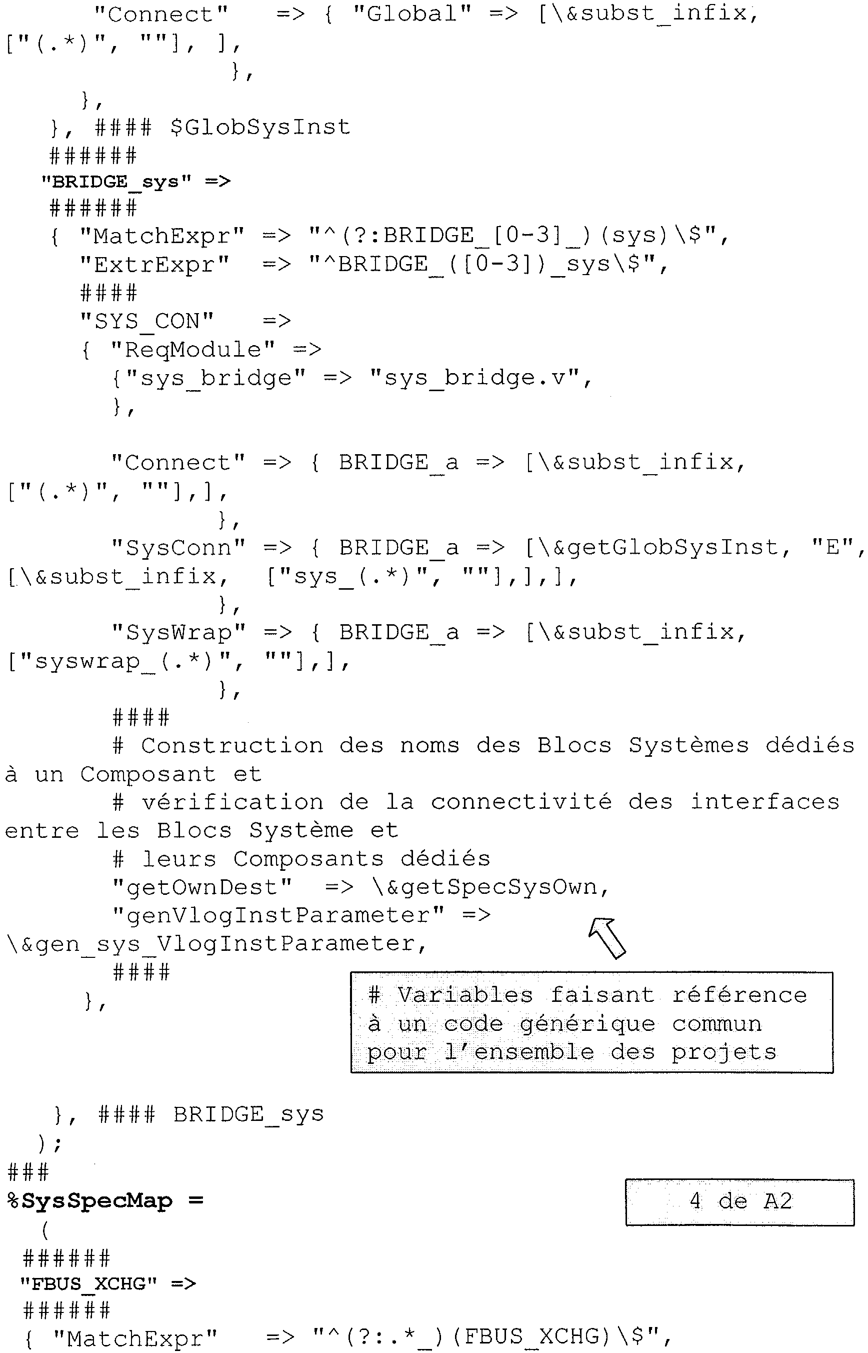

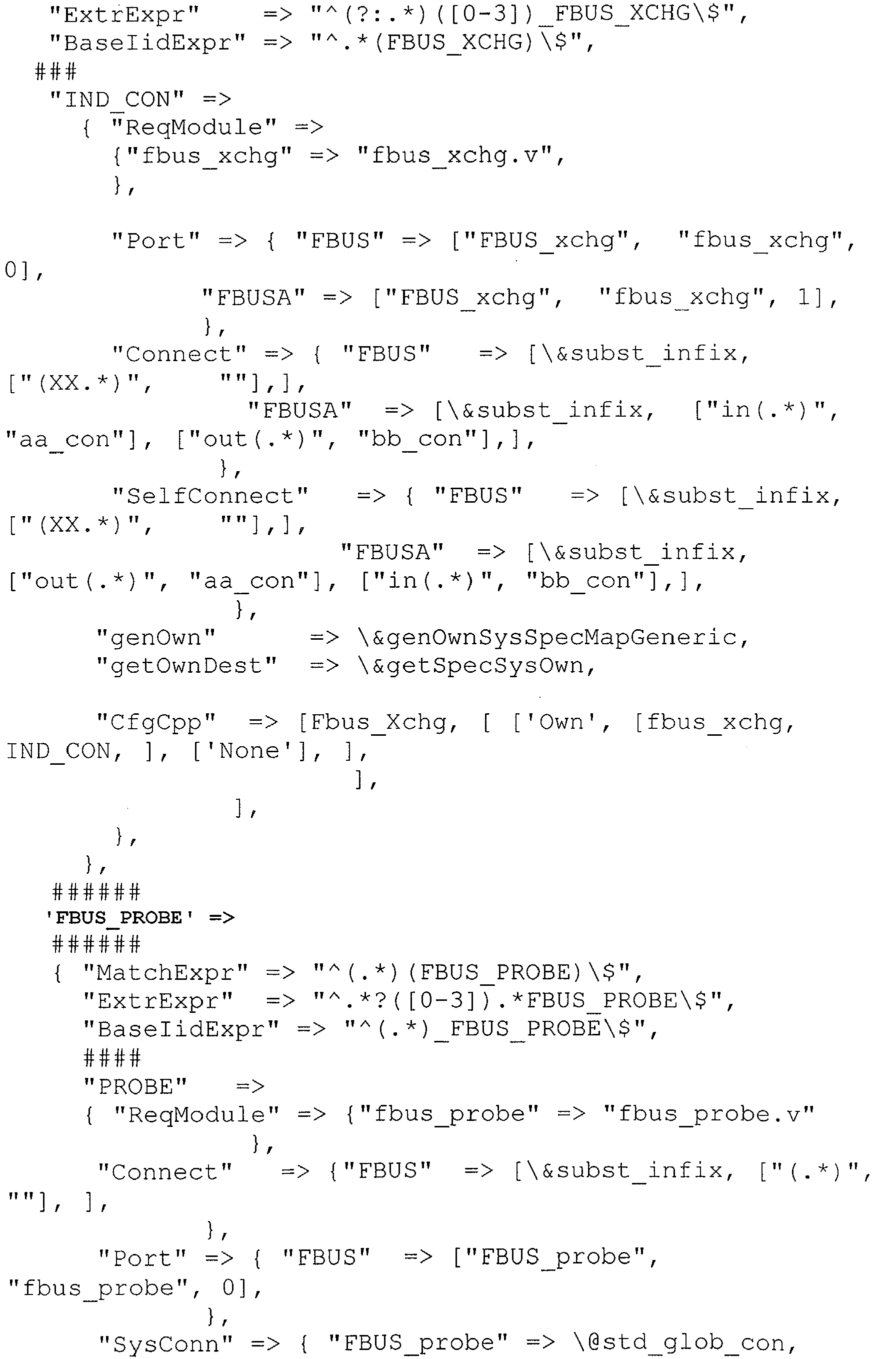

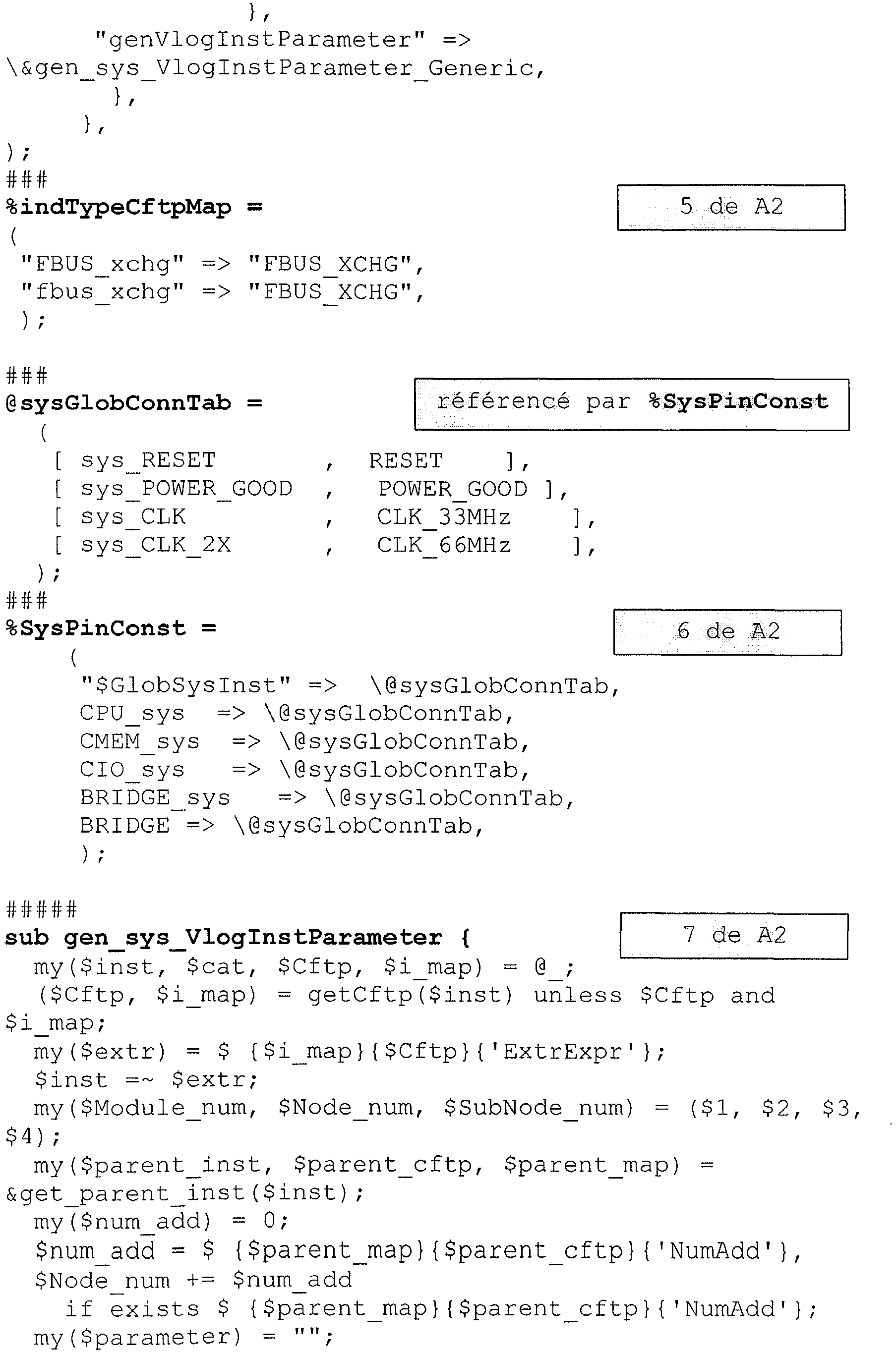

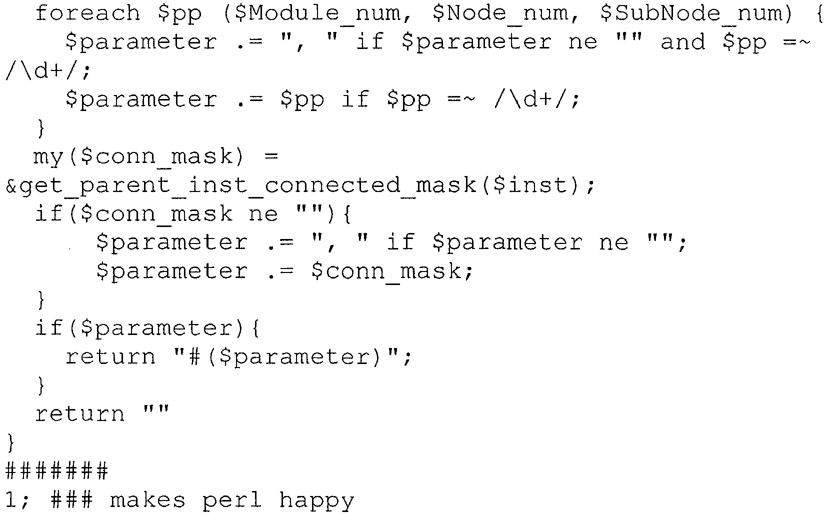

### ANNEXE

### A3 - Procédures de connexion des Composants

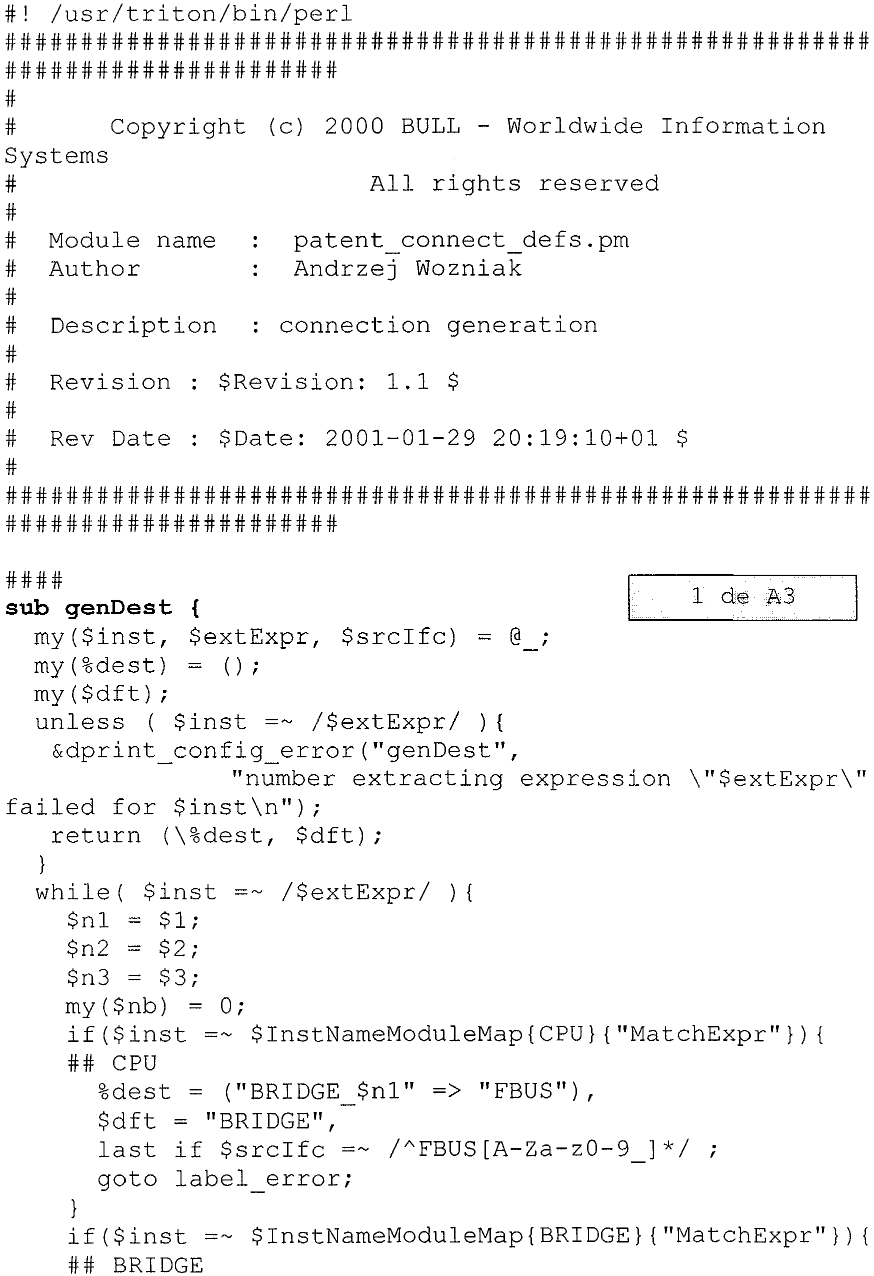

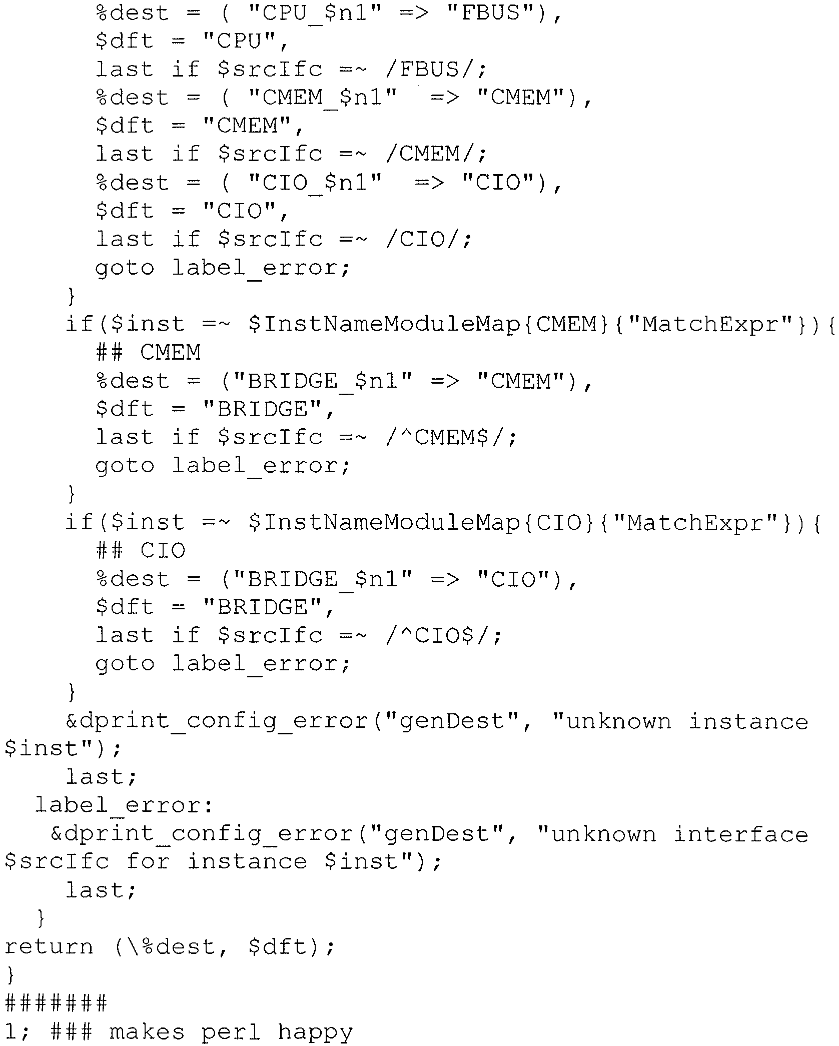

### ANNEXE

### A4 - Code de génération du fichier Verilog Top.v de connexion des Composants

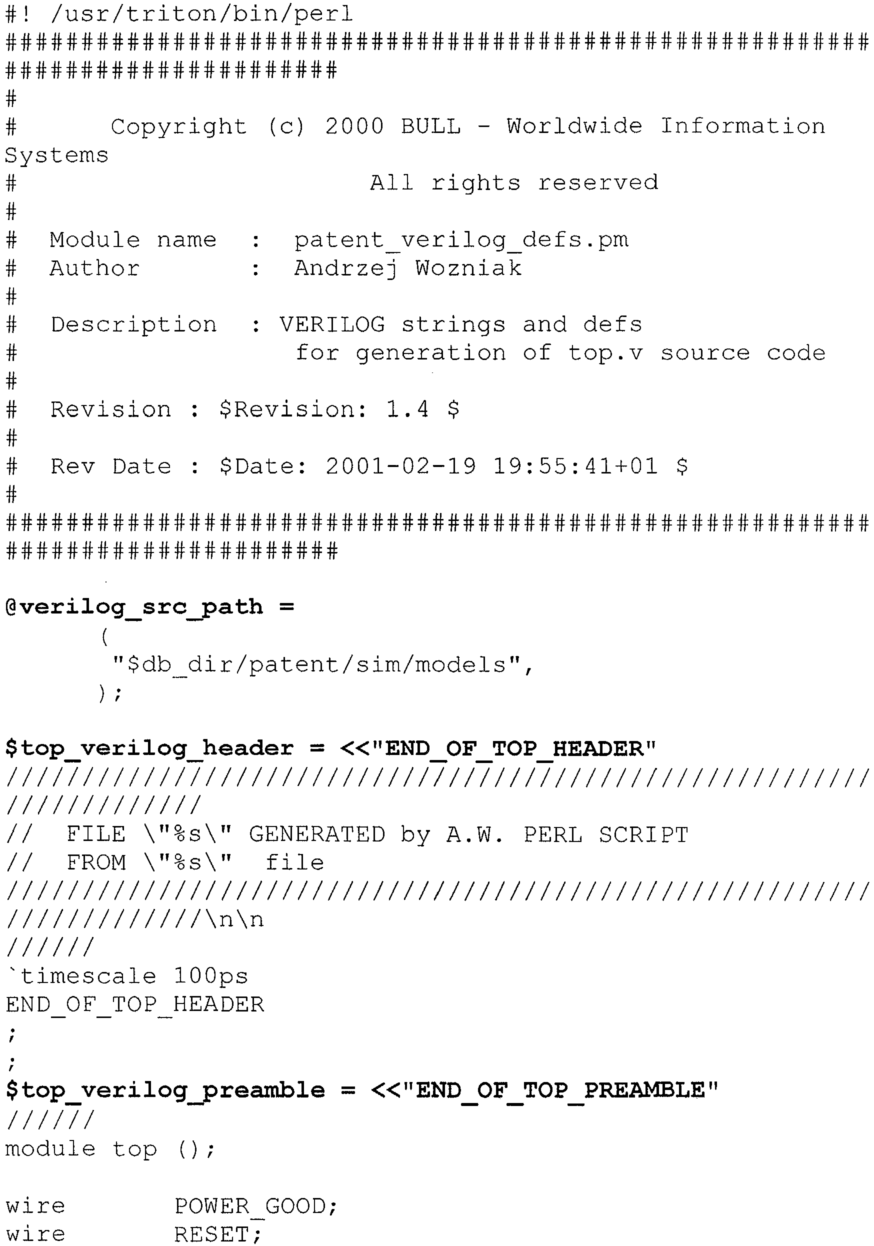

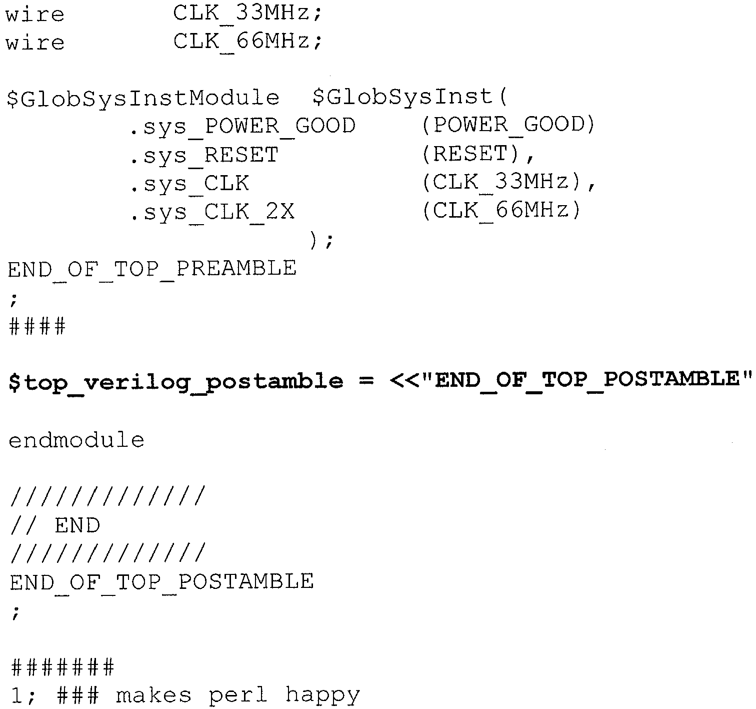

### ANNEXE

### A5 - Code de génération des Classes C++

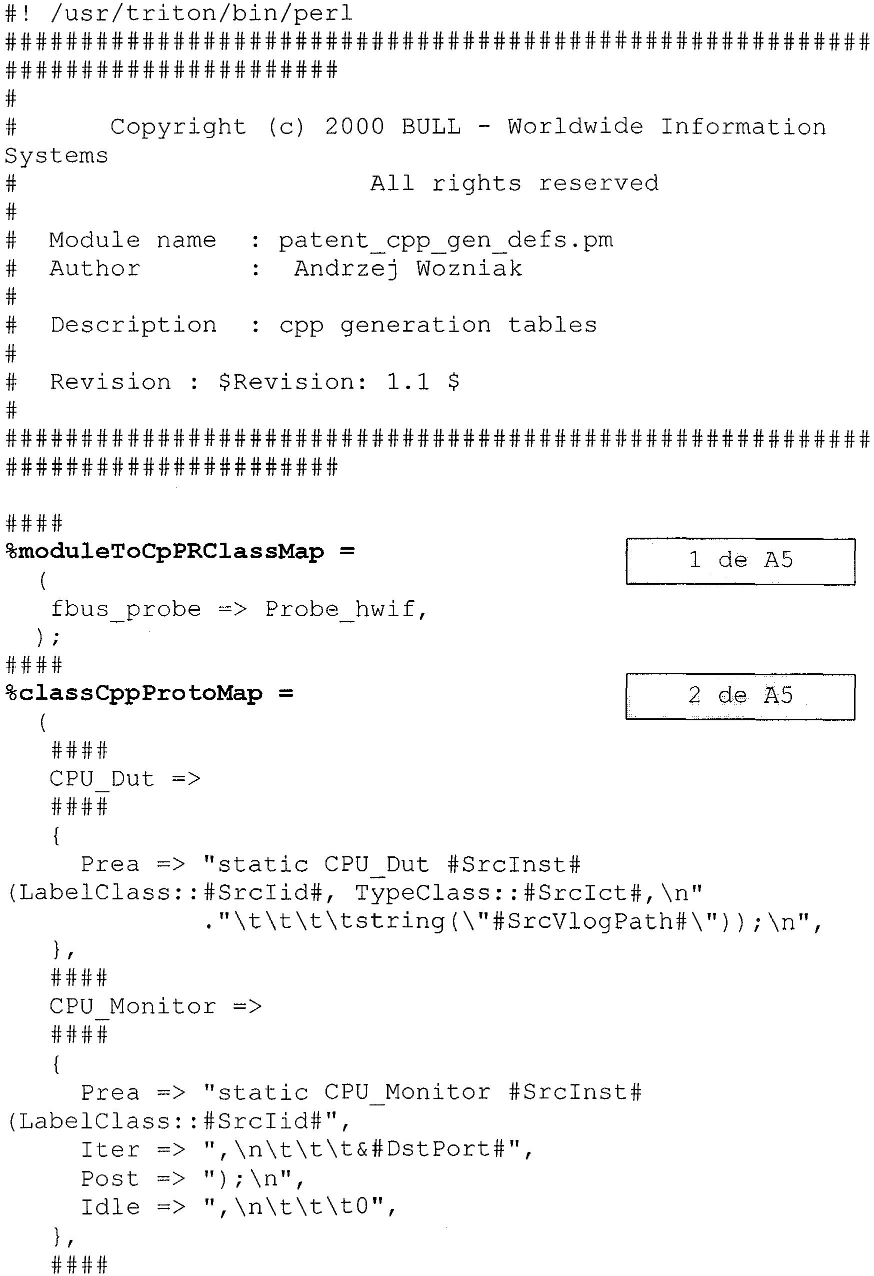

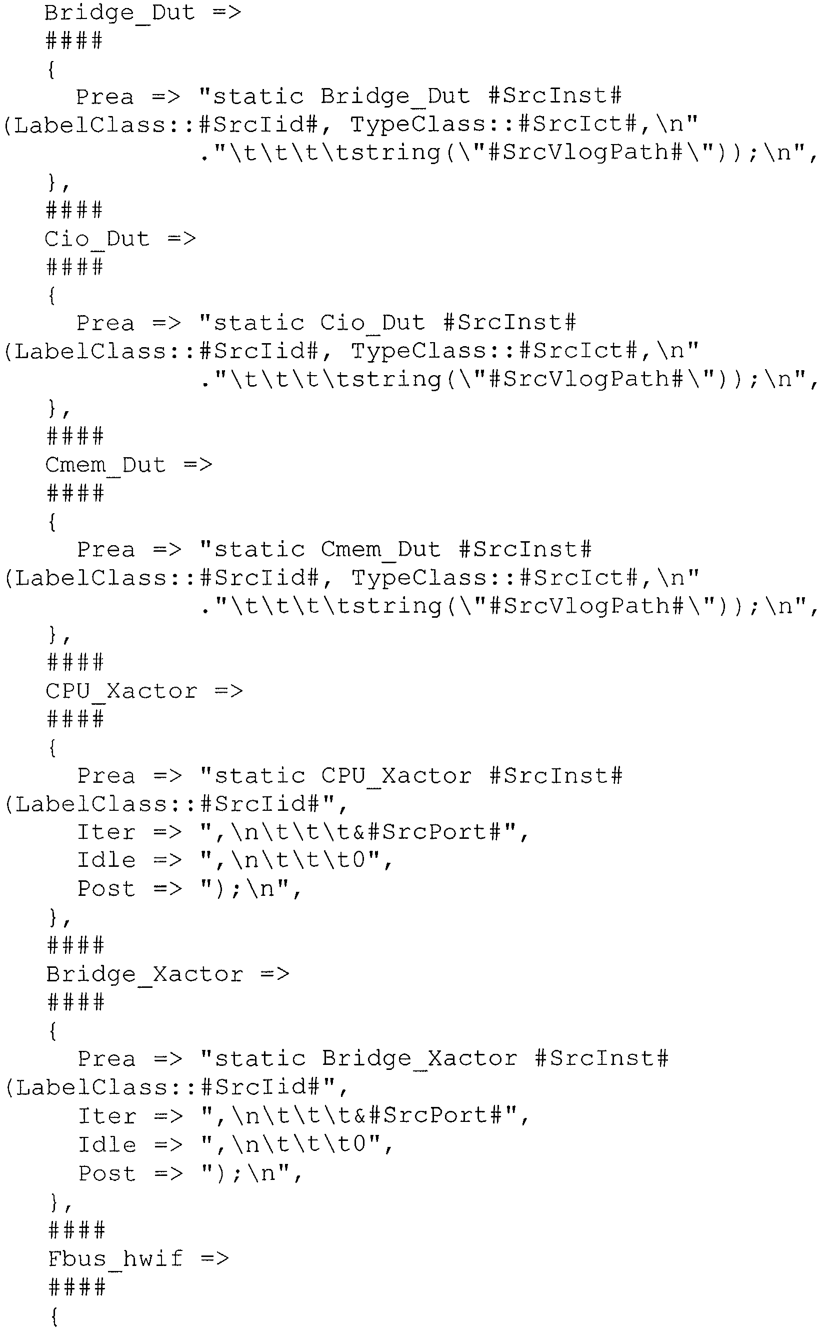

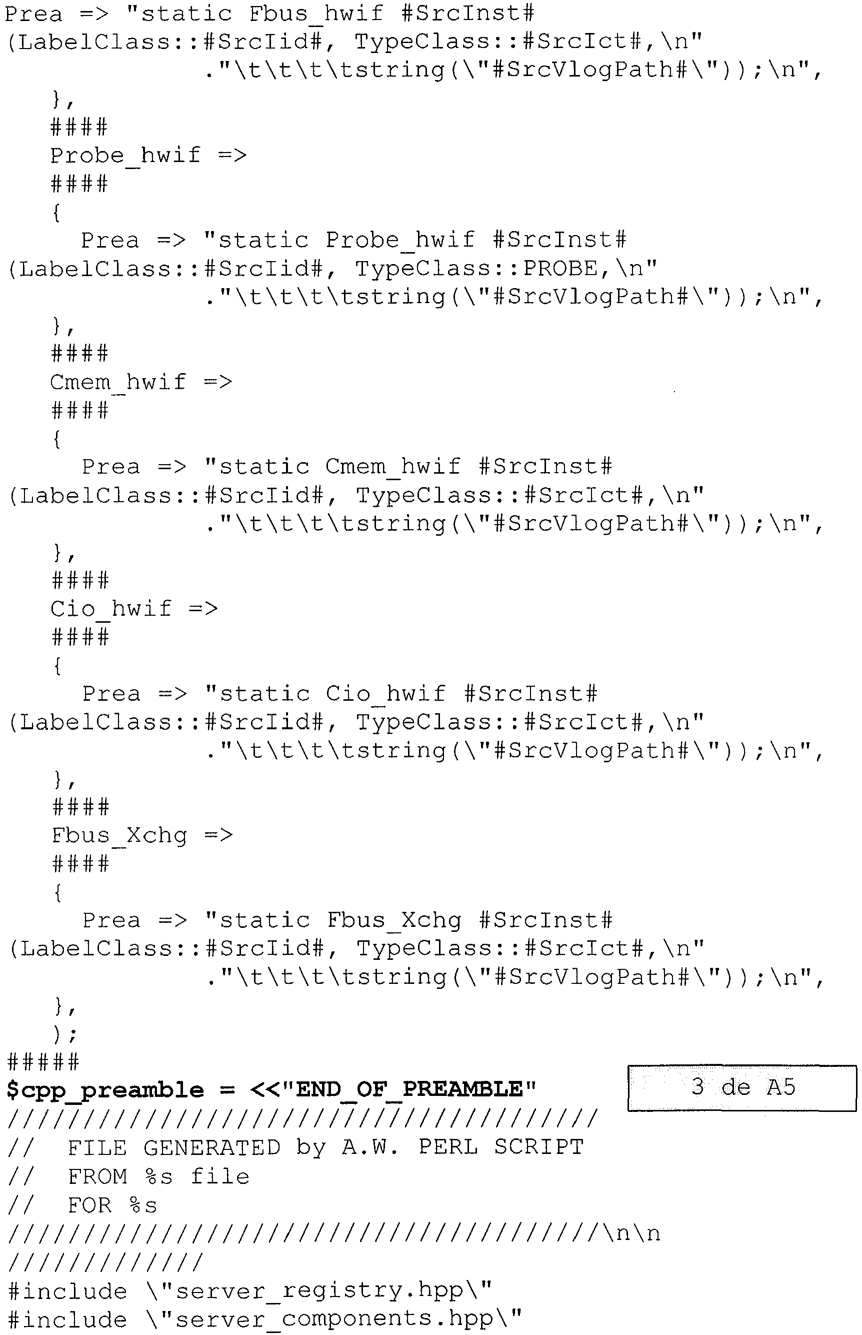

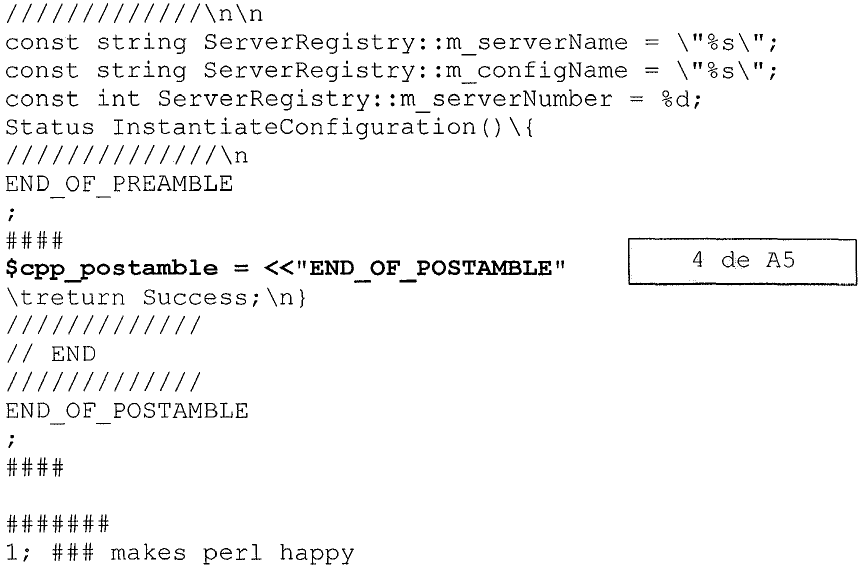

### ANNEXE

### A6 - Fichier Résultat Verilog

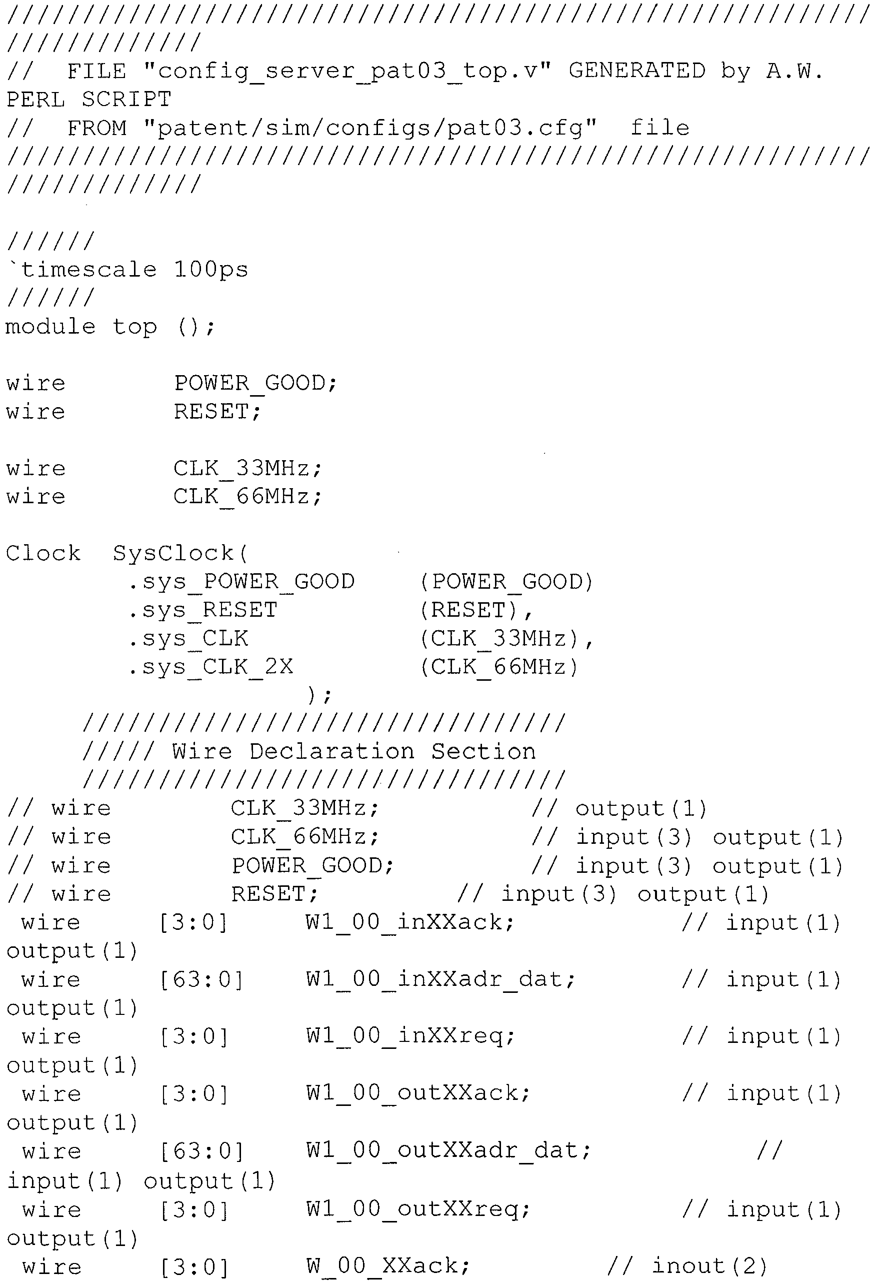

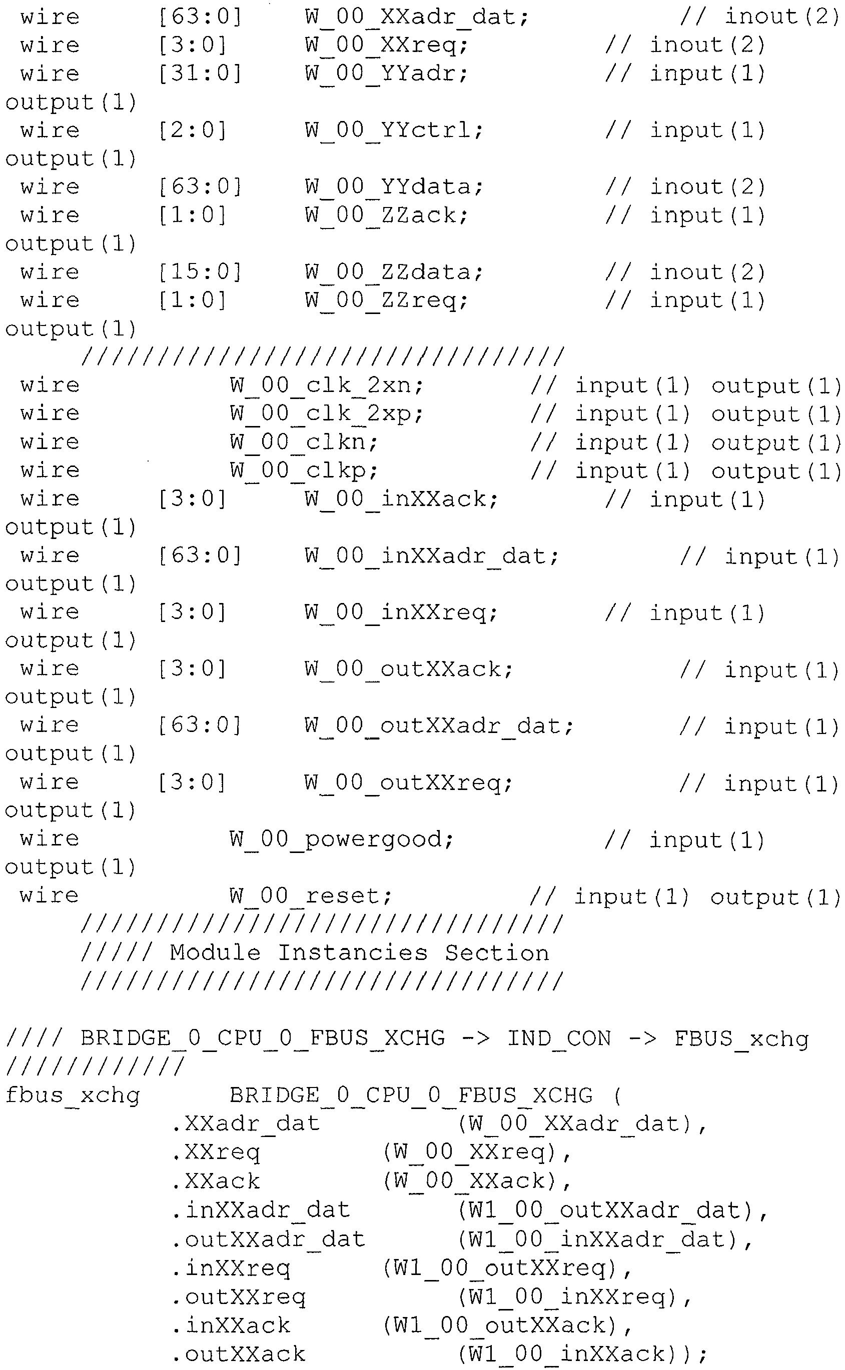

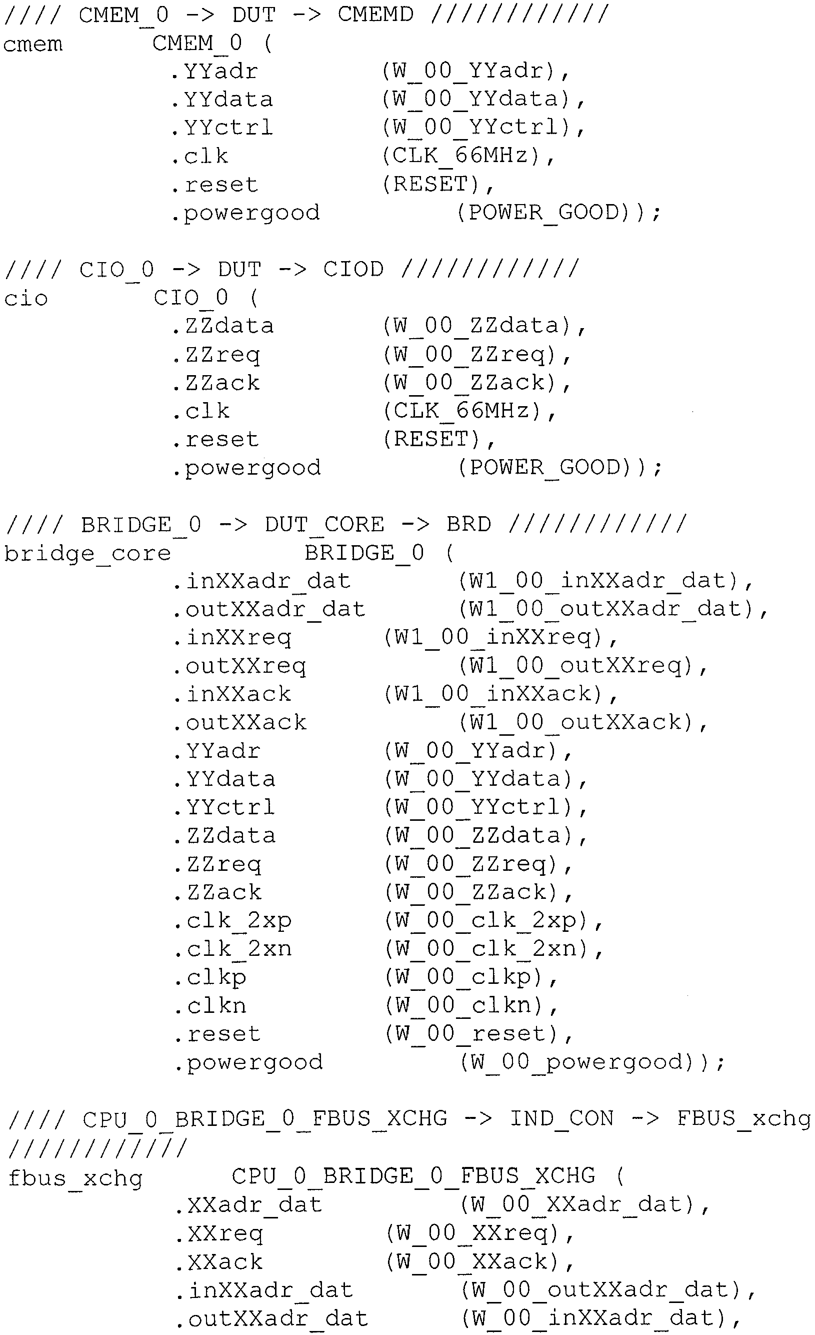

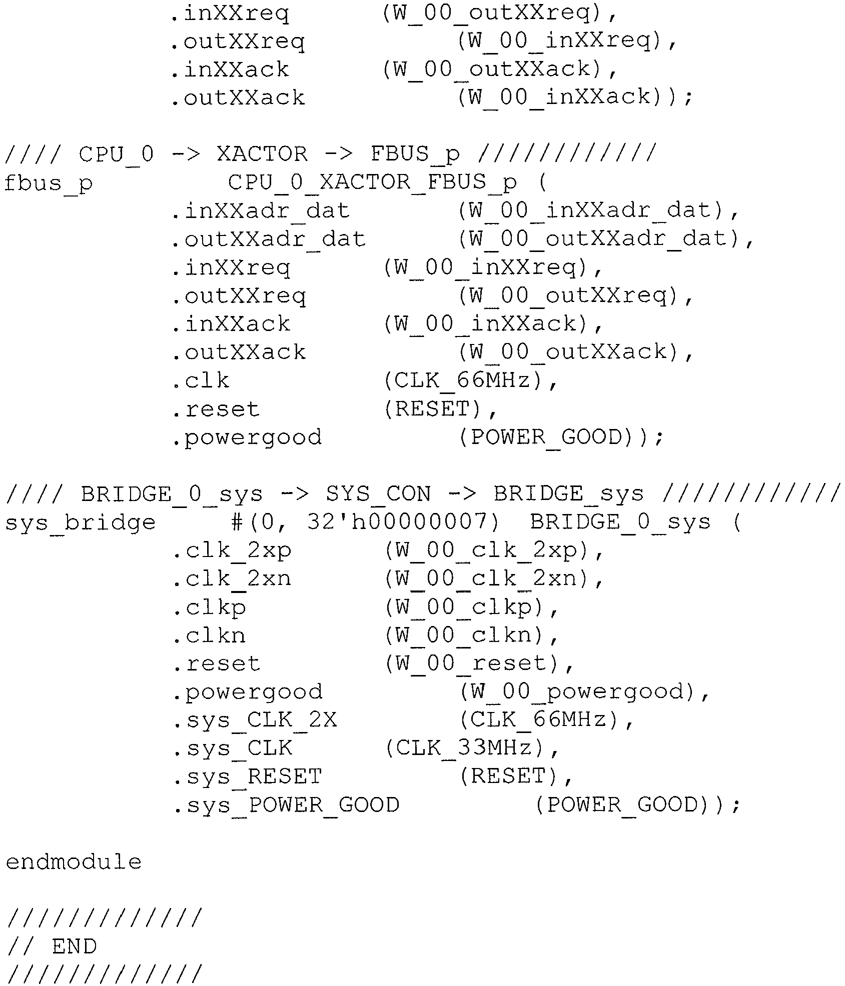

### ANNEXE

### A7 - Fichiers résultat C++

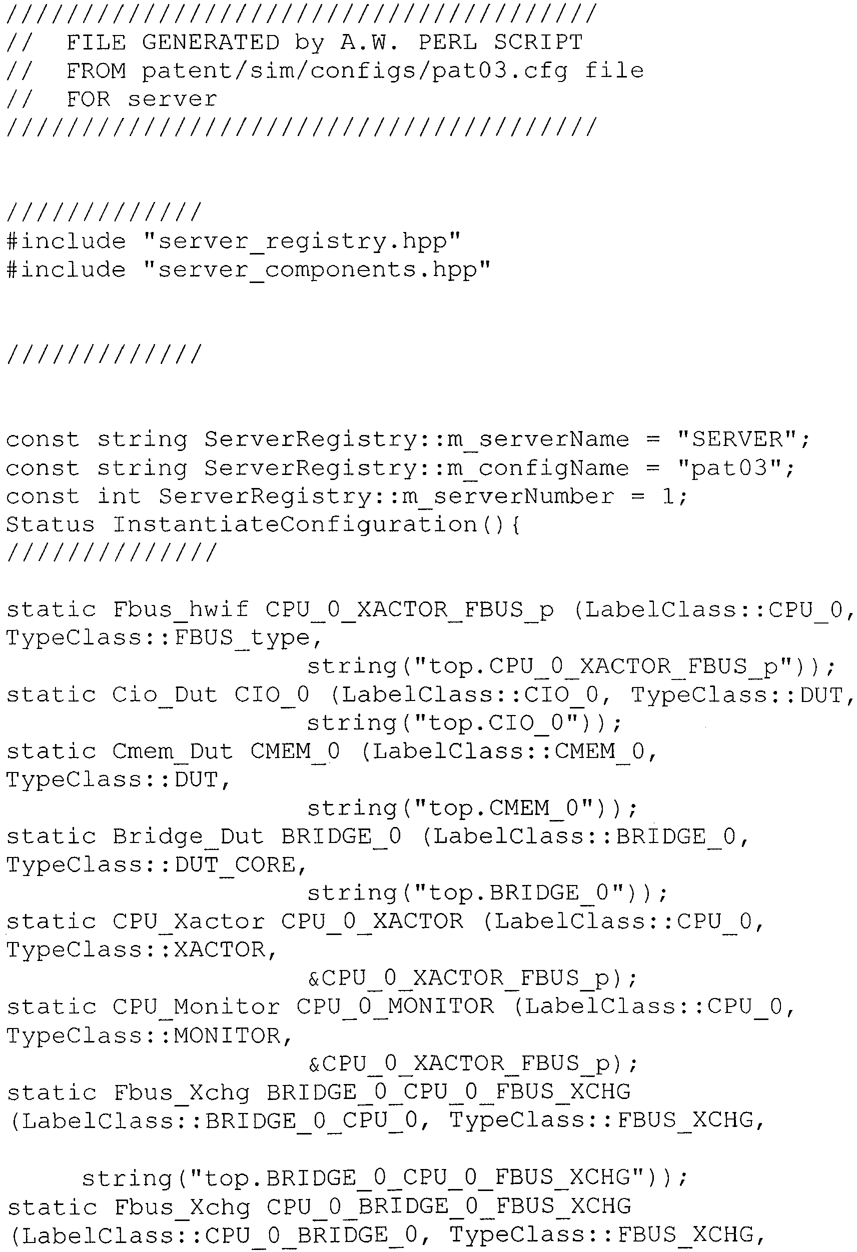

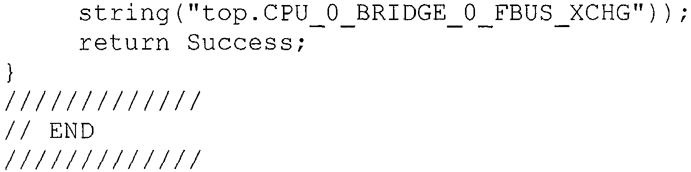

## Revendications

1. Procédé mis en oeuvre au moyen d'un système de traitement de données (40) associé à un programme d'ordinateur dit Configurateur, pour générer automatiquement des fichiers source d'un modèle global de simulation d'une architecture comprenant un système en développement, ledit modèle global de simulation comprenant, d'une part, des modèles logiciels de composants constitutifs du système en développement pouvant constituer, à l'aide du Configurateur, une machine ou une partie d'une machine et, d'autre part, des modèles logiciels de composants d'environnement de simulation, lesdits fichiers source permettant de tester et de vérifier le système en développement par simulation de son fonctionnement dans un environnement identique à, très proche de son utilisation finale, le procédé comportant l'établissement d'un fichier de définition de configuration (FCONF) de composants de l'architecture en langage de haut niveau, ces composants constituant des blocs fonctionnels déterminés de description des fonctionnalités de circuits intégrés ou de parties de circuits intégrés, et étant choisis par l'utilisateur-concepteur dans une bibliothèque de différents types de composants constitutifs et une bibliothèque de composants d'environnements pour constituer le modèle global de simulation de l'architecture spécifié par un fichier de description de l'architecture (FDARCH), l'établissement des fichiers source correspondant au fichier de définition de configuration (FCONF) comprenant les étapes suivantes:
- lecture du fichier de description de l'architecture (FDARCH) et mémorisation, dans une table de composants et de règles de connexion (TCRC), dans une table de règles de cohérence de connexions (TRCOH) et dans une table de formatage de fichiers source (TMFT), des informations relatives à l'ensemble des configurations possibles, chaque composant obtenant un nom identifiant, de façon non équivoque, sa position dans l'architecture, ainsi qu'un type parmi plusieurs types,
- instanciation des composants spécifiés dans le fichier de définition de configuration (FCONF) par l'utilisateur-concepteur au moyen d'une liste de composants présents désignés par leurs nom et type et comportant des paramètres ou faisant appel à des procédures, le fichier de définition de la configuration (FCONF) comprenant un fichier de sélection des composants et de leur type et des indications supplémentaires optionnelles concernant le type d'interface et le serveur concerné par la configuration à générer par le Configurateur, et mémorisation des informations correspondantes dans une table de connexion des instances (TCINST),
- connexion topologique des instances et mémorisation des informations correspondantes dans une table de connexion des instances (TCINST),
- connexion physique des signaux d'interface, au niveau de chaque instance des composants, par application d'expressions régulières, mémorisées dans la table de composants et de règles de connexion (TCRC) portant sur le nom des signaux constituant une table de câblage (TCAB), et
- utilisation de la table de connexion des instances (TCINST), de la table de câblage (TCAB) et de la table de formatage (TFMT) pour générer automatiquement des fichiers source de type HDL (MGHDL) et de type HLL (MGHLL) du modèle global de simulation, correspondant à la configuration spécifiée par le fichier de définition de configuration (FCONF).

2. Procédé selon la revendication 1, dans lequel le Configurateur transmet aux parties de type HLL de chaque composant des informations sur :
- le nom du composant,
- le type de l'instance,
- le chemin HDL, à savoir le nom hiérarchique du composant dans la description du modèle.

3. Procédé selon la revendication 1 ou 2, dans lequel le fichier de définition de la configuration (FCONF) comporte en outre un mot-clé (serveur<n>) indiquant le nom ou le numéro du serveur sur lequel se trouve instancié un composant dans le cas d'une utilisation du procédé sur un système multiserveur.

4. Procédé selon la revendication 3, dans lequel, dans le cas d'une utilisation sur un système multiserveur, le Configurateur exécute les étapes suivantes :
- découpage de la Configuration en plusieurs parties (de type HDL et de type HLL) en triant les composants de type HDL et les objets HLL selon leurs appartenances aux serveurs,
- génération des composants de type HDL périphériques servant à l'envoi et la réception des signaux entre les parties de la configuration,
- duplication des Blocs Globaux par le système Configurateur et instanciation des Blocs Globaux dupliqués sur chaque serveur,
- génération des parties de type HLL servant de support de communication entre les serveurs.

5. Procédé selon la revendication 3 ou 4, dans lequel la connexion automatique entre les composants par le système de traitement de données (40) comprend plusieurs phases :
- une phase topologique de haut niveau réalisant la sélection des composants et leurs positionnements respectifs,
- une phase de câblage réalisant la connexion effective entre les composants, cette phase générant comme résultat une table de câblage (TCAB) associant les signaux connectés ensemble, au nom unique du fil les connectant,
- une phase de génération des fichiers sources de type HDL et de type HLL.

6. Procédé selon la revendication 5, dans lequel la phase de câblage est effectuée par le système de traitement de données (40) selon les trois étapes suivantes :
a. les Blocs Globaux et les Blocs Système sont connectés en premier à tous les composants,
b. viennent ensuite les connexions des signaux entre les autres composants,
c. à la fin du câblage, une passe supplémentaire permet de connecter les signaux restant non connectés de chaque composant à des signaux prédéterminés pour assurer un état stable et déterminé, le système Configurateur générant alors des configurations partielles comprenant un sous-ensemble de l'architecture.

7. Procédé selon la revendication 6, dans lequel les signaux prédéterminés sont les signaux du Bloc Système correspondant au composant.

8. Procédé selon une des revendications 1 à 7, dans lequel le fichier de description de l'architecture (FDARCH) du modèle global comprend les modèles de simulation des Blocs globaux et des Blocs Système, ces deux types de composants étant connectés entre eux et gérant des signaux d'environnement.

9. Procédé selon la revendication 8, dans lequel les Blocs Système sont connectés aux autres composants et leur fournissent des signaux système qui leur sont spécifiques.

10. Procédé selon la revendication 9, dans lequel le système de traitement de données (40) effectue un contrôle de conformité des connexions en comparant la table de connexion des instances (TCINST) réelles entre blocs avec la table de règles de cohérence de connexions (TRCOH).

11. Procédé selon la revendication 10, dans lequel le système de traitement de données (40) compare les connexions physiques entre les composants à la table de règles de cohérence de connexions (TRCOH), pour détecter des incompatibilités entre extrémités de connexions entre les composants, et, en pareil cas, il spécifie, et ajoute, dans la table de connexion des instances (TCINST), un composant adaptateur (Bloc Intermédiaire) (101) inséré dans la connexion considérée.

12. Procédé selon la revendication 11, dans lequel le fichier de définition de configuration (FCONF) comprend des informations, spécifiées par un attribut, concernant l'utilisation de composants adaptateurs ou Blocs intermédiaires avec les instances des Composants actifs, dont les connexions sont comparées à la table de connexion des instances (TCINST), pour détecter des incompatibilités entre extrémités de connexions entre les composants, et, en pareil cas, il spécifie, et ajoute, dans la table de connexion des instances (TCINST), un autre composant adaptateur ou Bloc intermédiaire (102) inséré dans la connexion considérée.

13. Procédé selon la revendication 12, dans lequel le système de traitement de données (40) sélectionne certaines des connexions entre composants de la table de règles de cohérence de connexions (TRCOH) et spécifie, et ajoute, dans la table de connexion des instances (TCINST), des connexions supplémentaires constituant des dérivations aboutissant à des modèles supplémentaires respectifs, représentant des outils de surveillance ou sondes des connexions.

14. Procédé selon l'une des revendications 1 à 13, dans lequel, dans la phase de génération des fichiers sources, le système Configurateur génère les fichiers source en langage HDL (MGHDL) et en langage HLL (MGHLL) en s'appuyant sur le contenu de la table de composants et de règles de connexion (TCRC), la table de règles de cohérence de connexions (TRCOH), la table de formatage des fichiers source (TMFT), la table de connexion des instances (TCINST) et la table de câblage (TCAB).

15. Procédé selon la revendication 14, dans lequel le système de traitement de données (40) effectue un traitement par le système Configurateur, pour chaque variante de configuration, pour obtenir plusieurs modèles de simulation correspondant à la même spécification fonctionnelle, mais écrits en une description comportant différents mélanges des langages de niveaux différents (HDL, HLL).

16. Procédé selon l'une des revendications 1 à 15, dans lequel le système de traitement de données (40) établit la spécification fonctionnelle du modèle global de simulations dans un format informatique compatible avec un langage de programmation de haut niveau (HLL) et en format compatible avec un langage de description du matériel (HDL).

17. Procédé selon une des revendications 15 ou 16, dans lequel le fichier de définition de configuration (FCONF) comprend, pour chaque composant, au moins une partie en langage de type HDL, ladite partie en langage de type HDL fournissant une interface vers d'autres modèles.

18. Procédé selon la revendication 17, dans lequel les modèles comprenant une partie en langage de type HLL comprennent des adaptateurs d'interface.

19. Procédé selon la revendication 18, dans lequel le système Configurateur choisit chaque modèle d'adaptateurs d'interface en fonction de la table de règles de cohérence de connexions (TRCOH).

20. Procédé selon la revendication 19, dans lequel les connexions des signaux physiques sont spécifiés par des "Ports", chaque port étant une sélection arbitraire des signaux de l'interface de type HDL d'un composant à l'aide des expressions régulières portant sur les noms de ces signaux, et étant constitué de paires expression régulière / expression de substitution, ces expression étant appliquées successivement au nom de chaque signal de l'interface de type HDL, et, si la substitution finale est identique pour deux signaux, ces derniers sont connectés entre eux, la connexion étant mémorisée dans la table de câblage (TCAB).

21. Procédé selon la revendication 20, dans lequel chaque adaptateur d'interface étant partagé entre plusieurs modèles connectés sur le même port, un seul de ces modèles émet des signaux sur ledit port.

22. Système de traitement de données (40) comprenant un programme d'ordinateur dit Configurateur pour générer automatiquement des fichiers source d'un modèle global de simulation d'un système en développement ayant une configuration de blocs fonctionnels déterminés mutuellement reliés par des connexions d'interfonctionnement, ledit modèle global de simulation comprenant, d'une part, des modèles logiciels de composants constitutifs du système en développement pouvant constituer, à l'aide du Configurateur, une machine ou une partie d'une machine et, d'autre part, des modèles logiciels de composants d'environnement de simulation, lesdits fichiers source permettant de tester et de vérifier le système en développement par simulation de son fonctionnement dans un environnement identique à, très proche de son utilisation finale, dans lequel le Configurateur (PROGCONF) comprend des moyens pour réaliser une simulation du câblage par l'application d'expressions régulières mémorisées, en utilisant un fichier de définition de configuration (FCONF) en langage de haut niveau, une table de composants et de règles de connexion (TCRC) décrivant les propriétés (type, Interfaces de type HDL, ports, constructeurs d'objets de classes HLL, etc...) des composants logiciels de simulation du circuit, une table de règles de cohérence de connexions (TRCOH) en langage de haut niveau (HLL), des moyens d'instancier les éléments résultants du fichier de définition de configuration (FCONF), un générateur du code HLL qui combine les paramètres des composants avec les règles de connexion, ledit système de traitement de données mettant en oeuvre les étapes du procédé selon la revendication 1.

23. Système selon la revendication 22, **caractérisé en ce qu'**il existe au moins cinq types de composants : les Composants actifs, les Blocs de Monitoring et Vérification, les Blocs intermédiaires, les Blocs Système et les Blocs Globaux.

24. Système selon la revendication 23, **caractérisé en ce que** le système est agencé pour effectuer un contrôle de conformité des connexions en comparant la table de connexion des instances (TCINST) avec une table de règles de cohérence des connexions (TRCOH) physiques entre les modèles choisis des blocs constituant le modèle global.

25. Système selon la revendication 24, **caractérisé en ce qu'**il est agencé pour comparer la table de connexion des instances (TCINST) réelles entre blocs à la table de cohérence des connexions (TRCOH), pour détecter des incompatibilités entre extrémités de connexions entre blocs, et, en pareil cas, pour spécifier, et ajouter, dans la table de règles de cohérence des connexions (TRCOH), un bloc fonctionnel adaptateur ou Bloc Intermédiaire (101) inséré dans la connexion considérée.

26. Système selon une des revendications 22 à 25, **caractérisé en ce que** la table de composants et de règles de connexion (TCRC), comprenant les propriétés des composants, contient des paramètres globaux communs à tous les types de composants et se présente sous forme d'une table répartie suivant une ou plusieurs tables, associatives ou non, dont les entrées sont des noms désignant l'ensemble des modèles possibles pour un même composant.

27. Système selon la revendication 26, **caractérisé en ce que** les tables associatives peuvent contenir la description, soit sous forme de suites de paramètres, ou bien sous forme de références à des procédures qui génèrent les valeurs requises, les entrées de ces tables associatives étant des noms désignant l'ensemble des modèles possibles pour un même composant et formant une chaîne de caractères contenant des identificateurs spéciaux prédéterminés, substitués par les valeurs calculées par le système Configurateur.

28. Système selon la revendication 27, **caractérisé en ce qu'**au moins trois sélecteurs indiquent l'instance à prendre en compte, cette dernière étant transmise comme paramètre à un constructeur d'un objet HLL :
- un premier sélecteur indique l'instance ou "item" courante,
- un deuxième sélecteur précise l'instance connectée à l'autre extrémité du port,
- un troisième sélecteur indique l'instance composée correspondant au Composant actif contenant le port d'observation.

29. Système selon l'une des revendications 22 à 28, **caractérisé en ce que** le système Configurateur utilise une ou plusieurs tables de règles de cohérence de connexions (TRCOH), qui représentent les règles d'interconnexion entre les composants et d'insertion des composants intermédiaires, une ou plusieurs tables de composants et de règles de connexions (TCRC), qui représentent les règles de connexion niveau système et les règles de génération de connexions entre les signaux, et une ou plusieurs tables de formatage de fichiers source (TFMT), qui représentent les règles de génération des instances des objets de type HLL.

30. Système selon l'une des revendications 22 à 29, **caractérisé en ce que** le système Configurateur utilise :
- une classe de base en HLL permettant d'identifier de façon univoque chaque objet instancié et d'interroger la configuration,
- des moyens de génération et d'instanciation automatique des Blocs Système,
- des moyens des tableaux associant les signaux connectés ensemble au nom unique du fil les connectant,
- des moyens d'utiliser un tableau de formatage pour générer les fichiers sources en HDL et HLL.

31. Système selon l'une des revendications 22 à 30, **caractérisé en ce que** l'opérateur spécifie fonctionnellement, dans la plus large mesure possible, la configuration dans le langage de plus haut niveau et il complète la spécification fonctionnelle par les composants en langage de plus bas niveau.

32. Système selon une des revendications 22 à 31, **caractérisé en ce que** les entrées suivantes du hachage définissent le Type du composant et, à chaque Type de Composant, correspond un hachage composé à son tour des entrées suivantes :
- une première entrée *RegModule* - contient le nom du module HDL du composant et le nom du fichier source correspondant,
- une deuxième entrée *Connect* - est la définition de la méthode de sélection des signaux faisant partie d'un Port, cette description étant composée d'une suite d'entrées indexées par le nom du Port ; à chaque nom de Port, le configurateur associe un tableau d'expressions régulières et un pointeur sur une procédure de connexion des signaux qui gère l'application de ces expressions aux noms des signaux de l'interface du composant.

33. Système selon la revendication 32, **caractérisé en ce que** la structure générique des Composants actifs comprend un Bloc contenant la description HDL et un Bloc en HLL, fournissant les chemins d'accès aux ressources HDL et, le cas échéant, une description du bloc en HLL, l'ensemble des signaux du bloc HDL constituant l'interface du Bloc englobant, formée, d'une part, de Ports, qui sont des sélections logiques arbitraires des signaux d'une interface et, d'autre part, d'adaptateurs d'interface qui sont les parties logicielles assurant, sur chaque Port, la communication bi-directionnelle entre les parties en HLL et celles en HDL, les adaptateurs d'interface étant choisis par le système Configurateur.

34. Système selon la revendication 33, **caractérisé en ce que** les Ports sont spécifiés sous forme d'expressions régulières, qui servent à la fois à sélectionner les sous-ensembles de signaux à connecter et à définir les règles de connexions.

35. Système selon une des revendications 22 à 34, **caractérisé en ce que** le système Configurateur génère des Composants dits de Transfert qui sont insérés de chaque côté de la coupure sur les serveurs, ces composants étant simplement des fils pour les entrées et des registres pour les sorties.

## Patentansprüche

1. Verfahren, das mittels eines Datenverarbeitungssystems (40) umgesetzt wird, das einem Computerprogramm, bezeichnet als Konfigurator, zugeordnet ist, um automatisch Quelldateien eines globalen Simulationsmodells einer Architektur zu generieren, umfassend ein Entwicklungssystem, wobei das genannte globale Simulationsmodell einerseits Softwaremodelle von konstitutiven Komponenten des Entwicklungssystems umfasst, die mithilfe des Konfigurators eine Maschine oder einen Teil einer Maschine bilden können, und andererseits Software-Modelle von Umweltsimulations-Komponenten, wobei die genannten Quelldateien das Testen und Überprüfen des Systems in der Entwicklung per Simulation seiner Funktionsweise in einer Umgebung zu testen und zu überprüfen, die ihrer finalen Nutzung identisch bis sehr ähnlich ist, wobei das Verfahren das Anlegen einer Datei zur Konfigurationsdefinition (FCONF) von Komponenten der Architektur in einer Sprache hohen Niveaus umfasst, wobei diese Komponenten funktionale, bestimmte Blöcke zur Beschreibung der Funktionalitäten von integrierten Schaltkreisen oder Teilen von integrierten Schaltkreisen bilden und vom Nutzer und Entwickler in einer Bibliothek aus unterschiedlichen Typen von konstitutiven Komponenten und einer Bibliothek aus Umgebungskomponenten ausgewählt sind, um das globale Simulationsmodell der Architektur zu bilden, die durch eine Beschreibungsdatei der Architektur (FDARCH) spezifiziert ist, wobei das Anlegen der Quelldateien der Datei zur Konfigurationsdefinition (FCONF) entspricht, die die folgenden Schritte umfassen:
- Lesen der Beschreibungsdatei der Architektur (FDARCH) und Abspeicherung in einer Tabelle der Komponenten und Verbindungsregeln (TCRC) in einer Tabelle der Kohärenzregeln der Verbindungen (TRCOH) und in einer Formatierungstabelle der Quelldateien (TMFT), der Informationen bezüglich aller möglichen Konfigurationen, wobei jede Komponente einen unverwechselbaren Benutzernamen, seine Position in der Architektur sowie einen Typ aus mehreren Typen erhält;
- Instanzierung der Komponenten, die in der Definitionsdatei der Konfiguration (FCONF) vom Nutzer und Entwickler mittels einer Liste von vorhandenen Komponenten spezifiziert sind, welche von ihrem Namen und Typ bezeichnet werden und Parameter enthalten oder auf Verfahren zurückgreifen, wobei die Definitionsdatei der Konfiguration (FCONF) eine Auswahldatei der Komponenten und ihren Typ und zusätzliche optionale Angaben bezüglich des Schnittstellentyps und des von der vom Konfigurator zu generierenden Konfiguration betroffenen Servers und Speicherung der entsprechenden Informationen in einer Verbindungstabelle der Instanzen (TCINST) umfasst,
- Topologische Verbindung der Instanzen und Abspeicherung der entsprechenden Informationen in einer Verbindungstabelle der Instanzen (TCINST),
- Physische Verbindung der Schnittstellensignale an jeder Instanz der Komponenten per Anwendung von regelmäßigen Expressionen, die in der Tabelle der Komponenten und der Verbindungsregeln (TCRC) abgespeichert sind und sich auf den Namen der Signale beziehen, die eine Verkabelungstabelle (TCAB) bilden, und
- Verwendung der Verbindungstabelle der Instanzen (TCINST), der Verkabelungstabelle (TCAB) und der Formatierungstabelle (TFMT) zum automatischen Generieren der Quelldateien vom Typ HDL (MGHDL) und vom Typ HLL (MGHLL) des globalen Simulationsmodells, das der Konfiguration entspricht, die von der Datei zur Konfigurationsdefinition (FCONF) spezifiziert ist.

2. Verfahren gemäß Anspruch 1, bei dem der Konfigurator auf die Teile vom Typ HLL jeder Komponente Informationen überträgt über:
- den Namen der Komponente,
- den Typ der Instanz,
- den Pfad HDL, und zwar den hierarchischen Namen der Komponente in der Beschreibung des Modells.

3. Verfahren gemäß Anspruch 1 oder 2, bei dem die Datei zur Konfigurationsdefinition (FCONF) darüber hinaus ein Schlüsselwort (Server<n>) umfasst, das den Namen oder die Nummer des Servers angibt, auf dem sich eine Komponente in dem Fall einer Verwendung des Verfahrens auf einem Multiserversystem instanziert befindet.

4. Verfahren gemäß Anspruch 3, bei dem in dem Fall einer Verwendung auf einem Multiserversystem der Konfigurator die folgenden Schritte ausführt:
- Zerschneiden des Konfigurators in mehrere Teile (von Typ HDL und vom Typ HLL) durch Sortieren der Komponenten vom Typ HDL und der Objekte HLL gemäß ihren Zugehörigkeiten zu den Servern,
- Generieren der peripherischen Komponenten vom Typ HDL, die für den Versand und den Empfang der Signale zwischen den Teilen der Konfiguration dienen,
- Duplizieren der Globalen Blöcke durch das Konfiguratorsystem und Instanzierung der auf jedem Server duplizierten Globalen Blöcke,
- Generieren der Teile vom Typ HLL, die als Kommunikationsträger zwischen den Servern dienen.

5. Verfahren gemäß Anspruch 3 oder 4, bei dem die automatische Verbindung zwischen den Komponenten durch das Datenverarbeitungssystem (40) mehrere Phasen umfasst:
- eine topologische Phase hohen Niveaus, die die Auswahl der Komponenten und ihrer jeweiligen Positionierungen realisiert,
- eine Verkabelungsphase, die die effektive Verbindung zwischen den Komponenten realisiert, wobei diese Phase als Ergebnis eine Verkabelungstabelle (TCAB) generiert, die die miteinander verbundenen Signale dem einzigartigen Namen des sie verbindenden Drahtes zuordnet,
- eine Generierungsphase der Quelldateien vom Typ HDL und vom Typ HLL.

6. Verfahren gemäß Anspruch 5, bei dem die Verkabelungsphase durch das Datenverarbeitungssystem (40) gemäß den folgenden drei Schritten ausgeführt ist:
a. die Globalen Blöcke und die Systemblöcke sind als Erstes mit allen Komponenten verbunden,
b. anschließend folgen die Verbindungen der Signale zwischen den anderen Komponenten,
c. bei Abschluss der Verkabelung lässt ein zusätzlicher Durchgang die Verbindung der verbleibenden, nicht verbundenen Signale jeder Komponente mit vorbestimmten Signalen zur Gewährleistung eines stabilen und bestimmten Zustandes zu, wobei das Konfiguratorsystem dann teilweise Konfigurationen generiert, die eine Teilgruppe der Architektur umfassen.

7. Verfahren gemäß Anspruch 6, bei dem die vorbestimmten Signale Signale des der Komponente entsprechenden Blocksystems sind.

8. Verfahren gemäß einem der Ansprüche 1 bis 7, bei dem die Beschreibungsdatei der Architektur (FDARCH) des globalen Modells die Simulationsmodelle der globalen Blöcke und der Systemblöcke umfasst, wobei diese zwei Komponententypen miteinander verbunden sind und Umgebungssignale verwalten.

9. Verfahren gemäß Anspruch 8, bei dem die Systemblöcke mit den anderen Komponenten verbunden sind und ihnen Systemsignale liefern, die für sie spezifisch sind.

10. Verfahren gemäß Anspruch 9, bei dem das Datenverarbeitungssystem (40) eine Konformitätskontrolle der Verbindungen per Vergleich der Verbindungstabelle der realen Instanzen (TCINST) zwischen Blöcken mit der Tabelle der Kohärenzregeln der Verbindungen (TRCOH) vergleicht.

11. Verfahren gemäß Anspruch 10, bei dem das Datenverarbeitungssystem (40) die physischen Verbindungen zwischen den Komponenten mit der Tabelle der Kohärenzregeln der Verbindungen (TRCOH) vergleicht um Inkompatibilitäten zwischen Verbindungsenden zwischen den Komponenten zu detektieren und in einem derartigen Fall spezifiziert es eine Anpassungskomponente (Intermediärer Block) (101), die in die betrachtete Verbindung eingefügt wird, und fügt sie in die Verbindungstabelle der Instanzen (TCINST) hinzu.

12. Verfahren gemäß Anspruch 11, bei dem die Datei zur Konfigurationsdefinition (FCONF) Informationen, die durch ein Attribut spezifiziert sind, bezüglich der Verwendung von Anpassungskomponenten oder Intermediären Blöcken mit den Instanzen der aktiven Komponenten, deren Verbindungen mit der Verbindungstabelle der Instanzen (TCIST) verglichen werden, um Inkompatibilitäten zwischen Verbindungsenden zwischen den Komponenten zu detektieren, umfasst, und in einem derartigen Fall spezifiziert sie eine andere Anpassungskomponente oder einen intermediären Block (102), der in die betrachtete Verbindung eingefügt ist, und fügt diese in die Verbindungstabelle der Instanzen (TCINST) hinzu.

13. Verfahren gemäß Anspruch 12, bei dem das Datenverarbeitungssystem (40) einige der Verbindungen zwischen Komponenten der Tabelle der Kohärenzregeln der Verbindungen (TRCOH) auswählt und zusätzliche Verbindunggen spezifiziert und in die Verbindungstabelle der Instanzen (TCINST) einfügt, die Ableitungen bilden, welche zu jeweiligen zusätzlichen Modellen führen, die Überwachungs-Tools oder Sonden der Verbindungen darstellen.

14. Verfahren gemäß einem der Ansprüche 1 bis 13, bei dem das Konfiguratorsystem in der Generierungsphase der Quelldateien die Quelldateien in der Sprache HDL (MGHDL) und in der Sprache HLL (MGHLL) generiert, es sich auf den Inhalt der Tabelle der Komponenten und Verbindungsregeln (TCRC), die Tabelle der Kohärenzregeln der Verbindungen (TRCOH), die Formatierungstabelle der Quelldateien (TMF), die Verbindungstabelle der Instanzen (TCINST) und die Verkabelungstabelle (TCAB) stützt.

15. Verfahren gemäß Anspruch 4, bei dem das Datenverarbeitungssystem (40) für jede Konfigurationsvariante eine Verarbeitung durch das Konfiguratorsystem durchführt, um mehrere Simulationsmodelle zu erhalten, die derselben funktionalen Spezifikation entsprechen, jedoch in einer Beschreibung geschrieben sind, die unterschiedliche Mischungen der Sprachen unterschiedlicher Niveaus (HDL, HLL) umfassen.

16. Verfahren gemäß einem der Ansprüche 1 bis 15, bei dem das Datenverarbeitungssystem (40) die funktionale Spezifikation des globalen Simulationsmodells in einem Informatikformat, das mit einer Programmiersprache hohen Niveaus (HLL) kompatibel ist, und in einem Format, das mit einer Beschreibungssprache der Hardware (HDL) kompatibel ist, erstellt.

17. Verfahren gemäß einem der Ansprüche 1 bis 16, bei dem die Datei zur Konfigurationsdefinition (FCONF) für jede Komponente wenigstens einen Teil in einer Sprache vom Typ HDL umfasst, wobei der genannte Teil in der Sprache vom Typ HDL eine Schnittstelle zu anderen Modellen liefert.

18. Verfahren gemäß Anspruch 17, bei dem die Modelle, die einen Teil in einer Sprache vom Typ HLL umfassen, Schnittstellenanpassungen umfassen.

19. Verfahren gemäß Anspruch 18, bei dem das Konfigurationssystem jedes Schnittstellenanpassungsmodell in Abhängigkeit von der Tabelle der Kohärenzregeln der Verbindungen (TROCH) wählt.

20. Verfahren gemäß Anspruch 19, bei dem die Verbindungen der physischen Signale von den "Ports" spezifiziert werden, wobei jeder Port eine willkürliche Auswahl der Signale der Schnittstelle vom Typ HDL einer Komponente mithilfe der regelmäßigen Expressionen ist, die sich auf die Namen dieser Signale beziehen, und aus Paaren regelmäßiger Expression / Substitutionsexpression gebildet ist, wobei diese Expressionen sukzessive im Namen jedes Signals der Schnittstelle vom Typ HDL angewendet sind und wenn die finale Substitution bei zwei Signalen identisch ist, sind letztere miteinander verbunden, wobei die Verbindung in der Verkabelungstabelle (TCAB) abgespeichert ist.

21. Verfahren gemäß Anspruch 20, bei dem jede Schnittstellenanpassung zwischen mehreren, mit demselben Port verbundenen Modellen geteilt ist, wobei ein einziges dieser Modelle Signale an dem genannten Port ausgibt.

22. Datenverarbeitungssystem (40), umfassend ein als Konfigurator bezeichnetes Computerprogramm zum automatischen Generieren der Quelldateien eines globalen Simulationsmodells eines Entwicklungssystems, das eine Konfiguration von funktionalen, bestimmten Blöcken hat, die gegenseitig durch Interworking-Verbindungen verbunden sind, wobei das genannte globale Simulationsmodell einerseits Softwaremodelle aus konstitutiven Komponenten des Systems in der Entwicklung, die mithilfe des Konfigurators eine Maschine oder einen Teil einer Maschine bilden können, und andererseits Softwaremodelle aus Komponenten der Umgebungssimulation umfasst, wobei die genannten Quelldateien das Testen und das Überprüfen des Systems in der Entwicklung per Simulation seiner Funktion in einer Umgebung zulassen, die mit ihrer finalen Verwendung identisch oder ihr sehr ähnlich ist, bei dem der Konfigurator (PROGCONF) Mittel zur Realisierung einer Simulation der Verkabelung durch die Anwendung regelmäßiger abgespeicherter Expressionen realisiert, indem er eine Datei zur Konfigurationsdefinition (FCONF) in einer Sprache hohen Niveaus verwendet, wobei eine Tabelle aus Komponenten und Verbindungsregeln (TCRC) die Eigenschaften (Typ, Schnittstellen vom Typ HDL, Ports, Objekthersteller der Klassen HLL, usw.) der Simulations-Softwarekomponenten des Schaltkreises, eine Tabelle der Kohärenzregeln der Verbindungen (TRCOH) in einer Sprache hohen Niveaus (HL), Mittel zum Instanzieren der Elemente, die aus der Datei zur Konfigurationsdefinition (FCONF) resultieren, einen Generator des Codes HLL beschreibt, der die Parameter der Komponenten mit den Verbindungsregeln kombiniert, wobei das genannte Datenverarbeitungssystem die Schritte des Verfahrens gemäß Anspruch 1 umsetzt.

23. System gemäß Anspruch 22, **dadurch gekennzeichnet, dass** es wenigstens fünf Komponententypen gibt: die aktiven Komponenten, die Monitoring- und Überprüfungsblöcke, die intermediären Blöcke, die Systemblöcke und die Globalen Blöcke.

24. System gemäß Anspruch 23, **dadurch gekennzeichnet, dass** das System angeordnet ist, um eine Konformitätskontrolle der Verbindungen per Vergleich der Verbindungstabelle der Instanzen (TCINST) mit einer Tabelle der Kohärenzregeln der physischen Verbindungen (TRCOH) zwischen den gewählten Modellen auszuführen, die von den das globale Modell bildenden Blöcken gewählt sind.

25. System gemäß Anspruch 24, **dadurch gekennzeichnet, dass** es angeordnet ist, um die Verbindungstabelle der realen Instanzen (TCINST) zwischen Blöcken mit der Tabelle der Kohärenz der Verbindungen (TRCOH) zu vergleichen, um Inkompatibilitäten zwischen Verbindungsenden zwischen Blöcken zu detektieren und in einem derartigen Fall einen funktionalen Anpassungsblock oder Intermediären Block (101), der in die betrachtete Verbindung eingefügt ist, zu spezifizieren und in die Tabelle der Kohärenzregeln der Verbindungen (TRCOH) hinzuzufügen.

26. System gemäß einem der Ansprüche 22 bis 25, **dadurch gekennzeichnet, dass** die Tabelle der Komponenten und der Verbindungsregeln (TCRC), die die Eigenschaften der Komponenten umfasst, gemeinsame globale Parameter für alle Komponententypen enthält und sich in Form einer Tabelle darstellt, die gemäß einer oder mehreren assoziativen oder nicht assoziativen Tabellen verteilt ist, deren Eintragungen Namen sind, die die Gruppe der für eine und dieselbe Komponente möglichen Modelle bezeichnet.

27. System gemäß Anspruch 26, **dadurch gekennzeichnet, dass** die assoziativen Tabellen die Beschreibung entweder in Form von Parameterfolgen oder in Form von Bezugnahmen auf Verfahren enthalten können, die die erforderlichen Werte generieren, wobei die Eintragungen dieser assoziativen Tabellen Namen sind, die die Gruppe der für eine und dieselbe Komponente möglichen Modelle bezeichnen und eine Zeichenkette bilden, die spezielle, vorbestimmte Kennungen enthält, die durch Werte substituiert sind, die durch das Konfiguratorsystem berechnet sind.

28. System gemäß Anspruch 27, **dadurch gekennzeichnet, dass** wenigstens drei Auswahlvorrichtungen die zu berücksichtigende Instanz anzeigen, wobei Letztere als Parameter auf einen Hersteller eines Objekts HLL übertragen ist:
- eine erste Auswahlvorrichtung zeigt die Instanz oder das laufende "Item" an,
- eine zweite Auswahlvorrichtung präzisiert die mit dem anderen Ende des Ports verbundene Instanz,
- eine dritte Auswahlvorrichtung zeigt die zusammengesetzte Instanz an, die der aktiven Komponente entspricht, die den Beobachtungsport enthält.

29. System gemäß einem der Ansprüche 22 bis 28, **dadurch gekennzeichnet, dass** das Konfiguratorsystem eine oder mehrere Tabellen der Kohärenzregeln der Verbindungen (TRCOH) verwendet, die die Interkonnektionsregeln zwischen den Komponenten und Einfügungsregeln der intermediären Komponenten, eine oder mehrere Tabellen der Komponenten und Verbindungsregeln (TCRC) darstellen, die die Verbindungsregeln auf Systemniveau und die Generierungsregeln von Verbindungen zwischen den Signalen und eine oder mehrere Formatierungstabellen von Quelldateien (TFMT) darstellen, die die Generierungsregeln der Instanzen der Objekte vom Typ HLL darstellen.

30. System gemäß einem der Ansprüche 22 bis 29, **dadurch gekennzeichnet, dass** das Konfiguratorsystem verwendet:
- eine Basisklasse in HLL, die die eindeutige Identifizierung jedes instanzierten Objekts und die Abfrage der Konfiguration zulässt,
- Mittel zum Generieren und automatischen Instanzieren der Systemblöcke,
- Mittel der Tabellen, die die miteinander verbundenen Signale dem einzigartigen Namen des sie verbindenden Drahtes zuordnet,
- Verwendungsmittel einer Formatierungstabelle zum Generieren der Quelldateien in HDL und HLL.

31. System gemäß einem der Ansprüche 22 bis 30, **dadurch gekennzeichnet, dass** der Operator in dem weitest möglichen Bereich funktional die Konfiguration in der Sprache höchsten Niveaus spezifiziert und er die funktionale Spezifikation durch die Komponenten in der Sprache niedrigsten Niveaus vervollständigt.

32. System gemäß einem der Ansprüche 22 bis 31, **dadurch gekennzeichnet, dass** die folgenden Eintragungen des Zerhackens den Typ der Komponente definieren und jedem Komponententyp ein Zerhacken entspricht, das seinerseits aus den folgenden Eintragungen zusammengesetzt ist:
- einer ersten Eintragung *RegModule* - die den Namen des Moduls HDL der Komponente und den Namen der entsprechenden Quelldatei enthält,
- einer zweiten Eintragung *Connect* - die die Definition der Auswahlmethode der Signale ist, die Teil eines Ports sind, wobei diese Beschreibung sich aus einer Folge von Eintragungen zusammensetzt, die durch den Namen des Ports indexiert sind; jedem Portnamen ordnet der Konfigurator eine Tabelle von regelmäßigen Expressionen und einen Zeiger auf einem Verbindungsverfahren der Signale zu, der die Anwendung dieser Expressionen den Namen der Signale der Schnittstelle der Komponente verwaltet.

33. System gemäß Anspruch 32, **dadurch gekennzeichnet, dass** die generische Struktur der aktiven Komponenten einen Block, der die Beschreibung HDL enthält, und einen Block in HLL, der die Zugangspfade zu den Ressourcen HDL liefert, und ggf. eine Beschreibung des Blocks in HLL umfasst, wobei die Gruppe der Signale des Blocks HDL die Schnittstelle des umfassenden Blocks bildet, die einerseits aus Ports gebildet ist, die willkürliche logische Auswahlen der Signale einer Schnittstelle sind, und andererseits Schnittstellenanpassungen, die die Softwareteile sind, die auf jedem Port die bidirektionale Kommunikation zwischen den Teilen in HLL und denen in HDL gewährleisten, wobei die Schnittstellenanpassungen von dem Konfiguratorsystem ausgewählt werden.

34. System gemäß Anspruch 33, **dadurch gekennzeichnet, dass** die Ports in Form von regelmäßigen Expressionen spezifiziert sind, die gleichzeitig zur Auswahl der Teilgruppen von zu verbindenden Signalen und zur Definition der Verbindungsregeln dienen.

35. System gemäß einem der Ansprüche 22 bis 34, **dadurch gekennzeichnet, dass** das Konfiguratorsystem als Übertragungskomponenten bezeichnete Komponenten generiert, die auf jeder Seite des Bruchs auf den Servern eingefügt sind, wobei diese Komponenten einfach Drähte für die Eingänge und die Register für die Ausgänge sind.

## Claims

1. A method implemented by means of a data processing system (40) associated with a so-called configurator computer program, for automatically generating source files of a global simulation model for simulating an architecture comprising a system under development, said global simulation model comprising, on the one hand, software models of constituent components of the system under development that can constitute, using the Configurator, a machine or part of a machine and, on the other hand, software models of simulation environment components, said source files enabling the system under development to be tested and checked by simulating its operation in an environment identical to, very close to its final use,
the method including establishing a configuration defining file (FCONF) of architecture components in a high level language, these components constituting determined functional blocks for describing functionalities of integrated circuits or parts of integrated circuits, and being chosen by the user-designer in a library of different types of constituent components and a library of environment components to constitute the global simulation model of the architecture specified by an architecture describing file (FDARCH), establishing the source files corresponding to the configuration defining file (FCONF) comprising the following steps of:
- reading the architecture describing file (FDARCH) and storing, in a component and connection rule table (TCRC), in a connection consistency rule table (TRCOH) and in a source file formatting table (TMFT), information relating to all the possible configurations, each component obtaining a name identifying, unequivocally, its position in the architecture, as well as a type among several types,
- instantiating the components specified in the configuration defining file (FCONF) by the user-designer by means of a list of present components designated by their name and type and including parameters or involving procedures, the configuration defining file (FCONF) comprising a file for selecting the components and their type and optional further indications about the interface type and the server concerned by the configuration to be generated by the Configurator, and storing the corresponding information in an instance connecting table (TCINST),
- topologically connecting the instances and storing the corresponding information in an instance connecting table (TCINST),
- physically connecting the interface signals, at each instance of the components, by applying regular expressions, stored in the component and connection rule table (TCRC) relating to the name of the signals constituting a wiring table (TCAB), and
- using the instance connecting table (TCINST), of the wiring table (TCAB) and the formatting table (TFMT) to automatically generate HDL type (MGHDL) and HLL type (MGHLL) source files of the global simulation model, corresponding to the configuration specified by the configuration defining file (FCONF).

2. The method according to claim 1, wherein the Configurator transmits to the HLL type parts of each component information about:
- the component name,
- the instance type,
- the HDL path, namely the hierarchical name of the component in the model description.

3. The method according to claim 1 or 2, wherein the configuration defining file (FCONF) further includes a key word (server<n>) indicating the name or number of the server on which a component is instantiated in the case of a use of the method on a multiserver system.

4. The method according to claim 3, wherein, in the case of a use on a multiserver system, the Configurator executes the following steps of:
- cutting off the Configuration into several parts (of the HDL type and HLL type) by sorting the HDL type components and the HLL objects depending on which servers they belong to,
- generating the peripheral HDL type components used for sending and receiving signals between the parts of the configuration,
- duplicating the Global Blocks by the Configurator system and instantiating the duplicated Global Blocks on each server,
- generating the HLL type parts used for supporting the communication between the servers.

5. The method according to claim 3 or 4, wherein the automatic connection between the components by the data processing system (40) comprises several phases:
- a high level topological phase performing the selection of the components and their respective positioning,
- a wiring phase performing the actual connection between the components, this phase generating as a result a wiring table (TCAB) associating the signals connected together, with a single name of the wire connecting them,
- a phase of generating the HDL type and HLL type source files.

6. The method according to claim 5, wherein the wiring phase is carried out by the data processing system (40) according to the following three steps:
a. the Global Blocks and the System Blocks are connected firstly to all the components,
b. then the connections of the signals between the other components follow,
c. at the end of the wiring, a further run enables the signals remaining not connected of each component to be connected to predetermined signals to ensure a stable determined state, the Configurator system thereby generating partial configurations comprising a sub-set of the architecture.

7. The method according to claim 6, wherein the predetermined signals are the signals of the System Block corresponding to the component.

8. The method according to one of claims 1 to 7, wherein the architecture describing file (FDARCH) of the global model comprises the models for simulating the global Blocks and System Blocks, both these types of components being connected together and managing environment signals.

9. The method according to claim 8, wherein the System Blocks are connected to the other components and provide them system signals specific thereto.

10. The method according to claim 9, wherein the data processing system (40) carries out a connection compliance monitoring by comparing the instance connecting table (TCINST) for actual instances between blocks with the connection consistency rule table (TRCOH).

11. The method according to claim 10, wherein the data processing system (40) compares the physical connections between the components to the connection consistency rule table (TRCOH), for detecting incompatibilities between connection ends between the components, and, in such a case, it specifies, and adds, in the instance connecting table (TCINST), an adaptor component (Intermediate Block) (101) inserted in the connection considered.

12. The method according to claim 11, wherein the configuration defining file (FCONF) comprises information, specified by an attribute, concerning the use of adaptor components or intermediate Blocks with the instances of the active Components, the connections of which are compared with the instance connecting table (TCINST), for detecting incompatibilities between connection ends between the components, and, in such a case, it specifies, and adds, in the instance connecting table (TCINST), another adaptor component or intermediate Block (102) inserted in the connection considered.

13. The method according to claim 12, wherein the data processing system (40) selects some of the connections between components of the connection consistency rule table (TRCOH) and specifies, and adds, in the instance connecting table (TCINST), further connections constituting shunts leading to respective further models, representing monitoring tools or connection probes.

14. The method according to one of claims 1 to 13, wherein, in the phase of generating source files, the Configurator system generates the source files in the HDL language (MGHDL) and in the HLL language (MGHLL) by considering the content of the component and connection rule table (TCRC), the connection consistency rule table (TRCOH), the source file formatting table (TMFT), the instance connecting table (TCINST) and the wiring table (TCAB).

15. The method according to claim 14, wherein the data processing system (40) carries out a processing by the Configurator system, for each configuration alternative, to obtain several simulation models corresponding to the same functional specification, but written in a description including different mixtures of the different-level languages (HDL, HLL).

16. The method according to one of claims 1 to 15, wherein the data processing system (40) establishes the functional specification of the global simulation model in a computing format compatible with a high level programming language (HLL) and in a format compatible with a hardware describing language (HDL).

17. The method according to one of claims 15 and 16, wherein the configuration defining file (FCONF) comprises, for each component, at least one part in the HDL type language, said part in the HDL type language providing an interface to other models.

18. The method according to claim 17, wherein the models comprising a part in the HLL type language comprise interface adaptors.

19. The method according to claim 18, wherein the Configurator system chooses each interface adaptor model depending on the connection consistency rule table (TRCOH).

20. The method according to claim 19, wherein the connections of the physical signals are specified by "Ports", each port being an arbitrary selection of the signals of the HDL type interface of a component using regular expressions relating to the names of these signals, and being constituted by regular expression/substitution expression pairs, these expressions being successively applied to the name of each signal of the HDL type interface, and, if the final substitution is identical for two signals, the latter are connected to each other, the connection being stored in the wiring table (TCAB).

21. The method according to claim 20, wherein each interface adaptor being shared between several models connected to the same port, only one of these models emits signals on said port.

22. A data processing system (40) comprising a so-called Configurator computer program for automatically generating source files of a global simulation model for simulating a system under development having a configuration of determined functional blocks mutually connected by interoperable connections, said global simulation model comprising, on the one hand, software models of constituent components of the system under development that can constitute, using the Configurator, a machine or part of a machine and, on the other hand, software models of simulation environment components, said source files enabling the system under development to be tested and checked by simulating its operation in an environment identical to, very close to its final use,
wherein the Configurator (PROGCONF) comprises means for performing a simulation of the wiring by applying stored regular expressions, by using a configuration defining file (FCONF) in a high level language, a component and connection rule table (TCRC) describing the properties (type, HDL type interfaces, ports, HLL class object builders, etc.) of the software components for simulating the circuit, a connection consistency rule table (TRCOH) in a high level language (HLL), means for instantiating the resulting elements of the configuration defining file (FCONF), a HLL code generator which combines the parameters of the components with the connection rules, said data processing system implementing the steps of the method according to claim 1.

23. The system according to claim 22, **characterised in that** there is at least five types of components: the active Components, the Monitoring and Checking Blocks, the intermediate Blocks, the System Blocks and the Global Blocks.

24. The system according to claim 23, **characterised in that** the system is arranged to carry out a connection compliance monitoring by comparing the instance connecting table (TCINST) with a connection consistency rule table (TRCOH) for the physical connections between the chosen models of the blocks constituting the global model.

25. The system according to claim 24, **characterised in that** it is arranged to compare the instance connecting table (TCINST) for actual instances between blocks with the connection consistency table (TRCOH), for detecting incompatibilities between connection ends between blocks, and, in such a case, to specify, and add, in the connection consistency rule table (TRCOH), an adaptor functional block or Intermediate Block (101) inserted in the connection considered.

26. The system according to one of claims 22 to 25, **characterised in that** the component and connection rule table (TCRC), comprising the properties of the components, contains global parameters common to all the types of components and is in the form of a table distributed according to one or more tables, being associative or not, the inputs of which are names designating all the possible models for a same component.

27. The system according to claim 26, **characterised in that** the associative tables can contain the description, either as a series of parameters, or as references to procedures which generate the required values, the inputs of these associative tables being names designating all the possible models for a same component and forming a character string containing predetermined special identifiers, substituted by the values calculated by the Configurator system.

28. The system according to claim 27, **characterised in that** at least three selectors indicate the instance to be taken into account, the latter being transmitted as a parameter to a HLL object builder:
- a first selector indicates the current instance or "item",
- a second selector sets out the instance connected to the other end of the port,
- a third selector indicates the constituted instance corresponding to the active Component containing the observation port.

29. The system according to one of claims 22 to 28, **characterised in that** the Configurator system uses one or more connection consistency rule tables (TRCOH), which represent the interconnection rules between the components and insertion rules for the intermediate components, one or more component and connection rule tables (TCRC), which represent the system level connection rules and the connection generating rules between the signals, and one or more source file formatting tables (TFMT), which represent the HLL type object instance generating rules.

30. The system according to one of claims 22 to 29, **characterised in that** the Configurator system uses:
- a HLL base class enabling each instantiated object to be univocally identified and the configuration to be queried,
- means for generating and automatically instantiating the System Blocks,
- table means associating the signals connected together to the single name of the wire connecting them,
- means for using a formatting table for generating the HDL and HLL source files.

31. The system according to one of claims 22 to 30, **characterised in that** the operator functionally specifies, to the greatest extent possible, the configuration in the highest level language and it completes the functional specification by the components in the lowest level language.

32. The system according to one of claims 22 to 31, **characterised in that** the following hashing inputs define the component Type and, for each Component Type, there is a hashing in turn comprised of the following inputs:
- a first input *RegModule* - contains the name of the HDL module of the component and the name of the corresponding source file,
- a second input *Connect* - is the definition of the method for selecting the signals being part of a Port, this description being comprised of a series of inputs indexed by the Port name; with each Port name, the configurator associates a table of regular expressions and a pointer on a signal connection procedure which manages the application of these expressions to the names of the interface signals of the component.

33. The system according to claim 32, **characterised in that** the generic structure of the active Components comprises a Block containing the HDL description and a HLL Block, providing the paths for accessing the HDL resources and, when appropriate, a description of the HLL block, all the signals of the HDL block constituting the encompassing-Block interface, formed, on the one hand, by Ports, which are arbitrary logic selections of the signals of an interface and, on the other hand, interface adaptors which are the software parts ensuring, on each Port, the bidirectional communication between the HLL parts and the HDL ones, the interface adaptors being chosen by the Configurator system.

34. The system according to claim 33, **characterised in that** the Ports are specified as regular expressions, which are used both for selecting the subsets of signals to be connected and defining the connection rules.

35. The system according to one of claims 22 to 34, **characterised in that** the Configurator system generates so-called Transfer Components which are inserted on either side of the cut-off on the servers, these components being merely wires for the inputs and registers for the outputs.
